(19) **Europäisches Patentamt / European Patent Office / Office européen des brevets**

(11) **EP 2 464 018 A1**

(12) # EUROPEAN PATENT APPLICATION
published in accordance with Art. 153(4) EPC

(43) Date of publication:
**13.06.2012 Bulletin 2012/24**

(21) Application number: **10806251.4**

(22) Date of filing: **06.08.2010**

(51) Int Cl.:
*H03M 7/30* (2006.01)      *H04N 7/30* (2006.01)
*H04N 7/32* (2006.01)

(86) International application number:
**PCT/JP2010/004966**

(87) International publication number:
**WO 2011/016251 (10.02.2011 Gazette 2011/06)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **06.08.2009   JP 2009183791
21.08.2009   JP 2009192627**

(71) Applicant: **Panasonic Corporation
Kadoma-shi
Osaka 571-8501 (JP)**

(72) Inventors:
• **SHIBAHARA, Youji
Chuo-ku
Osaka 540-6207 (JP)**

• **NISHI, Takahiro
Chuo-ku
Osaka 540-6207 (JP)**
• **SASAI, Hisao
Chuo-ku
Osaka 540-6207 (JP)**
• **TANIKAWA, Kyoko
Chuo-ku
Osaka 540-6207 (JP)**

(74) Representative: **Grünecker, Kinkeldey,
Stockmair & Schwanhäusser
Leopoldstrasse 4
80802 München (DE)**

(54) **ENCODING METHOD, DECODING METHOD, ENCODING DEVICE AND DECODING DEVICE**

(57)   A coding method according to an implementation of the present invention includes: transforming an input signal to generate a transformed output signal (S110); quantizing the transformed output signal to generate a quantized coefficient (S120); and entropy coding the quantized coefficient to generate a coded signal (S130), and the transforming (S110) includes: generating a first transformed output signal by performing a first transform on the input signal using a first transform coefficient (S112); and generating a second transformed output signal by performing, using a second transform coefficient, a second transform on a first partial signal that is a part of the first transformed output signal (S116), and in the entropy coding (S130), the second transform coefficient or a second inverse transform coefficient is compression coded by calculating a difference between a predetermined value and an element included in the second transform coefficient or a second inverse transform coefficient, and compression coding the calculated difference.

FIG. 7

Start → Transform — S110 → Quantization — S120 → Entropy coding — S130 → End

EP 2 464 018 A1

**Description**

[Technical Field]

The present invention relates to coding methods of coding audio, still images, and video, and in particular to a coding method including a process of transforming an input signal from a spatial-temporal domain into a frequency domain.

[Background Art]

In order to compress audio data and video data, the audio coding standards and the video coding standards have been developed. The examples of the video coding standards include the ITU-T standards denoted as H. 26x, and the ISO/IEC standards denoted as MPEG-x. The latest video coding standard is the standard denoted as H.264/MPEG-4AVC.

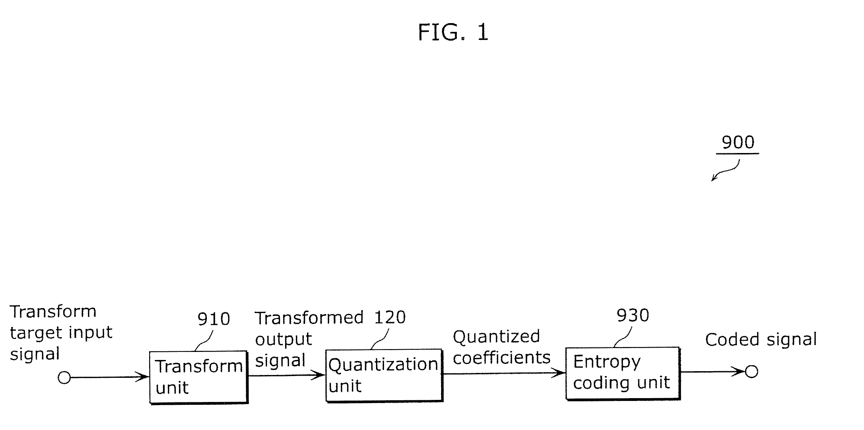

FIG. 1 is a block diagram showing a structure of a conventional coding apparatus 900. As shown in FIG. 1, the coding apparatus 900 includes a transform unit 910, a quantization unit 120, and an entropy coding unit 930, and codes audio data and video data at a low bit rate.

The transform unit 910 generates a transformed output signal with reduced correlation, by transforming, from the spatial-temporal I domain into the frequency domain, an input signal that is various data, or a transform target input signal that is obtained by performing some processing on the input signal. The transformed output signal generated as above is output to the quantization unit 120.

The quantization unit 120 quantizes the transformed output signal provided from the transform unit 910 and thereby generates quantized coefficients having a small total amount of data. The quantized coefficients generated as above are output to the entropy coding unit 930.

The entropy coding unit 930 codes the quantized coefficients provided from the quantization unit 120, using an entropy coding algorithm, and thereby generates a coded signal having a reduced amount of data. The coded signal generated as above is, for example, recorded on a recording medium or transmitted to a decoding apparatus through a network.

Transform processing which the transform unit 910 performs is described in detail below.

To the transform unit 910, an n-point vector (n-dimensional signal) that is a transform target signal (i.e., the transform target input signal) is input as a transform input vector $x^n$. The transform unit 910 performs predetermined transform processing (a transform T) on the transform input vector $x^n$ and outputs a transform output vector $y^n$ as the transformed output signal (cf. Expression 1).

[Math. 1]

$$y^n = T[x^n]$$

(Expression 1)

When the transform T is linear transform, the transform T can be expressed, as indicated by Expression 2, as a matrix product of the transform input vector $x^n$ and a transform matrix A that is an nxn square matrix. It is to be noted that Expression 3 is an expression for calculating, for each element $y_i$, the transform output vector $y^n$, using a transform coefficient $a_{ik}$ that is an element of the transform matrix A, and is derived from Expressions 1 and 2.

[Math. 2]

$$T[x^n] = Ax^n$$

(Expression 2)

[Math. 3]

$$y_i = \sum_{k=1}^{n} a_{ik} x_k$$

(Expression 3)

The transform matrix A is designed to reduce the correlation of an input signal and concentrate energy into an element having n which is small (on what is called a low-frequency side) among the elements of the transform output vector $y^n$. For designing the transform matrix A, a transform coefficient deriving method or a transforming method called Karhunen Loeve Transform (KLT) is known.

The KLT is a method of deriving an optimum transform coefficient or a transforming method using a derived optimum transform coefficient, based on the statistical properties of an input signal. The KLT is known as a technique for enabling complete elimination of correlation of an input signal and enabling most efficient energy concentration into a low-frequency band.

In other words, the KLT is ideal transform processing, and a signal transformed by the KLT and to be coded can be coded with good coding efficiency. [Summary of Invention]

[Technical Problem]

However, the KLT in the above conventional technique has a problem that an amount of computation is large and an amount of data of a transform matrix that is coefficients for use in transform is large. Details are as follows.

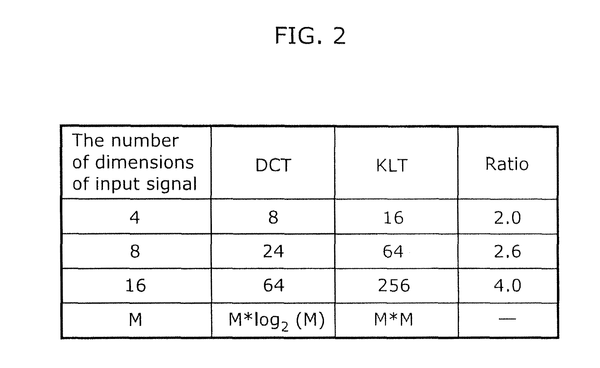

As shown in FIG. 2, in the case of the discrete cosine transform (DCT) using a high-speed algorithm, such as a butterfly operation, the number of multiplications is $MxLog_2(M)$ where M is the number of dimensions (hereinafter referred to also as the number of inputs) of an input signal. In contrast, in the case of the KLT, the number of multiplications is MxM. For example, in the DCT, the number of multiplications is 8 when the number of inputs is 4, and the number of multiplications is 24 when the number of inputs is 8. In contrast, in the KLT, the number of multiplications is 16 (two times as many as that in the DCT) when the number of inputs is 4, the number of multiplications is 64 (2.6 times as many as that in the DCT) when the number of inputs is 8, and the number of multiplications is 4.0 times as large as that in the DCT when the number of inputs is 16, for example. Since the amount of computation in the KLT is more likely to increase as the size of transform increases, the KLT has a problem of an enormous amount of computation as compared to the DCT.

In the KLT, the transform matrix A is derived based on the statistical properties of a set $S_A$ including the input signal vector $x^n$. For the input signal vector $x^n$ included in the set $S_A$, the transform using the transform matrix A enables the optimum elimination of correlation and the energy compression into the low-frequency band. However, when an input signal vector included in a set $S_B$ having different statistical properties from the designed set $S_A$ is input, a result of transform using the transform matrix A will not be optimum. Conversely, if a transform coefficient is generated at every slight change of the statistical properties of input to keep obtaining the optimum result, the amount of data of transform coefficients will be enormous.

As above, because the KLT has the problem that the amount of computation is large and the amount of data of transform coefficients is large, it used to be hard to utilize the KLT in the conventional coding.

Thus, the present invention has bee devised to solve the above problem and has an object to provide a coding method and a coding apparatus by which an increase in the amount of computation and an increase in the amount of data of transform coefficients are suppressed so that higher coding efficiency can be attained. Furthermore, the present invention has an object to provide a decoding method and decoding apparatus by which a signal coded by the coding method and the coding apparatus according to an implementation of the present invention can be correctly decoded.

[Solution to Problem]

In order to achieve the above object, a coding method according to an aspect of the present invention includes: transforming an input signal to generate a transformed output signal; quantizing the transformed output signal to generate a quantized coefficient; and entropy coding the quantized coefficient to generate a coded signal, wherein the transforming includes: generating a first transformed output signal by performing a first transform on the input signal using a first transform coefficient; and (i) generating a second transformed output signal by performing a second transform on a first partial signal using a second transform coefficient, and (ii) outputting the transformed output signal including the generated second transformed output signal and a second partial signal, the first partial signal being a part of the first transformed output signal, and the second partial signal being a part of the first transformed output signal other than the first partial signal, and in the entropy coding, the second transform coefficient or a second inverse transform coefficient is compression coded by (i) calculating a difference between a predetermined value and an element included in the second transform coefficient or the second inverse transform coefficient and (ii) compression coding the calculated difference, the second inverse transform coefficient being used in an inverse transform of the second transform.

With this, the transform coefficients are determined based on the statistical properties of an input signal, so that even when the determined transform coefficients need to be coded and transmitted to a decoding apparatus, coding of a difference from the predetermined value allows a reduction in the amount of information to be coded. It is therefore possible to increase the coding efficiency. Specifically, in the two-stage transform processing, the transform coefficients to be used in the transform processing at the second stage are determined based on the statistical properties, with the result that an increase in the amount of data of transform coefficients can be suppressed and the coding efficiency can be increased. For example, the transform processing performed at two stages with different accuracy levels requires a smaller amount of computation than in the transform processing performed at one stage with high accuracy and achieves a transform with higher accuracy than in the transform processing performed at one stage with a small amount of computation.

Furthermore, it may be possible that the second transform coefficient or the second inverse transform coefficient is a coefficient in a square matrix, and in the entropy coding, a difference between a diagonal element and a largest possible value of the diagonal element is calculated, the diagonal element being included in the second transform coefficient or the second inverse transform coefficient.

With this, the coding efficiency can be further increased using the characteristics that the diagonal elements of the transform coefficients or inverse transform coefficients determined based on the statistical properties have values close to the largest possible values of the transform coefficients or inverse transform coefficients.

Furthermore, it may be possible that the second transform coefficient or the second inverse transform coefficient is a coefficient in a square matrix, and in the entropy coding, a difference between adjacent diagonal elements is calculated, the adjacent diagonal elements being included in the second transform coefficient or the second inverse transform coefficient.

With this, the coding efficiency can be further increased using the characteristics that among the diagonal elements of the transform coefficients or inverse transform coefficients determined based on the statistical properties, the lower right diagonal elements have smaller values.

Furthermore, it may be possible that the second transform coefficient or the second inverse transform coefficient is a coefficient in a square matrix, and in the entropy coding, a prediction value is calculated based on a position of a diagonal element in the square matrix, and a difference between the calculated prediction value and the diagonal element is calculated, the diagonal element being included in the second transform coefficient or the second inverse transform coefficient.

With this, the calculating of a prediction value allows a further decrease in the difference from the predetermined value (the prediction value), with the result that the coding efficiency can be further increased.

Furthermore, it may be possible that the second transform coefficient or the second inverse transform coefficient is a coefficient in a square matrix, and the coding method further comprises determining the second transform coefficient or the second inverse transform coefficient based on a statistical property of the input signal, and in the determining, the second transform coefficient or the second inverse transform coefficient is determined so that a diagonal element included in the second transform coefficient or the second inverse transform coefficient has a plus sign.

With this, there is no need to code a sign of the diagonal element, which allows a further increase in the coding efficiency.

Furthermore, it may be possible that the second transform coefficient or the second inverse transform coefficient is a coefficient in a square matrix, and in the entropy coding, a component obtained by removing redundancy between a non-diagonal element and a symmetrical element is compression coded, the non-diagonal element being included in the second transform coefficient or the second inverse transform coefficient, and the symmetrical element being an element at a position symmetrical to the non-diagonal element about a diagonal element.

With this, the removing of redundancy between a non-diagonal element and a symmetrical element thereof allows a further increase in the coding efficiency.

Furthermore, it may be possible that, in the entropy coding, an average value of an absolute value of the non-diagonal element and an absolute value of the symmetrical element is calculated, and a difference between the calculated average value and the absolute value of the non-diagonal element is compression coded.

With this, the coding efficiency can be increased using the characteristics that a non-diagonal element and a symmetrical element thereof have absolute values close to each other.

Furthermore, in the entropy coding, information indicating whether the non-diagonal element and the symmetrical element have the same or different signs may be further compression coded.

With this, sending of the information on whether the signs are the same or defferent allows a further increase in the coding efficiency because a non-diagonal element and a symmetrical element thereof often have reverse signs.

Furthermore, in the entropy coding, information indicating that the non-diagonal element and the symmetrical element at any position have reverse signs may be further compression coded.

With this, for example, when all the non-diagonal elements and symmetrical elements thereof have reverse signs, it is enough to only send the information indicating that all the non-diagonal elements and symmetrical elements thereof have reverse signs, with the result that the coding efficiency can be further increased.

Furthermore, in the entropy coding, information indicating positivity and negativity of one of a top-triangle element and a bottom-triangle element may be further compression coded, each of the top-triangle element and the bottom-triangle element being the non-diagonal element.

With this, instead of coding all the plus and minus signs of the non-diagonal elements, coding only the information indicating positivity and negativity of the top-triangle elements or the bottom-triangle elements is enough, with the result that the coding efficiency can be further increased.

Furthermore, in the entropy coding, information indicating that a top-triangle element at any position has a plus sign may be further compression coded, the top-triangle element being the non-diagonal element.

With this, since the top-triangle elements often have plus signs, when all the top-triangle elements have plus signs, for example, it is enough to code only the information indicating that all the signs of the top-triangle elements are plus, with the result that the coding efficiency can be increased.

Furthermore, it may be possible that, in the quantizing, the second transform coefficient or the second inverse transform coefficient is quantized using a quantization step weighted according to a position of an element included in the second transform coefficient or the second inverse transform coefficient, and in the entropy coding, the quantized second transform coefficient or the quantized second inverse transform coefficient is compression coded.

With this, the quantizing of the coding coefficients allows a further reduction in the amount of information, with the result that the coding efficiency can be increased.

Furthermore, it may be possible that the coding method further comprises: predicting the input signal to generate a prediction signal; and generating a prediction error signal that is a difference between the prediction signal and the input signal, wherein, in the transforming, the prediction error signal is transformed.

With this, the prediction coding allows an increase in the coding efficiency.

Furthermore, the second transform is the Karhunen Loeve transform (KLT).

Furthermore, a decoding method according to an aspect of the present invention is a decoding method of decoding a coded signal to generate a decoded signal, the coded signal being generated by transforming and quantizing an input signal and including: a coded quantized coefficient resulting from compression coding; and a difference between a predetermined value and an element included in a transform coefficient or a second inverse transform coefficient, the transform coefficient being used in transform processing performed in generating the coded signal, and the second inverse transform coefficient being used in a second inverse transform, the decoding method comprising: entropy decoding the coded signal to generate a decoded quantized coefficient; inverse quantizing the decoded quantized coefficient to generate a decoded transformed output signal; and inverse transforming the decoded transformed output signal to generate the decoded signal, wherein the inverse transforming includes: generating a first decoded partial signal by performing the second inverse transform on a second decoded transformed output signal using the second inverse transform coefficient, the second decoded transformed output signal being a part of the decoded transformed output signal; and generating the decoded signal by performing, using a first inverse transform coefficient, a first inverse transform on a first decoded transformed output signal including the first decoded partial signal and a second decoded partial signal that is a part of the decoded transformed output signal other than the second decoded transformed output signal, and in the entropy decoding, the coded signal is decoded to obtain the difference, and the obtained difference and the predetermined value are added, to generate the second inverse transform coefficient.

With this, a coded signal generated using the above coding method can be decoded.

Furthermore, it may be possible that the transform coefficient or the second inverse transform coefficient is a coefficient in a square matrix, the coded signal includes a difference between a diagonal element and a largest possible value of the diagonal element, the diagonal element being included in the transform coefficient or the second inverse transform coefficient, and in the entropy decoding, the coded signal is decoded to obtain the difference, and the obtained difference and the largest possible value are added to generate the diagonal element, to generate the second inverse transform coefficient.

Furthermore, it may be possible that the transform coefficient or the second inverse transform coefficient is a coefficient in a square matrix, the coded signal includes a difference between a first diagonal element and a second diagonal element adjacent to the first diagonal element, the first and second diagonal elements being included in the transform coefficient or the second inverse transform coefficient, and in the entropy decoding, the coded signal is decoded to obtain the difference, and the obtained difference and the second diagonal element are added to generate the first diagonal element, to generate the second inverse transform coefficient.

Furthermore, it may be possible that the transform coefficient or the second inverse transform coefficient is a coefficient in a square matrix, the coded signal includes a difference between a diagonal element included in the transform coefficient or the second inverse transform coefficient and a prediction value calculated based on a position of the diagonal element in the square matrix, and in the entropy decoding, the coded signal is decoded to obtain the difference and generate the prediction value, and the generated prediction value and the obtained difference are added to generate the diagonal element, to generate the second inverse transform coefficient.

Furthermore, it may be possible that the transform coefficient or the second inverse transform coefficient is a coefficient in a square matrix, and in the entropy decoding, a component obtained by removing redundancy between a non-diagonal element and a symmetrical element is decoded to generate the non-diagonal element, to generate the second inverse transform coefficient, the non-diagonal element being included in the transform coefficient or the second inverse transform coefficient, and the symmetrical element being an element at a position symmetrical to the non-diagonal element about a diagonal element.

Furthermore, it may be possible that the coded signal includes an average value of an absolute value of the non-diagonal element and an absolute value of the symmetrical element, and a difference between the average value and the absolute value of the non-diagonal element, and in the entropy decoding, the coded signal is decoded to obtain the average value and the difference, and the obtained average value and the obtained difference are added, to generate the non-diagonal element.

Furthermore, it may be possible that the coded signal includes sign reverse information indicating whether the non-diagonal element and the symmetrical element have the same or different signs, and in the entropy decoding, the coded signal is decoded to obtain the sign reverse information, and according to the obtained sign reverse information, signs of the non-diagonal element and the symmetrical element are determined.

Furthermore, it may be possible that the coded signal includes all-sign reverse information indicating that the non-diagonal element and the symmetrical element at any position have reverse signs, and in the entropy decoding, the coded signal is decoded to obtain the all-sign reverse information, and according to the obtained all-sign reverse information, signs of the non-diagonal element and the symmetrical element are determined.

Furthermore, it may be possible that the coded signal further includes sign information indicating positivity and negativity of one of a top-triangle element and a bottom-triangle element, each of the top-triangle element and the bottom-triangle element being the non-diagonal element, and in the entropy decoding, the sign information is further obtained, and according to the obtained sign information, a sign of the non-diagonal element is determined.

Furthermore, it may be possible that the coded signal further includes top-triangle element sign information indicating that a top-triangle element at any position has a plus sign, the top-triangle element being the non-diagonal element, and in the entropy decoding, the top-triangle element sign information is further obtained, and according to the obtained top-triangle element sign information, it is determined that the top-triangle element has the plus sign.

Furthermore, it may be possible that the coded signal includes: a quantization step weighted according to a position of an element included in the transform coefficient or the second inverse transform coefficient; and a quantized transform coefficient or a quantized second inverse transform coefficient, each of the quantized transform coefficient and the quantized second inverse transform coefficient resulting from quantization using the quantization step, in the entropy decoding, the coded signal is decoded to obtain the quantization step and the quantized transform coefficient or the quantized second inverse transform coefficient, and in the inverse quantizing, the quantized transform coefficient or the quantized second inverse transform coefficient is further inverse quantized using the quantization step.

Furthermore, it may be possible that the coded signal is a signal generated by transforming and quantizing a prediction error signal, the decoding method further comprises generating a prediction signal, and in the inverse transforming, the inverse transform is performed to generate a decoded prediction error signal from the decoded transformed output signal, and the prediction signal and the decoded prediction error signal are added, to generate the decoded signal.

Furthermore, the second inverse transform may be the KLT.

In any one of the above decoding methods, the increase in the amount of computation and the increase in the amount of data of transform coefficients can be suppressed as in the case of the coding method. Furthermore, a signal coded in the above coding method can be decoded correctly.

It is to be noted that the present invention can be implemented not only as the coding method and the decoding method, but also as a coding apparatus and a decoding apparatus that include processing units which perform the respective processing steps included in the coding method and the decoding method. The present invention may also be implemented as a program which causes a computer to execute these steps. Furthermore, the present invention may also be implemented as a recoding medium, such as a computer-readable compact disc-read only memory (CD-ROM), on which the program has been recorded, and information, data, and signals which indicate the program. These program, information, data, and signals may be distributed via a communication network, such as the Internet.

In addition, part or all of the constituents of each of the above coding apparatus and decoding apparatus may be composed of a single system large scale integration (LSI). The system LSI is a super multifunctional LSI manufactured by integrating a plurality of structural units on a single chip and specifically is a computer system which includes a microprocessor, a ROM, a random access memory (RAM) and so on.

[Advantageous Effects of Invention]

With the coding method and the coding apparatus according to an aspect of the present invention, the increase in the amount of computation in the coding process and the increase in the amount of data of transform coefficients can be suppressed. Furthermore, with the decoding method and the decoding apparatus according to an aspect of the present invention, a signal coded in the coding method and the coding apparatus according to an aspect of the present invention can be decoded.

[Brief Description of Drawings]

[Fig. 1]
FIG. 1 is a block diagram showing a structure of a conventional coding apparatus.
[Fig. 2]
FIG. 2 shows comparison in an amount of computation between the DCT and the KLT.
[Fig. 3]

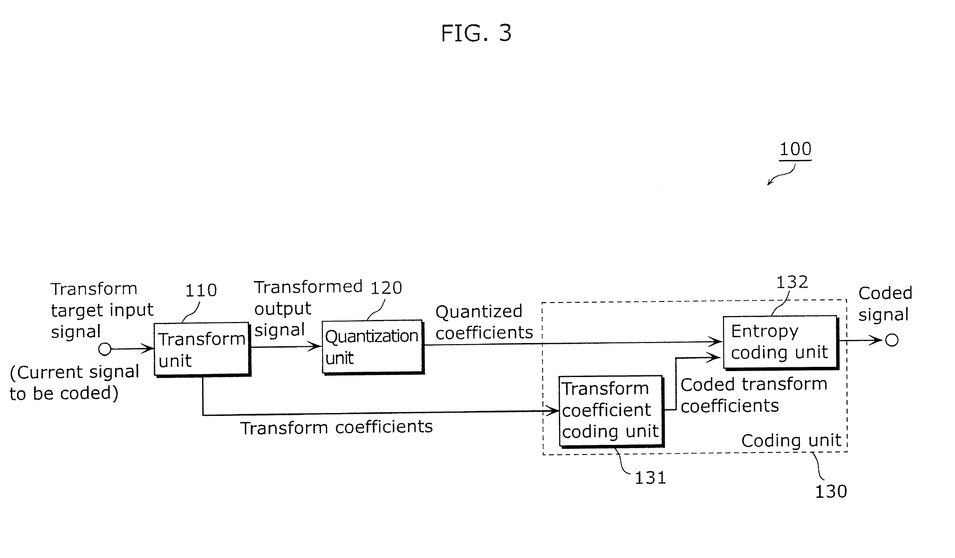

FIG. 3 is a block diagram showing an example of a structure of a coding apparatus according to Embodiment 1.
[Fig. 4]

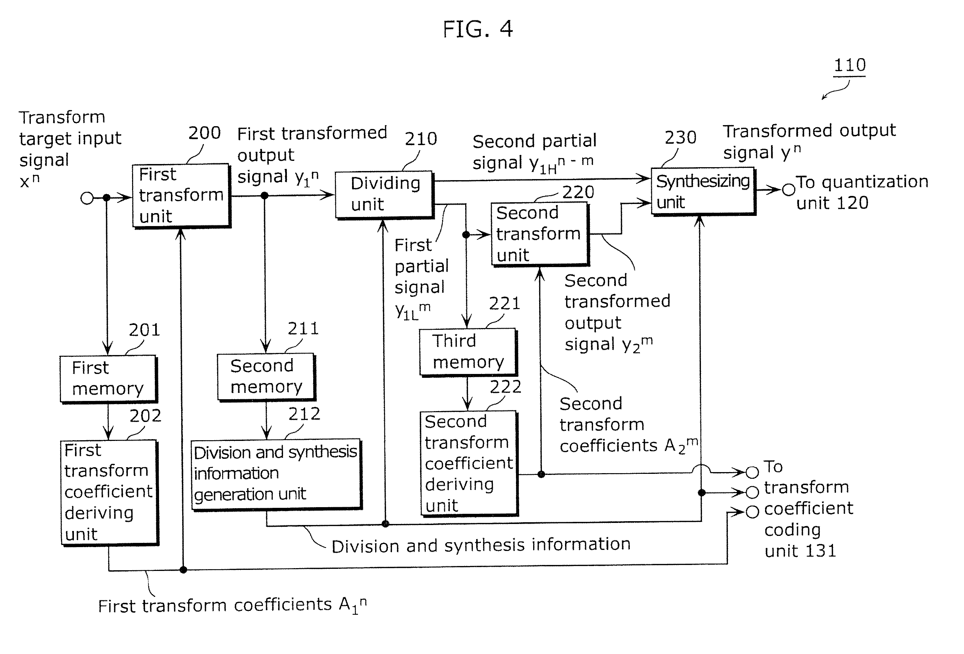

FIG. 4 is a block diagram showing an example of a structure of a transform unit according to Embodiment 1.
[Fig. 5]

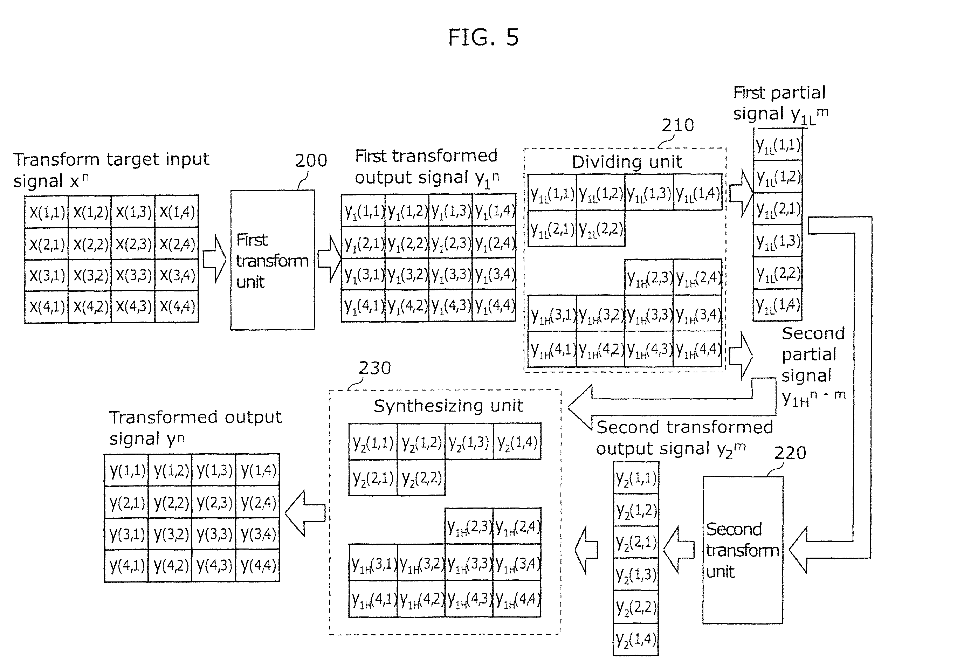

FIG. 5 conceptually shows an example of a data flow in the transform unit according to Embodiment 1.
[Fig. 6]

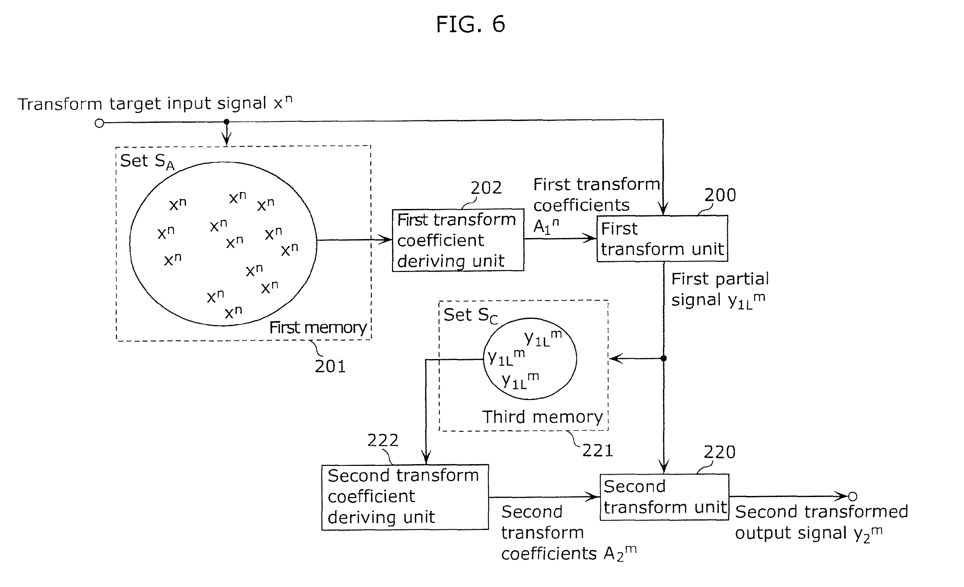

FIG. 6 schematically illustrates an example of derivation, by the KLT, of transform coefficients in the transform unit according to Embodiment 1.
[Fig. 7]

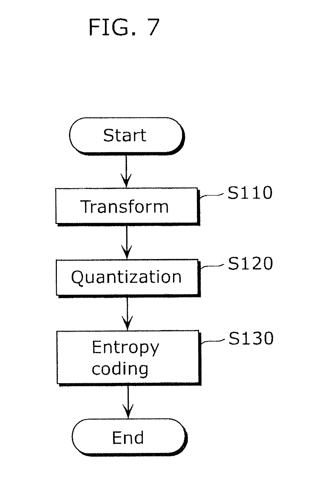

FIG. 7 is a flowchart showing an example of operation of the coding apparatus according to Embodiment 1.
[Fig. 8]

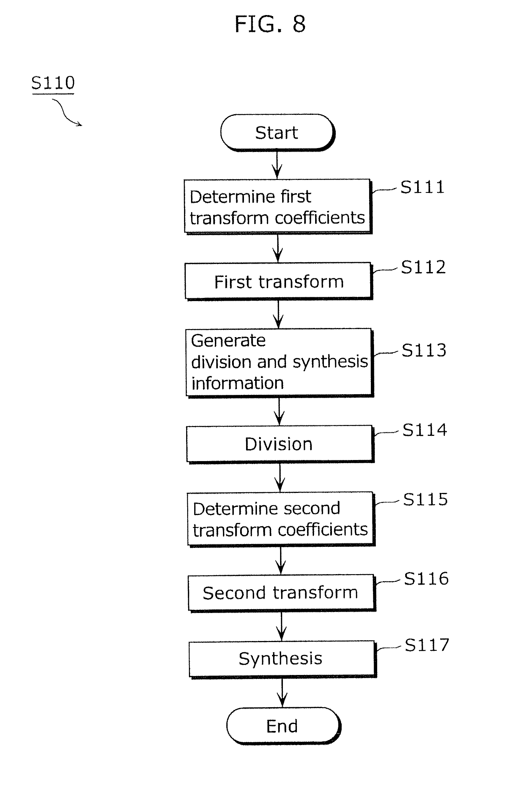

FIG. 8 is a flowchart showing an example of operation of the transform unit according to Embodiment 1.
[Fig. 9]

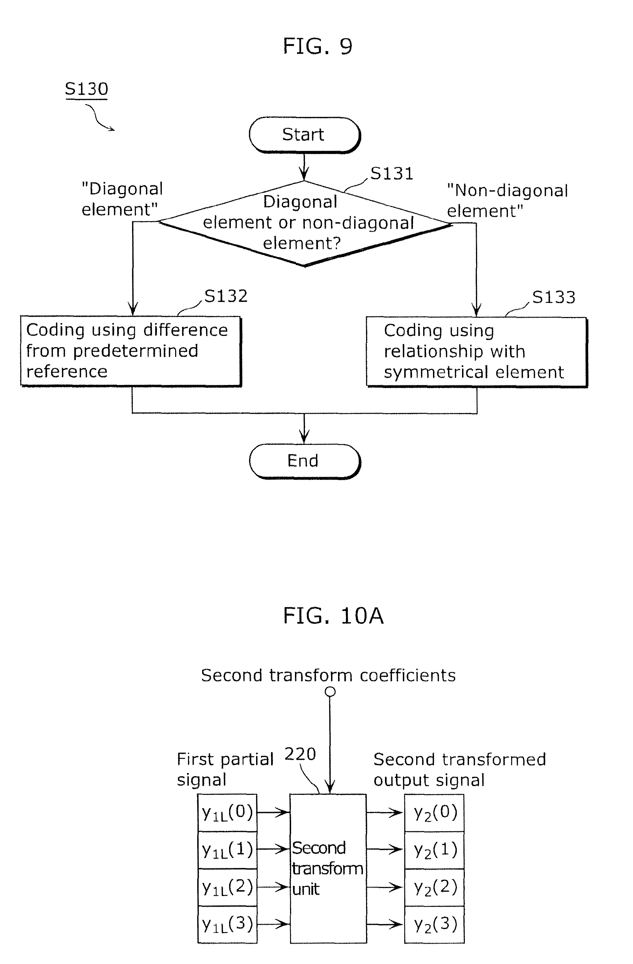

FIG. 9 is a flowchart showing an example of operation of a transform coefficient coding unit according to Embodiment 1.
[Fig. 10A]
FIG. 10A conceptually shows an example of input and output in a second transform unit according to Embodiment 1.
[Fig. 10B]

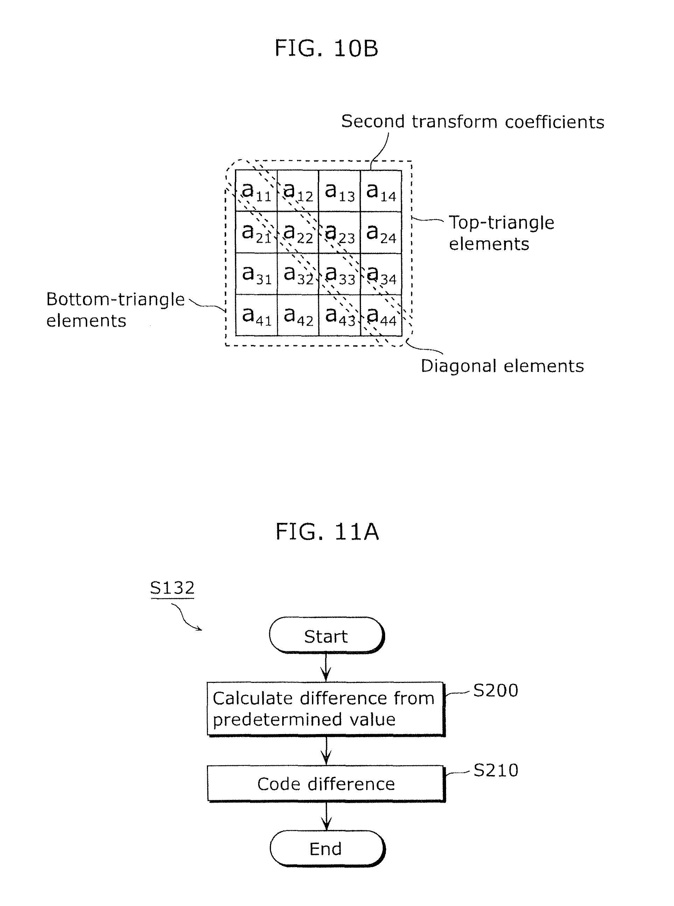

FIG. 10B is a block diagram showing an example of second transform coefficients according to Embodiment 1.
[Fig. 11A]
FIG. 11A is a flowchart showing an example of operation of the transform coefficient coding unit in Embodiment 1 where an element to be coded is a diagonal element.
[Fig. 11B]

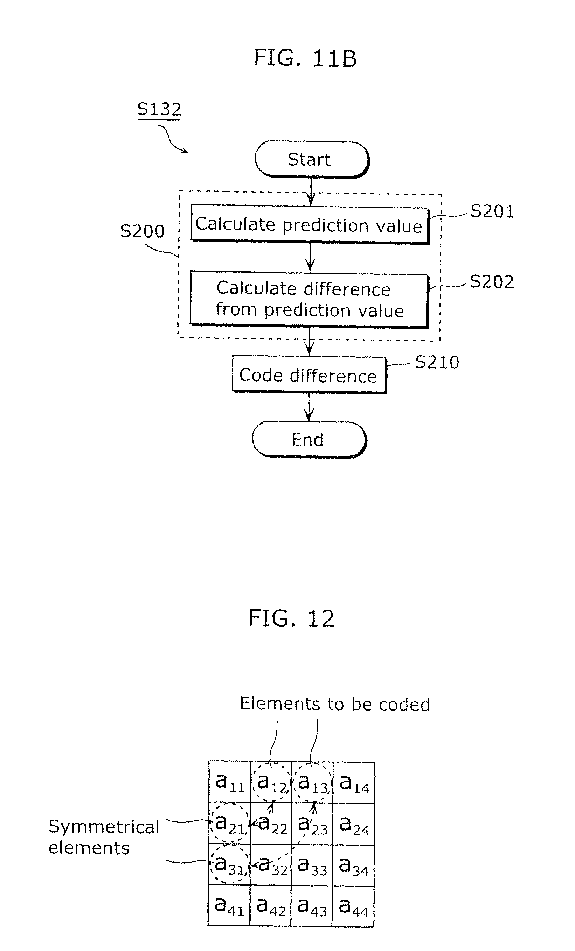

FIG. 11B is a flowchart showing another example of operation of the transform coefficient coding unit in Embodiment 1 where an element to be coded is a non-diagonal element.
[Fig. 12]
FIG. 12 shows an example of the elements to be coded which are non-diagonal elements, and symmetrical elements thereof, in Embodiment 1.
[Fig. 13]

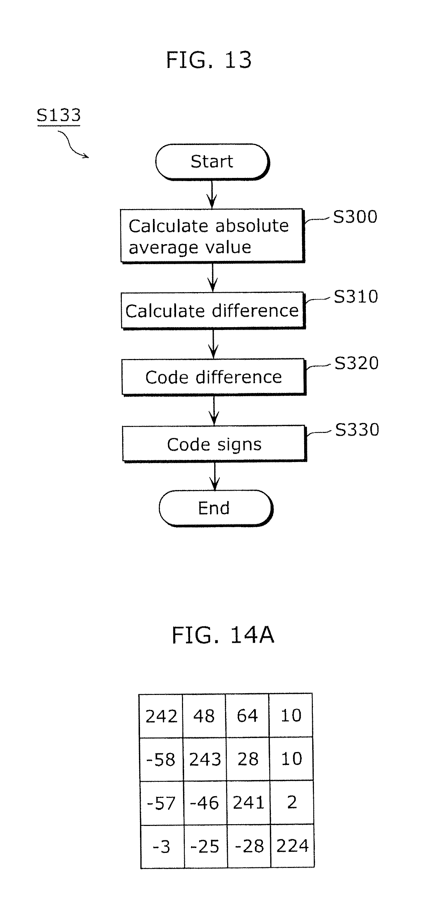

FIG. 13 is a flowchart showing an example of operation of the transform coefficient coding unit in Embodiment 1 where the elements to be coded are non-diagonal elements.
[Fig. 14A]
FIG. 14A shows an example of transform coefficients according to Embodiment 1.
[Fig. 14B]

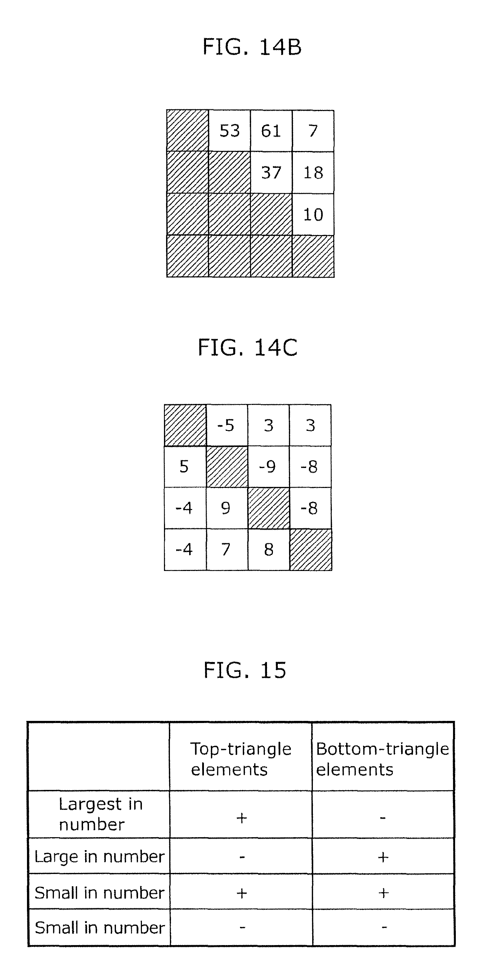

FIG. 14B shows an example of absolute average values in Embodiment 1.
[Fig. 14C]
FIG. 14C shows an example of header descriptions (that is, differences) in Embodiment 1.
[Fig. 15]
FIG. 15 shows the relationship of signs between top-triangle elements and bottom-triangle elements in Embodiment 1.

[Fig. 16]

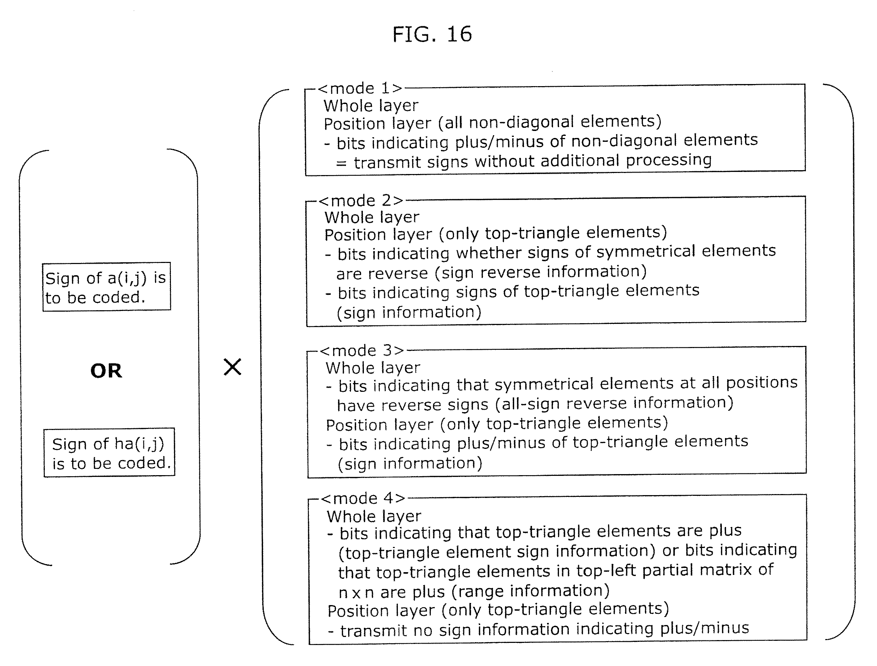

FIG. 16 schematically illustrates an example of syntax in transmitting the signs of non-diagonal elements in Embodiment 1.

[Fig. 17A]

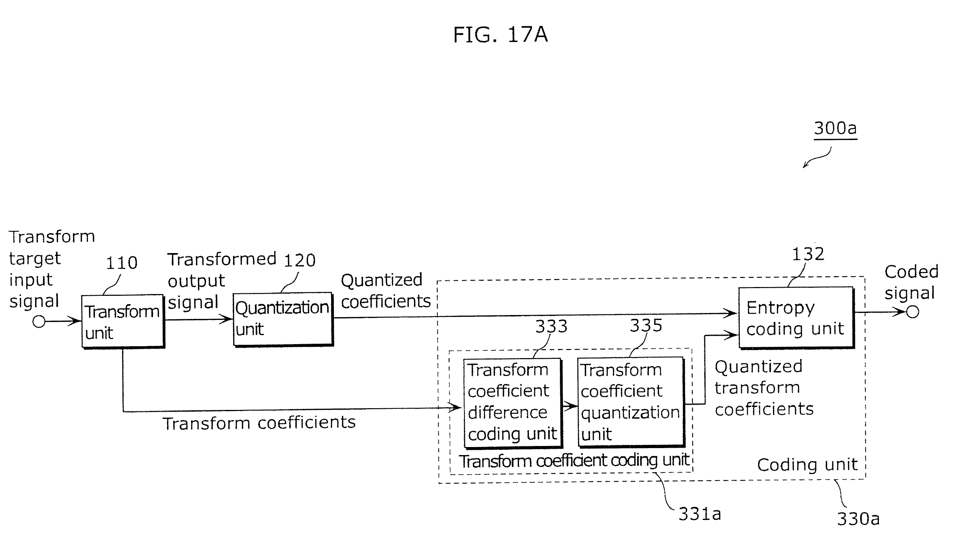

FIG. 17A is a block diagram showing another example of the structure of the coding apparatus according to Embodiment 1.

[Fig. 17B]

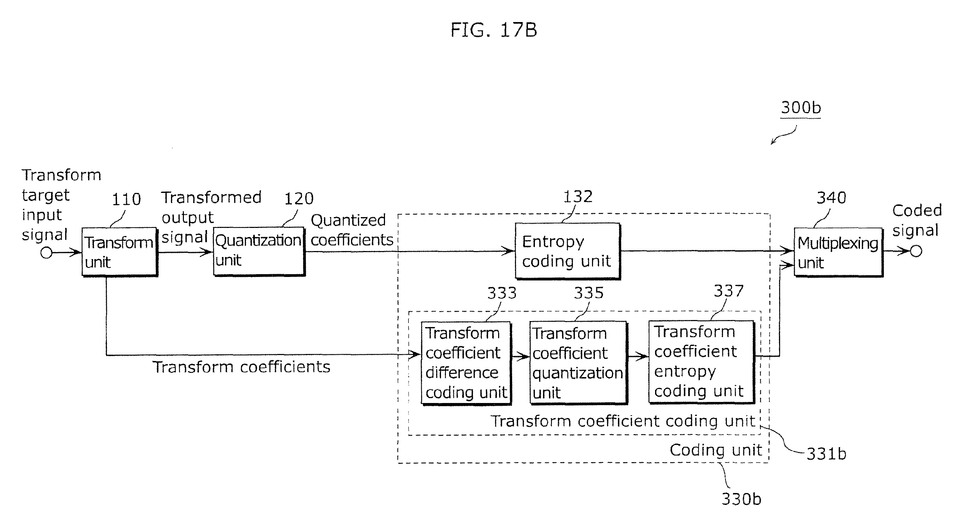

FIG. 17B is a block diagram showing another example of the structure of the coding apparatus according to Embodiment 1.

[Fig. 18A]

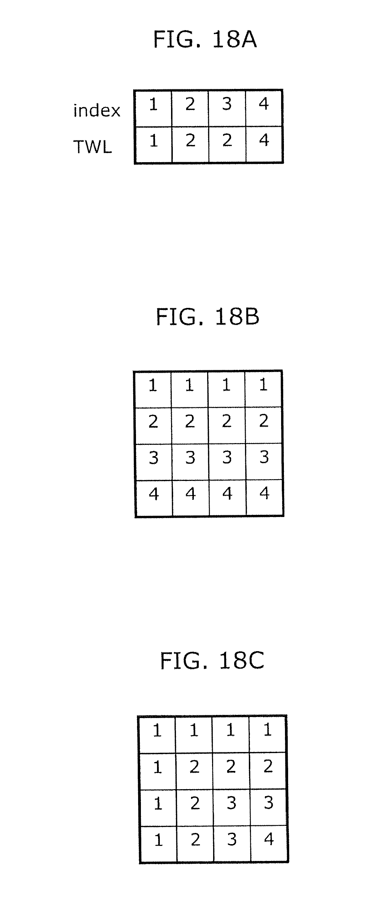

FIG. 18A shows an example of a transform coefficient quantization step table in Variation of Embodiment 1.

[Fig. 18B]

FIG. 18B shows an example of an index table in TWL array in Variation of Embodiment 1.

[Fig. 18C]

FIG. 18C shows an example of an index table in TWL array in Variation of Embodiment 1.

[Fig. 19]

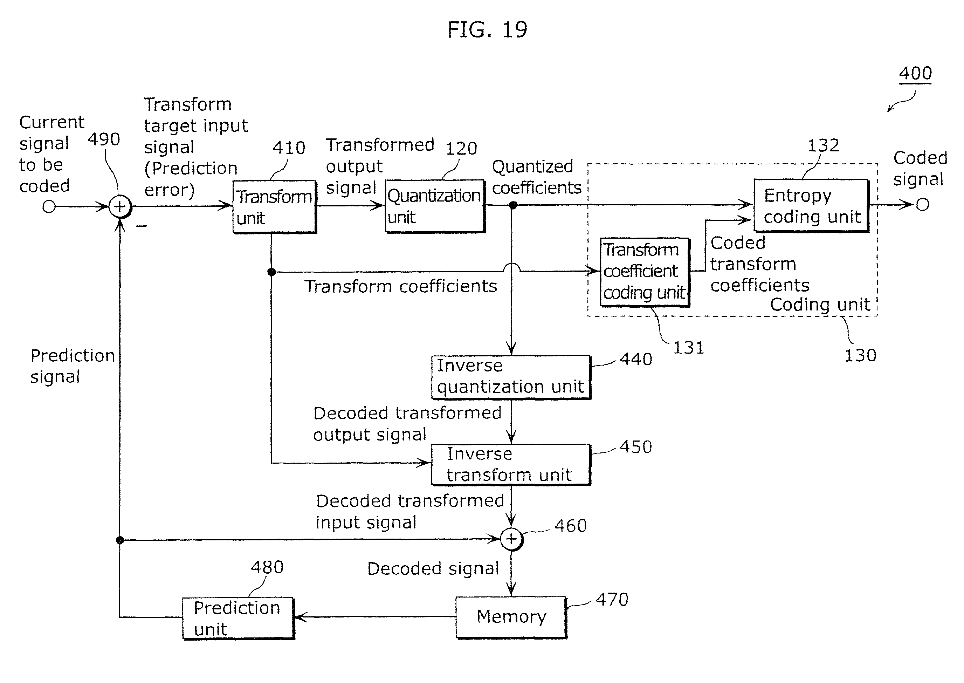

FIG. 19 is a block diagram showing an example of a structure of a coding apparatus in Variation of Embodiment 1.

[Fig. 20]

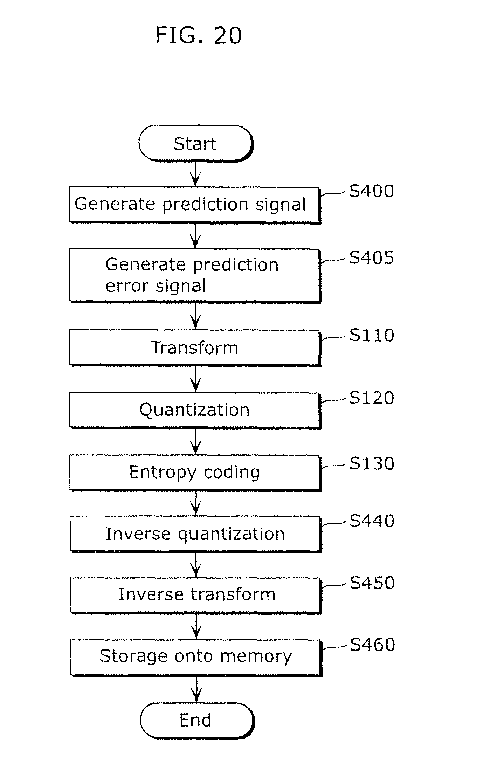

FIG. 20 is a flowchart showing an example of operation of the coding apparatus in Variation of Embodiment 1.

[Fig. 21]

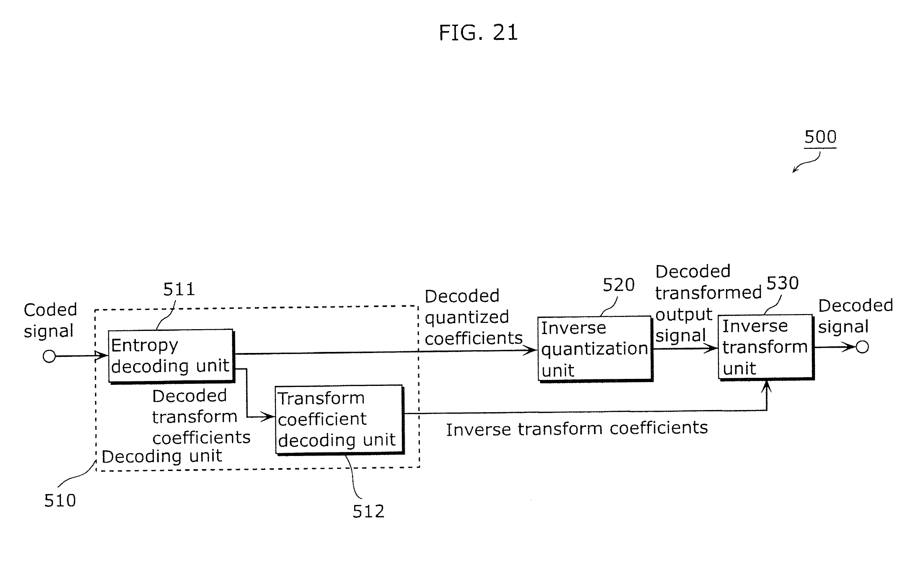

FIG. 21 is a block diagram showing an example of a structure of a decoding apparatus according to Embodiment 2.

[Fig. 22A]

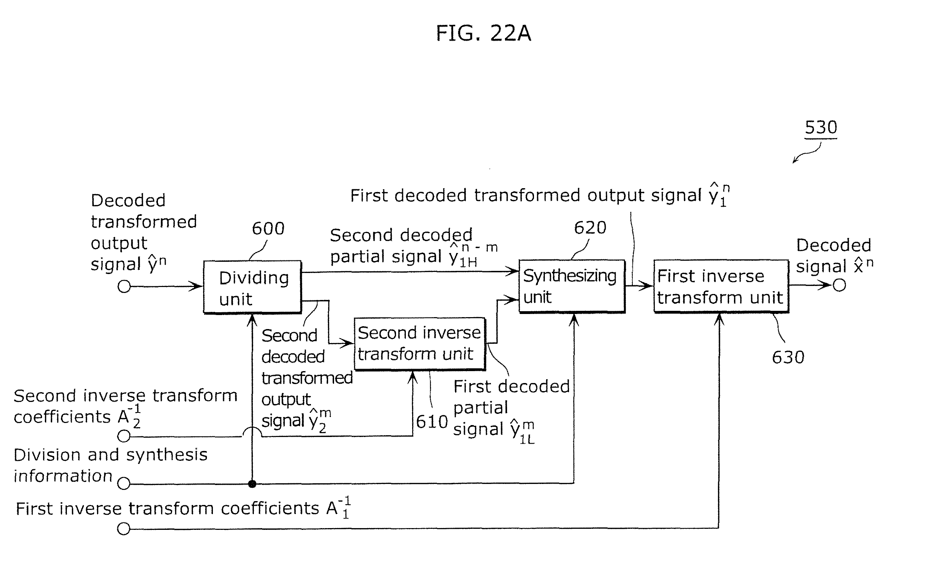

FIG. 22A is a block diagram showing an example of a structure of an inverse transform unit included in the decoding apparatus according to Embodiment 2.

[Fig. 22B]

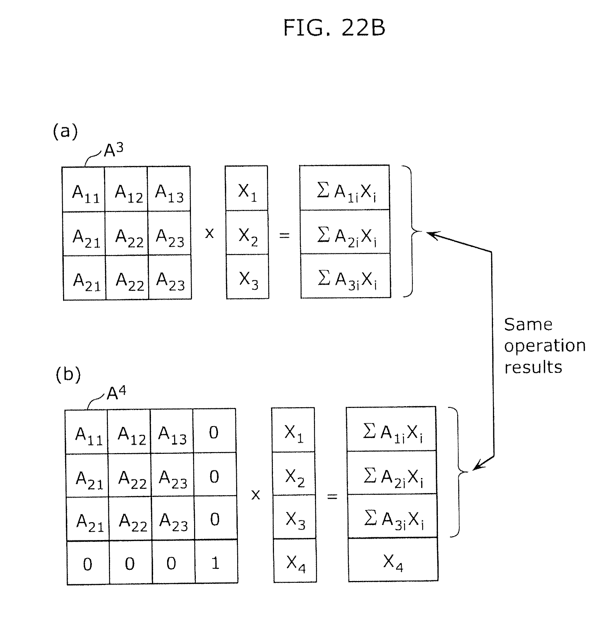

FIG. 22B conceptually shows an example of a matrix operation according to Embodiment 2.

[Fig. 23]

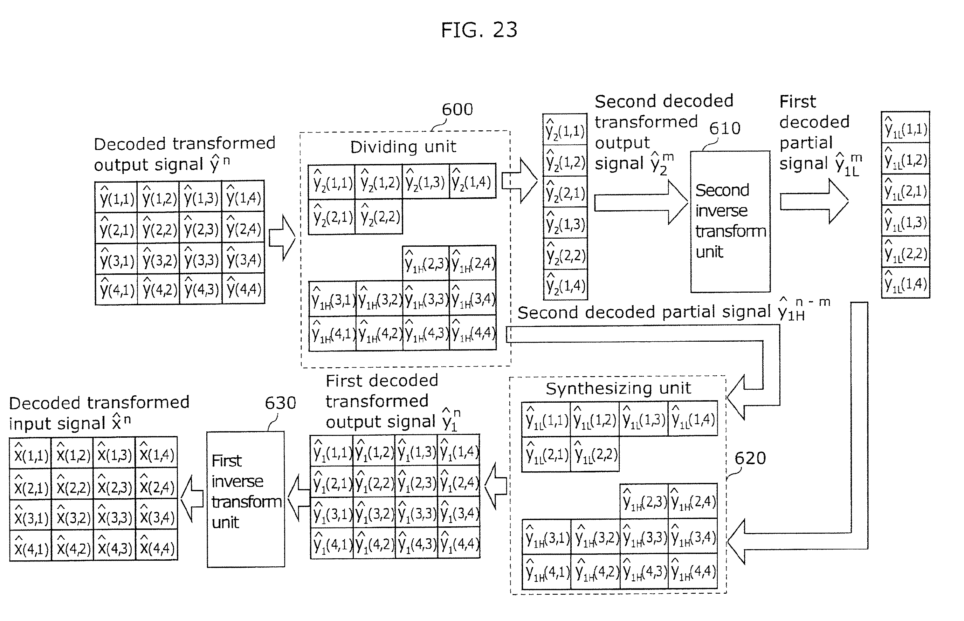

FIG. 23 conceptually shows an example of a data flow in the inverse transform unit according to Embodiment 2.

[Fig. 24]

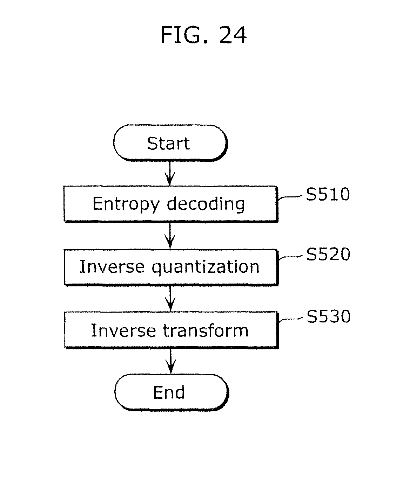

FIG. 24 is a flowchart showing an example of operation of the decoding apparatus according to Embodiment 2.

[Fig. 25]

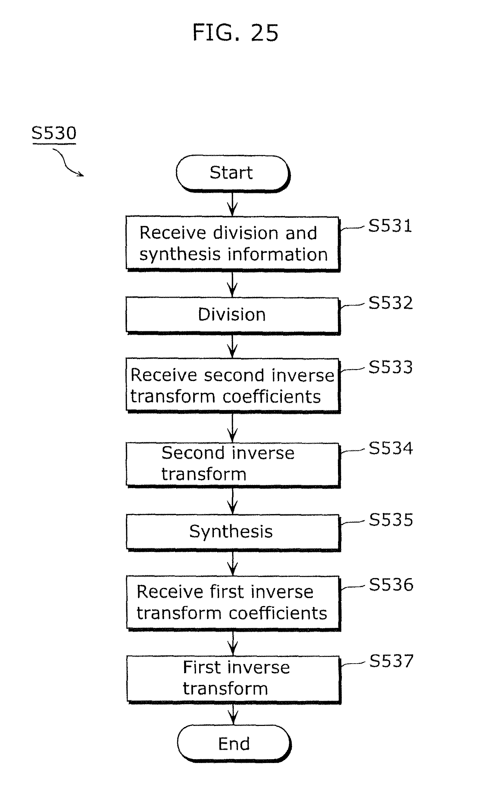

FIG. 25 is a flowchart showing an example of operation of the inverse transform unit according to Embodiment 2.

[Fig. 26]

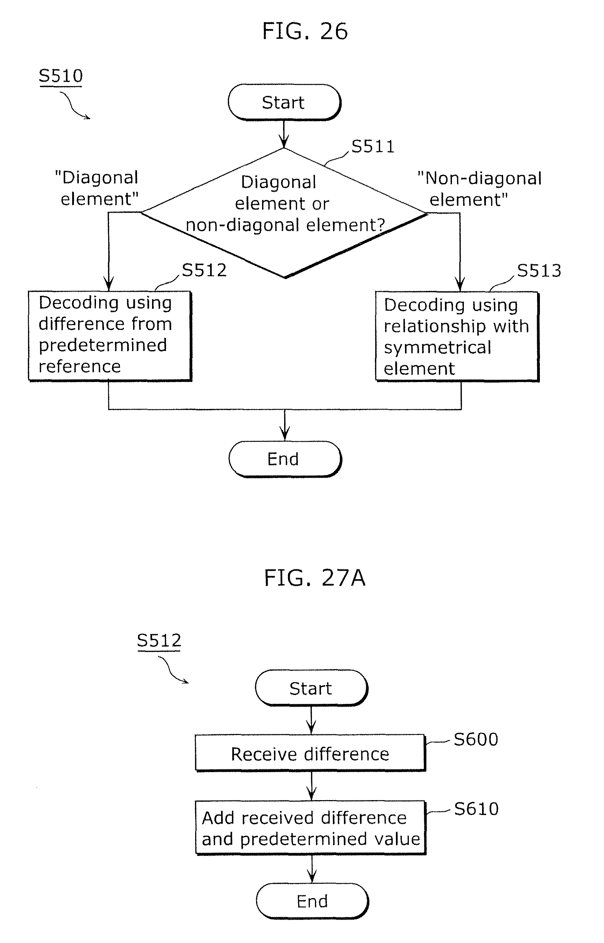

FIG. 26 is a flowchart showing an example of operation of a transform coefficient decoding unit according to Embodiment 2.

[Fig. 27A]

FIG. 27A is a flowchart showing an example of operation of the transform coefficient decoding unit in Embodiment 2 where an element to be decoded is a diagonal element.

[Fig. 27B]

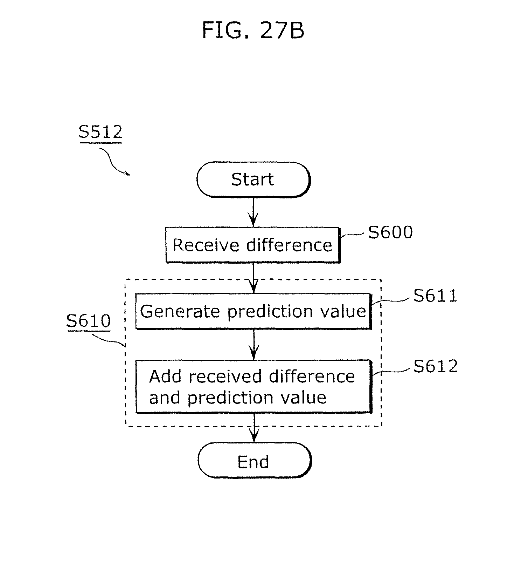

FIG. 27B is a flowchart showing an example of operation of the transform coefficient decoding unit in Embodiment 2 where the element to be decoded is a diagonal element.

[Fig. 28]

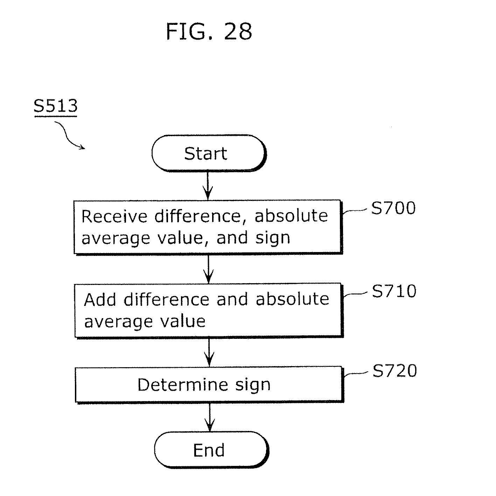

FIG. 28 is a flowchart showing an example of operation of the transform coefficient decoding unit in Embodiment 2 where the elements to be decoded are non-diagonal elements.

[Fig. 29A]

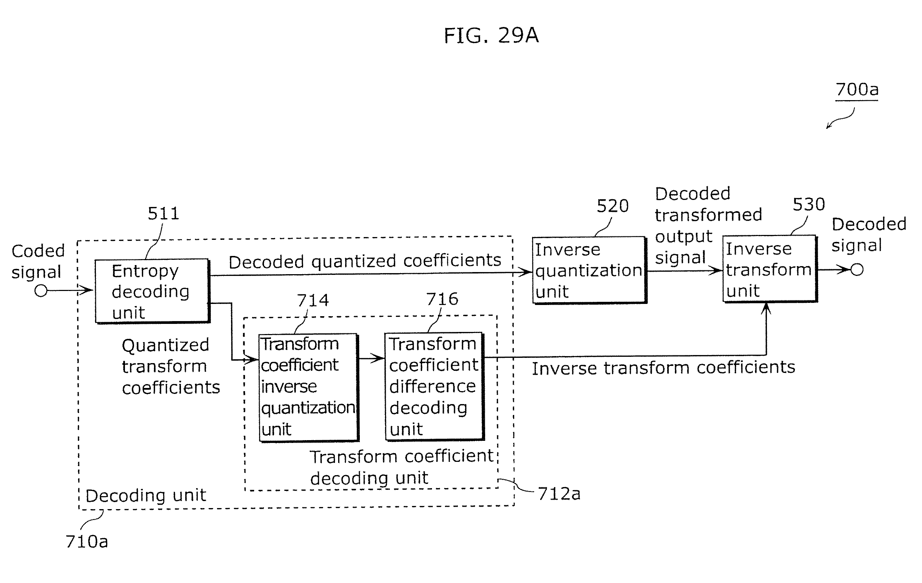

FIG. 29A is a block diagram showing another example of the structure of the decoding apparatus according to Embodiment 2.

[Fig. 29B]

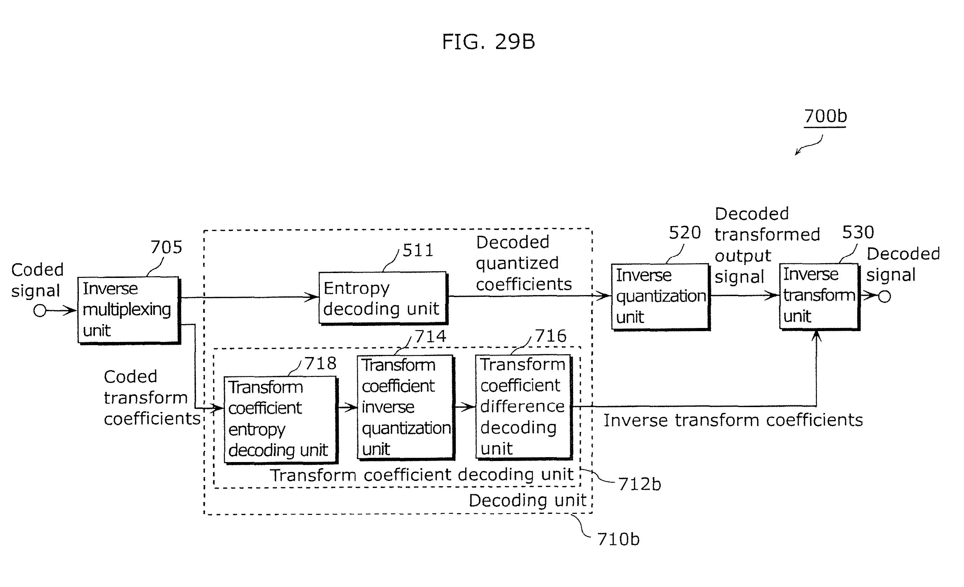

FIG. 29B is a block diagram showing another example of the structure of the decoding apparatus according to Embodiment 2.

[Fig. 30]

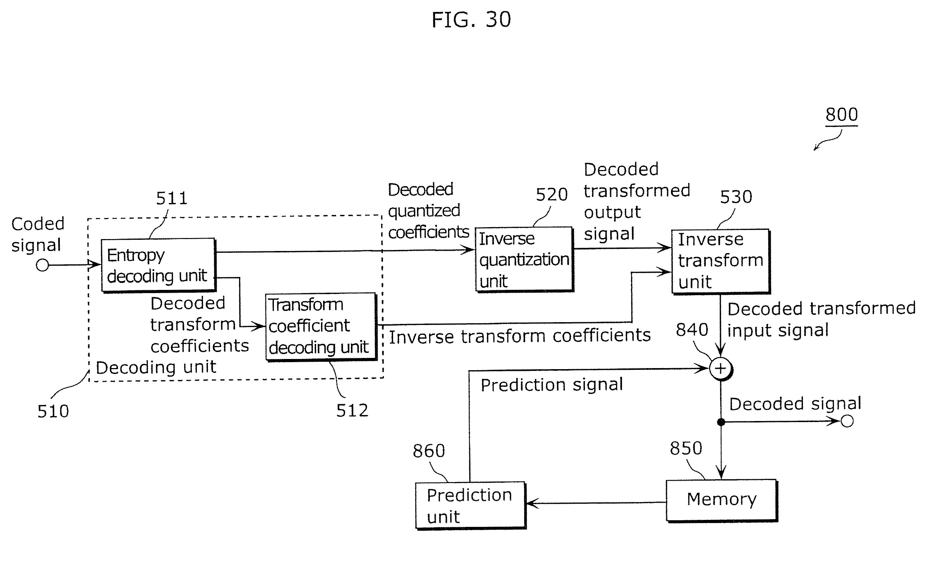

FIG. 30 is a block diagram showing an example of a structure of a decoding apparatus in Variation of Embodiment 2.

[Fig. 31]

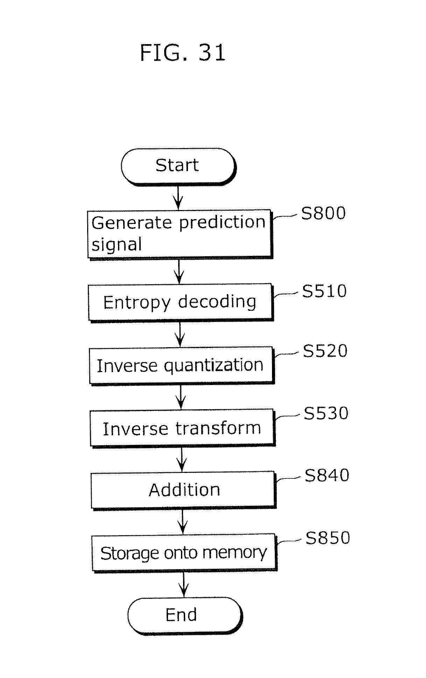

FIG. 31 is a flowchart showing an example of operation of the decoding apparatus in Variation of Embodiment 2.

[Fig. 32]

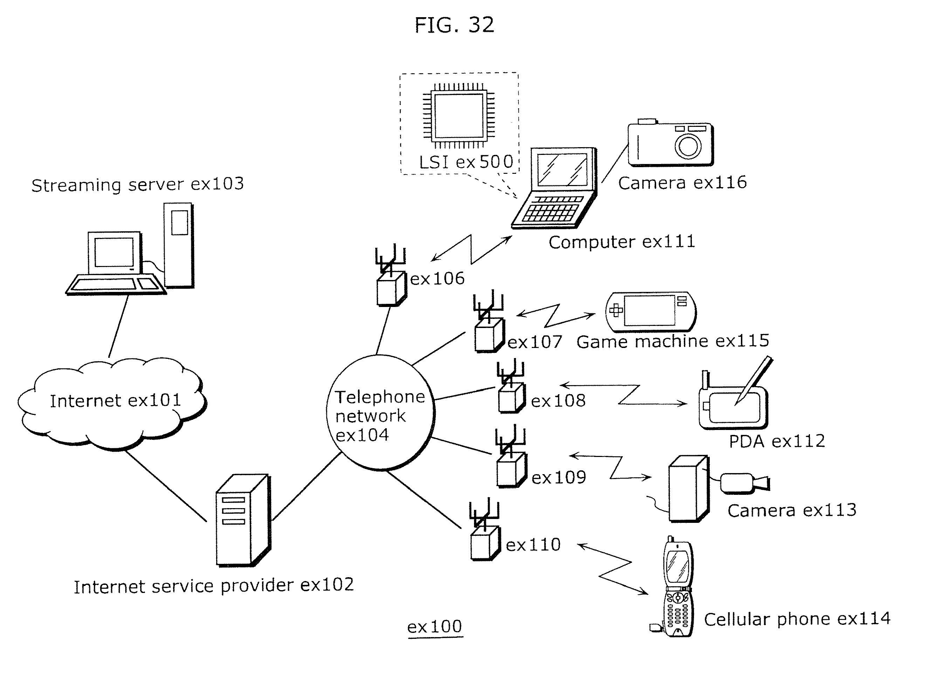

FIG. 32 schematically illustrates an overall configuration of a content providing system for implementing content distribution services.

[Fig. 33]

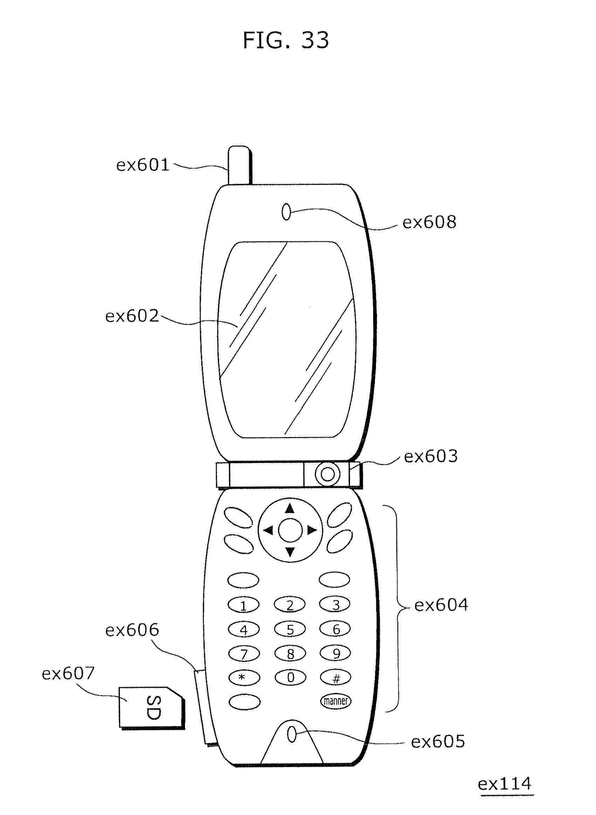

FIG. 33 is an external view of a cellular phone.
[Fig. 34]

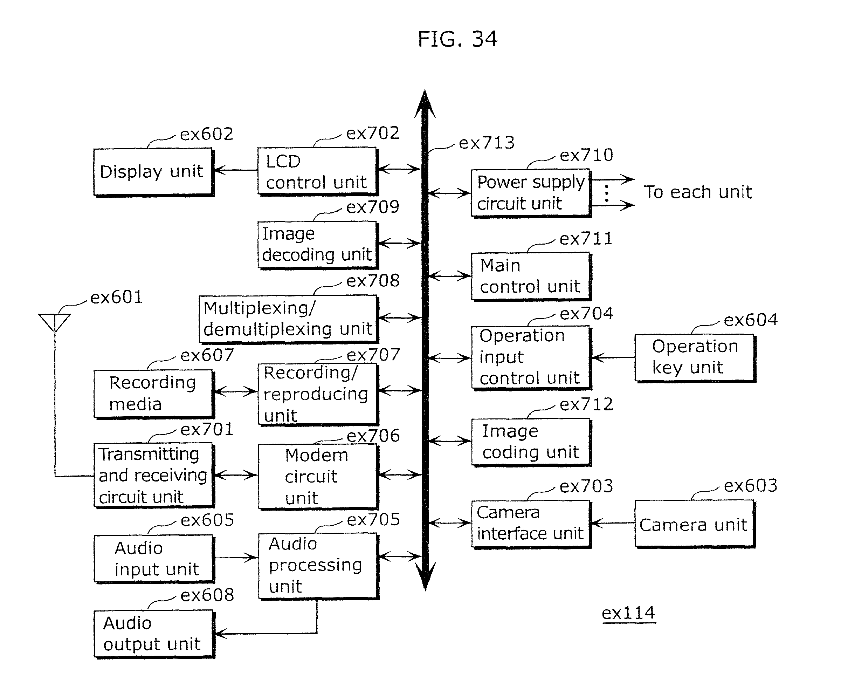

FIG. 34 shows an example of a configuration of the cellular phone.
[Fig. 35]

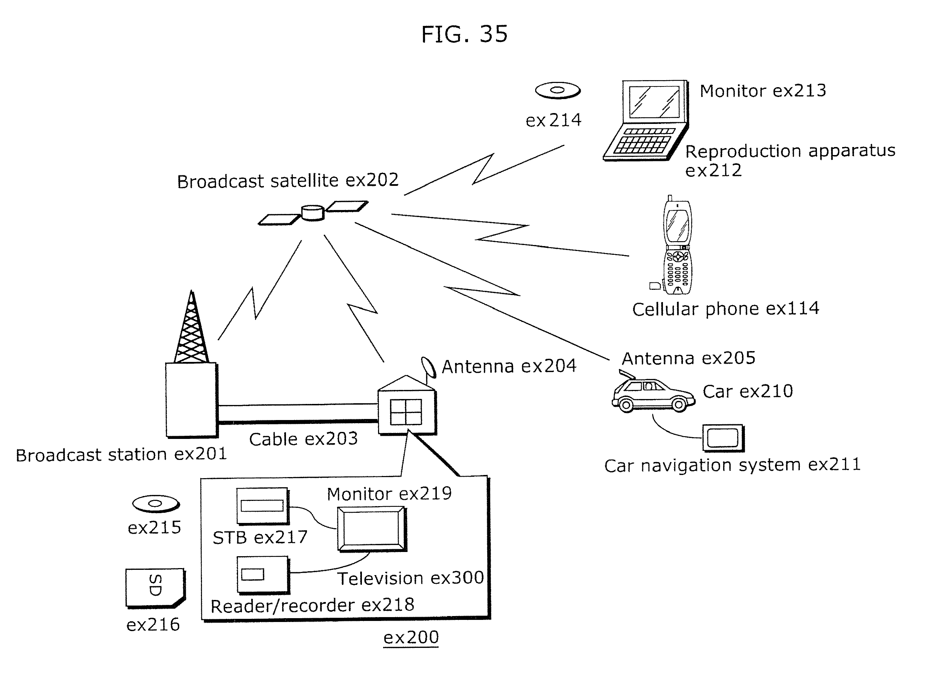

FIG. 35 schematically illustrates an example of an overall configuration of a digital broadcasting system.
[Fig. 36]

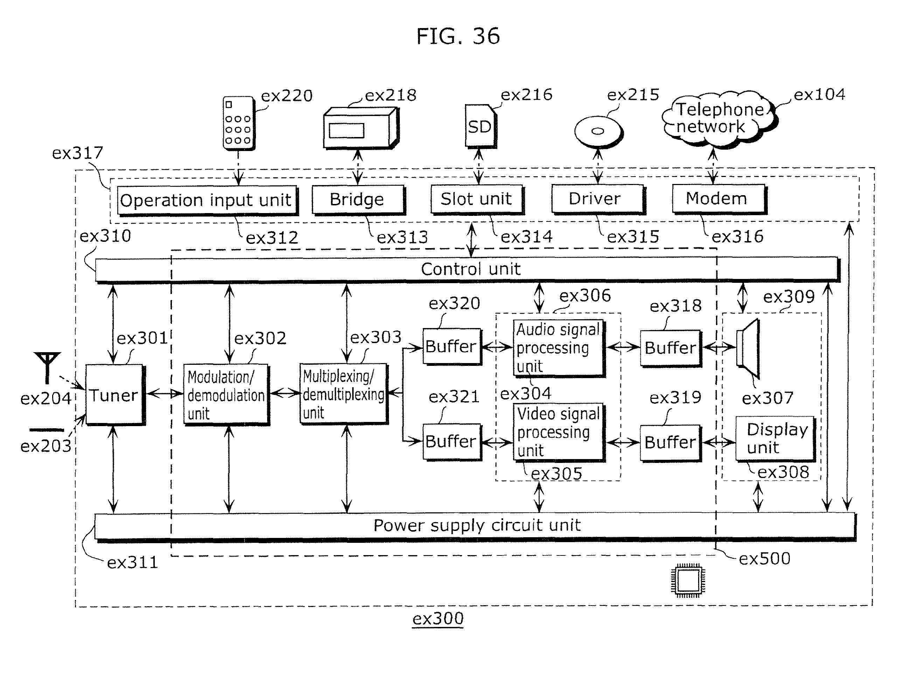

FIG. 36 is a block diagram illustrating an example of a configuration of a television.
[Fig. 37]

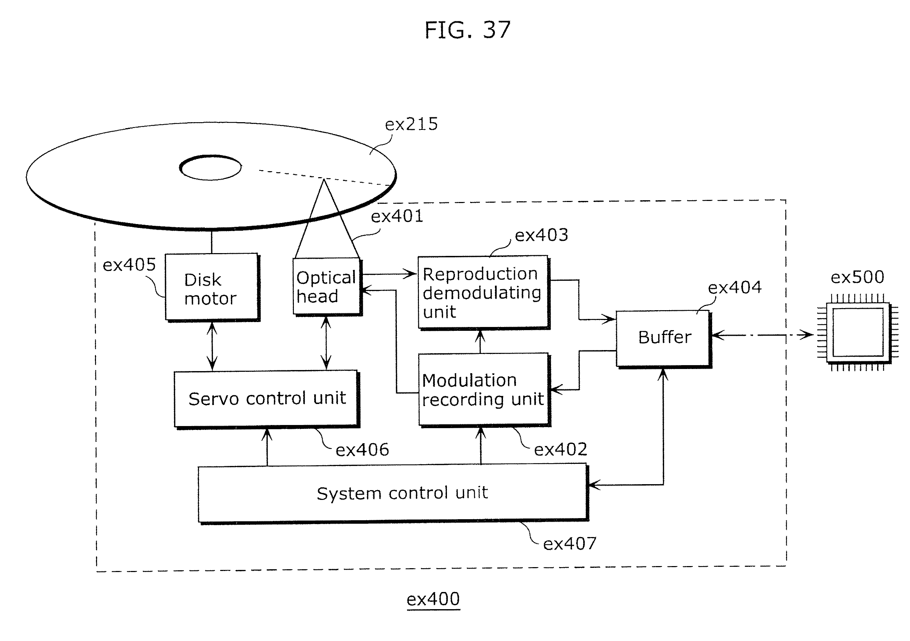

FIG. 37 is a block diagram illustrating an example of a configuration of an information reproducing/recording unit that reads and writes information from or on a recording medium that is an optical disk.
[Fig. 38]

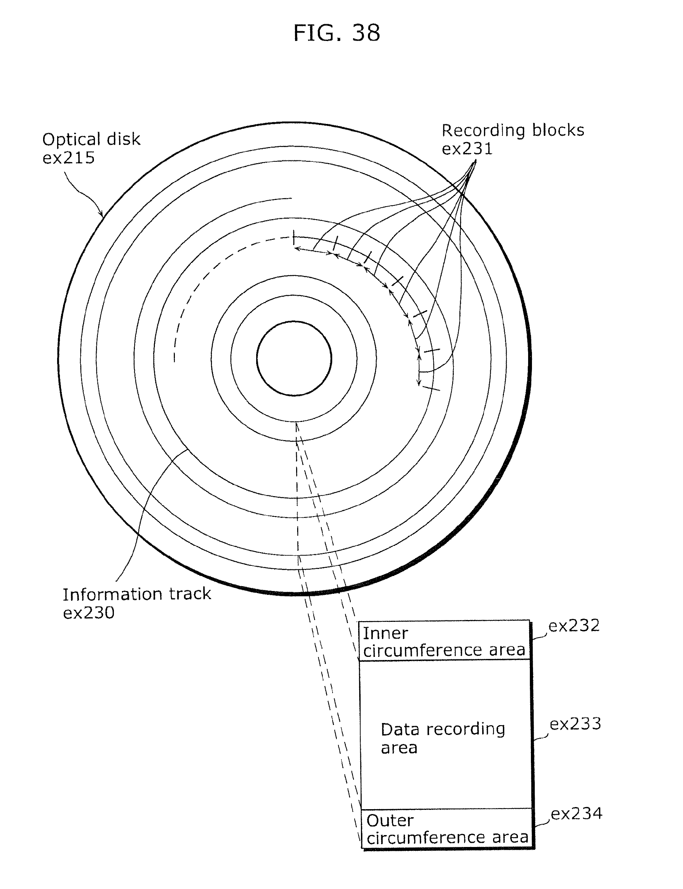

FIG. 38 shows an example of a configuration of a recording medium that is an optical disk.
[Fig. 39]

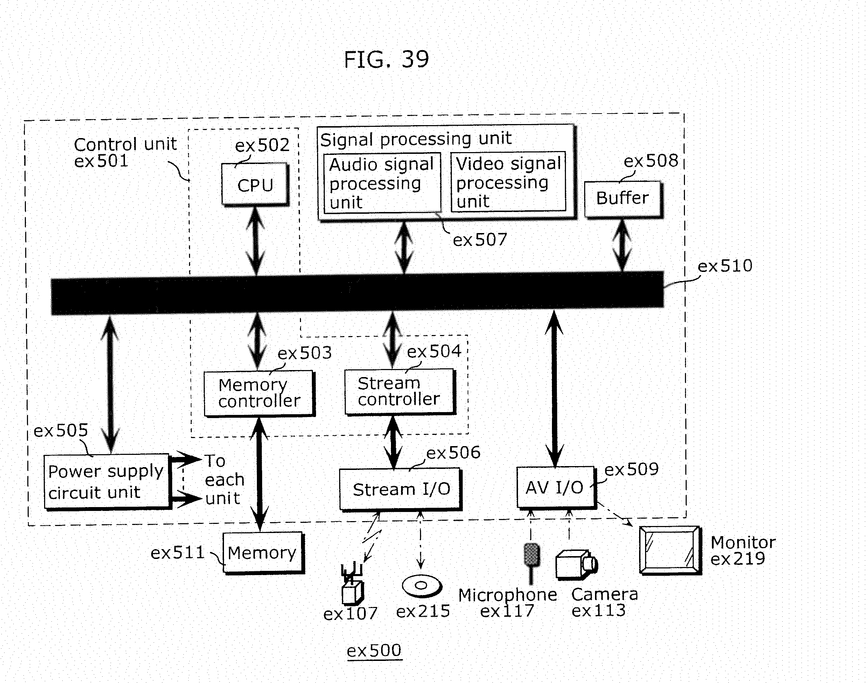

FIG. 39 is a block diagram illustrating an example of a configuration of an integrated circuit for implementing the video coding method and the video decoding method according to Embodiments.

[Description of Embodiments]

(Embodiment 1)

A coding apparatus according to Embodiment 1 is a coding apparatus which generates a coded signal by coding an input signal, and includes: a transform unit which performs transform processing to generate a transformed output signal from the input signal; a quantization unit which quantizes the transformed output signal to generate quantized coefficients; and a coding unit which compression codes the quantized coefficients and transform coefficients to generate the coded signal. The transform unit performs the transform processing on a transform target signal using the transform coefficients that are coefficients in a square matrix determined based on statistical properties of a set including the transform target signal which is based on the input signal and to be a target for the transform processing, and the coding unit calculates a difference between a predetermined value and each element included in the transform coefficients or inverse transform coefficients for use in an inverse transform of the above transform processing and compression codes the calculated difference, thereby compression coding the transform coefficients or the inverse transform coefficients. First, an example of a structure of the coding apparatus according to Embodiment 1 is described below with reference to FIG. 3. It is to be noted that a transform matrix and a transform coefficient are synonymously used in some parts herein.

It is to be noted that even a transform which can be achieved by means other than a simple matrix operation, such as a butterfly operation and an operation using shifts and addition, is represented in form of matrix in some parts herein. It should not be construed that such matrix representation excludes various transforms with a reduced amount of computation, such as a butterfly operation and an operation using shifts and addition or an operation using a lifting construction.

FIG. 3 is a block diagram showing an example of a structure of a coding apparatus 100 according to Embodiment 1. To the coding apparatus 100, an input signal that is various data, such as audio data, still image data, and video data, is input as a current signal to be coded. The coding apparatus 100 includes a transform unit 110, a quantization unit 120, and a coding unit 130 and codes an input signal, that is, the current signal.

To the transform unit 110, the current signal is input as a transform target signal (a transform target input signal). The transform target input signal is represented by, for example, a vector $x^n$ as indicated in Expression 4. For example, the current signal is composed of a plurality of transform target input signals $x^n$.

[Math. 4]

$$x^n = (x_1, x_2, \ldots, x_n)^t$$

(Expression 4)

The transform unit 110 performs the transform processing to generate the transformed output signal from the transform target input signal. The transform processing is transform processing which is performed using transform coefficients that are coefficients in a square matrix determined based on statistical properties of a set including the transform target signal which is to be a target for the transform processing.

For example, the transform unit 110 generates the transformed output signal with reduced correlation by transforming the received transform target input signal from the spatial-temporal domain into the frequency domain using the transform coefficients that are the coefficients in the square matrix. The transformed output signal generated as above is output to the quantization unit 120, and the transform coefficients used in the transform are output to the coding unit 130. Specific operation of the transform unit 110 will be described below with reference to FIG. 4.

The quantization unit 120 quantizes the transformed output signal provided from the transform unit 110 and thereby generates quantized coefficients having a small total amount of data. The quantized coefficients generated as above are output to the coding unit 130.

The coding unit 130 includes a transform coefficient coding unit 131 and an entropy coding unit 132 and compression codes the quantized coefficients provided from the quantization unit 120 and the transform coefficients provided from the transform unit 110.

The transform coefficient coding unit 131 generates the coded transform coefficients by compression coding, according to a predetermined coding scheme, the transform coefficients provided from the coding unit 110. Specific operation of the transform coefficient coding unit 131 will be described below. The coded transform coefficients generated as above are output to the entropy coding unit 132.

The entropy coding unit 132 compression codes the quantized coefficients and the coded transform coefficients using an entropy coding algorithm to generate the coded signal with remaining redundancy further compressed. The coded signal generated as above is, for example, recorded on a recording medium or transmitted to a decoding apparatus through a network.

It is to be noted that, in coding the transform coefficients, the transform coefficient coding unit 131 calculates a difference between a predetermined value and each element included in the transform coefficients and compression codes the calculated difference, thereby compression coding the transform coefficients. Specifically, according to a coding scheme that is different between a diagonal element and a non-diagonal element in a square matrix, the transform coefficient coding unit 131 calculates a difference between each of the elements and a reference that is different between the diagonal element and the non-diagonal element and codes the calculated difference, thereby compression coding the diagonal elements and the non-diagonal elements. A method of coding the transform coefficients will be described below with reference to the drawings. Furthermore, the transform coefficient coding unit 131 may compression codes inverse transform coefficients for use in a decoding apparatus.

Next, an example of a structure of the coding unit 110 according to Embodiment 1 is described in more detail.

FIG. 4 is a block diagram showing an example of the structure of the coding unit 110 included in the coding apparatus 100 according to Embodiment 1. As shown in FIG. 4, the coding unit 110 includes a first transform unit 200, a first memory 201, a first transform coefficient deriving unit 202, a dividing unit 210, a second memory 211, a division and synthesis information generation unit 212, a second transform unit 220, a third memory 221, a second transform coefficient deriving unit 222, and a synthesizing unit 230.

The first transform unit 200 generates a first transformed output signal $y_1^n$ by transforming a transform target input signal $x^n$ using a first transform matrix $A_1^n$. The transform using the first transform matrix $A_1^n$ is referred to as a first transform $T_1$. The first transform $T_1$ is processing of transforming the transform target input signal $x^n$ that is a signal in the spatial-temporal domain, into the first transformed output signal $y_1^n$ that is a signal in the frequency domain.

Thus, the first transform unit 200 generates the first transformed output signal $y_1^n$ by performing the first transform $T_1$ on the transform target input signal $x^n$. The first transformed output signal $y_1^n$ generated as above is output to the dividing unit 210 and the second memory 211.

The first memory 201 is a memory which holds the transform target input signal $x^n$. For example, when the transform target input signal $x^n$ is audio data or image data, the first memory 201 holds a plurality of transform target input signals $x^n$ which corresponds to data for one frame.

The first transform coefficient deriving unit 202 derives the first transform matrix $A_1^n$ using the transform target input signals $x^n$ held in the first memory 201. The first transform matrix $A_1^n$ may be predetermined fixed values or coefficients determined by the KLT. When the first transform matrix $A_1^n$ is the predetermined fixed values, the transform unit 110 is not required to include the first memory 201 and the first transform coefficient deriving unit 202 and instead, it is sufficient that the first transform unit 200 stores the predetermined fixed values in an internal memory or the like. A method of determining the transform coefficients by the KLT will be described below.

The dividing unit 210 divides the first transformed output signal $y_1^n$ into a first partial signal $y_{1L}^m$ and a second partial signal $y_{1H}^{n-m}$ so that correlation energy of the first partial signal $y_{1L}^m$ is larger than correlation energy of the second partial signal $y_{1H}^{n-m}$. The first partial signal $y_{1L}^m$ is output to the second transform unit 220 and the third memory 221. The second partial signal $y_{1H}^{n-m}$ is output to the synthesizing unit 230.

For example, using division and synthesis information that is information indicating how to divide the first transformed output signal $y_1^n$, the dividing unit 210 divides the first transformed output signal $y_1^n$ having N elements (i.e., having the number of dimensions N), into the first partial signal $y_{1L}^m$ having M elements (i.e., having the number of dimensions M) and the second partial signal $y_{1H}^{n-m}$ having N-M elements (i.e., having the number of dimensions N-M). Here, M is a natural number smaller than N. It is to be noted that the dividing unit 210 determines whether or not the data is to be a target for the second transform, and the division is not limited to explicit data division.

The dividing unit 210 may divide the first transformed output signal $y_1^n$ at a predetermined position for division so that each of the first partial signal $y_{1L}^m$ and the second partial signal $y_{1H}^{n-m}$ include the predetermined number of elements. In this case, the transform unit 110 is not required to include the second memory 211 and the division and synthesis information generation unit 212 and instead, it is sufficient that the dividing unit 210 stores, in an internal memory or the like, the division and synthesis information indicating the number of elements and the position for division of each of the partial signals.

The second memory 211 is a memory which holds the first transformed output signal $y_1^n$. For example, the second memory 211 holds a plurality of first transformed output signals $y_1^n$ which corresponds to data for one frame.

The division and synthesis information generation unit 212 generates the division and synthesis information using the first transformed output signal $y_1^n$ held in the second memory 211. The division and synthesis information is, for example, control information for instructing the dividing unit 210 to divide the first transformed output signal $y_1^n$ into the first partial signal having elements in a low-frequency band and the second partial signal having elements in a high-frequency band. Alternatively, the division and synthesis information is control information for instructing the dividing unit 210 to divide the first transformed output signal $y_1^n$ into the first partial signal having elements with large correlation energy and the second partial signal having elements with small correlation energy.

The division and synthesis information generation unit 212 generates the division and synthesis information in view of energy distribution of the plurality of first transformed output signals $y_1^n$. For example, the division and synthesis information generation unit 212 divides the first transformed output signal $y_1^n$ into the first partial signal having elements with correlation energy larger than a predetermined threshold and the second partial signal having elements with correlation energy smaller than the threshold.

The second transform unit 220 generates a second transformed output signal $y_2^m$ by transforming the first partial signal $y_{1L}^m$ using a second transform matrix $A_2^m$. The transform using the second transform matrix $A_2^m$ is referred to as a second transform $T_2$. In short, the second transform unit 220 generates the second transformed output signal $y_2^m$ by performing the second transform $T_2$ on the first partial signal $y_{1L}^m$. The second transformed output signal $y_2^m$ generated as above is output to the synthesizing unit 230.

The third memory 221 is a memory which holds the first partial signal $y_{1L}^m$. For example, the third memory 221 holds a plurality of first partial signals $y_{1L}^m$ which corresponds to data for one frame. It is to be noted that, as will be described below, the second transform coefficient deriving unit 222 preferably derives the second transform matrix $A_2^m$ using a set which is smaller than the set used to derive the first transform matrix $A_1^n$. Accordingly, the storage capacity of the third memory 221 may be smaller than that of the first memory 201.

The second transform coefficient deriving unit 222 derives the second transform matrix $A_2^m$ using the first partial signal $y_{1L}^m$ held in the third memory 221. The second transform matrix $A_2^m$ is, for example, coefficients determined by the KLT. A method of determining the transform coefficients by the KLT will be described below.

The synthesizing unit 230 generates the transformed output signal $y^n$ by synthesizing the second transformed output signal $y_2^m$ and the second partial signal $y_{1H}^{n-m}$ using the division and synthesis information. The transformed output signal $y^n$ generated as above is output to the quantization unit 120.

Since the second transform matrix $A_2^m$ is transform coefficients designed optimally for the first partial signal $y_{1L}^m$ by the KLT, the second transform unit 220 is capable of reducing redundancy remaining in the first transformed output signal $y_1^n$ by performing the second transform $T_2$. This produces an effect of contributing to compression of the coded signal.

At this time, the second transform unit 220 performs the second transform $T_2$ on the first partial signal $y_{1L}^m$ having the smaller number of elements than the elements of the first transformed output signal $y_1^n$. Accordingly, the amount of computation by the second transform unit 220 can be reduced, and the amount of data of the second transform matrix $A_2^m$ for use in the second transform $T_2$ can be reduced.

It is to be noted that the transform unit 110 according to Embodiment 1 of the present invention is not required to include the dividing unit 210 and the synthesizing unit 230. Specifically, instead of explicitly dividing the first transformed output signal $y_1^n$, it is sufficient that the transform unit 110 determines elements which are to be a target for the second transform $T_2$, from among the elements included in the first transformed output signal $y_1^n$, and performs the second transform $T_2$ only on the determined elements.

For example, the second transform unit 220 receives the first transformed output signal $y_1^n$ and performs, on the received first transformed output signal $y_1^n$, the second transform $T_2$ using the second transform coefficients. At this time, the second transform unit 220 sets, at 1, coefficient values of the second transform coefficients which are multiplied by elements which are not to be a target for the second transform $T_2$ (that is, elements included in the second partial signal) among the elements included in the first transformed output signal $y_1^n$. This allows the second transform unit 220 to perform the second transform $T_2$ only on the elements which are to be a target for the second transform $T_2$ among

the elements included in the first transformed output signal $y_1^n$.

At this time, the division and synthesis information generation unit 212 may generate selection range information for determining the elements which are to be a target for the second transform $T_2$. The second transform unit 220 may determine the elements which are to be a target for the second transform $T_2$, based on the selection range information generated by the division and synthesis information generation unit 212.

It is to be noted that the division and synthesis information described above is an example of the selection range information.

Subsequently, a flow of data in the transform unit 110 is described by giving an example of the transform target input signal $x^n$ as shown in FIG. 5. FIG. 5 conceptually shows an example of a data flow in the second transform unit 110 according to Embodiment 1.

As shown in FIG. 5, the transform target input signal $x^n$ composed of 16 elements (i.e., whose number of input elements is 16) is input to the transform unit 110. First, the first transform unit 200 generates the first transformed output signal $y_1^n$ by performing the first transform $T_1$ on the transform target input signal $x^n$. The first transformed output signal $y_1^n$ is output to the dividing unit 210.

The dividing unit 210 divides the first transformed output signal $y_1^n$ into the first partial signal $y_{1L}^m$ and the second partial signal $y_{1H}^{n-m}$. At this time, the dividing unit 210 rearranges the first partial signal $y_{1L}^m$ so that they are in one dimension and outputs the rearranged first partial signal $y_{1L}^m$ to the second transform unit 220. The second partial signal $y_{1H}^{n-m}$ is output to the synthesizing unit 230. It is to be noted that the dividing unit 210 preferably rearranges the first partial signal $y_{1L}^m$ so that the respective elements become arranged from a low-frequency band to a high-frequency band. The first partial signal $y_{1L}^m$ provided from the dividing unit 210 is not rearranged in one dimension, and in the second transform, a horizontal transform and a vertical transform are performed sequentially (in random order). The structure may be of a separable type.

For example, in the example shown in FIG. 5, the first partial signal $y_{1L}^m$ is composed of 6 elements (whose number of input elements is 6), and the second partial signal $y_{1H}^{n-m}$ is composed of 10 elements (whose number of input elements is 10). While the first partial signal $y_{1L}^m$ is composed of 6 consecutive elements, they may be composed of discrete elements.

The second transform unit 220 generates the second transformed output signal $y_2^m$ by performing the second transform $T_2$ on the first partial signal $y_{1L}^m$. The second transformed output signal $y_2^m$ generated as above is output to the synthesizing unit 230. This second transform $T_2$ further reduces correlation of the first partial signal $y_{1L}^m$, and the second transformed output signal $y_2^m$ to be output will be a signal with energy more concentrated in a low-frequency band.

The synthesizing unit 230 rearranges the second transformed output signal $y_2^m$ so that they are in a dimension (which is two dimensions in this case) in which they had been before being rearranged by the dividing unit 210. The synthesizing unit 230 then synthesizes the rearranged second transformed output signal $y_2^m$ and the rearranged second partial signal $y_{1H}^{n-m}$ to generate the transformed output signal $y^n$.

As described above, in the coding apparatus 100 according to Embodiment 1, the transform unit 110 transforms, at two stages, the received transform target input signal. Specifically, in the first transform at the first stage, the transform target input signal in the spatial-temporal domain is transformed into the transformed output signal in the frequency domain. Furthermore, the second transform using the KLT is performed on a part of the transformed output signal (preferably a signal including a low-frequency component).

The following describes a method of deriving transform coefficients by the KLT which is performed by at least the second transform unit 220. The KLT is an approach for designing a transform in which an input signal can be completely de-correlated based on the statistical properties of a set including the input signal.

Specifically, the KLT is to determine a transform in which non-diagonal elements of a variance-covariance matrix of the input signal are 0, and is equivalent to solving an eigenvalue problem of the variance-covariance matrix. The derived eigenvector becomes a basis function, and the eigenvalue becomes magnitude (i.e., energy) of the axis of each element of the transform coefficients. The elements are arranged from one with an axis having a large eigenvalue (variance or energy) to another with an axis having a small eigenvalue (variance or energy).

FIG. 6 schematically illustrates an example of derivation, by the KLT, of transform coefficients.

The transform target input signal $x^n$ which is input to the transform unit 110 is held in the first memory 201. The first transform coefficient deriving unit 202 derives the first transform matrix $A_1^n$ based on the set $S_A$ including, as samples, the plurality of transform target input signals $x^n$ held in the first memory 201. For example, the first transform coefficient deriving unit 202 derives, by the KLT, the first transform matrix $A_1^n$ optimized on average to many of the samples included in the set $S_A$.

This allows the first transform coefficient deriving unit 202 to perform the first transform using the common first transform matrix $A_1^n$ without much influence of the statistical properties of the respective transform target input signals $x^n$, even when the properties are slightly different. Consequently, the frequency of updates for the first transform matrix $A_1^n$ can be reduced (for example, on a per frame basis), which allows a reduction in the amount of computation. In addition, even when the first transform matrix $A_1^n$ is updated, an amount of change of each value from before to after the update is small, with the result that the amount of difference information can be small.

Meanwhile, the first partial signal $y_{1L}{}^m$ including elements with large correlation energy out of the first transformed output signal $y_1{}^n$ generated by the first transform unit 200 is held in the third memory 221. The second transform coefficient deriving unit 222 derives the second transform matrix $A_2{}^m$ based on a set $S_C$ including, as samples, the plurality of first partial signals $y_{1L}{}^m$ held in the third memory 221. For example, the second transform coefficient deriving unit 222 derives, by the KLT, the second transform matrix $A_2{}^m$ optimized on average to many of the samples included in the set $S_C$.

At this time, the set $S_C$ is a set smaller than the set $S_A$. For example, when the set $S_A$ is a set which corresponds to data for one frame, the set $S_C$ is a set which corresponds to data of a slice or a macroblock in image data or to data of a sub-frame or a sub-band in audio data. It is to be noted that it is sufficient that the set $S_C$ includes at least two samples (the first partial signal $y_{1L}{}^m$).

As above, the coding apparatus 100 according to Embodiment 1 uses the plurality of transforms including the first transform $T_1$ and the second transform $T_2$. The first transform $T_1$ is performed using the first transform matrix $A_1{}^n$ derived optimally according to the statistical properties of the larger set $S_A$, and the second transform $T_2$ is performed using the second transform matrix $A_2{}^m$ derived optimally according to the statistical properties of the smaller set $S_C$.

Providing the set $S_C$ which is a set smaller than the set $S_A$ as above enables timely responses to changes in the statistical properties of the first transformed output signal $y_1{}^n$, which allows a further reduction in correlation and compression of energy. Although a decrease in the size of the set $S_C$ increases the frequency of updates (the frequency of derivations) for the second transform matrix $A_2{}^m$, the total number of elements included in the second transform matrix $A_2{}^m$ decreases because the first partial signal $y_{1L}{}^m$ is a part of the first transformed output signal $y_1{}^n$ and have a smaller number of dimensions (a smaller number of elements) than that of the transform target input signal $x^n$, with the result that there can be a balance between a high-efficiency transform and reductions in the amount of computation and in the amount of data.

As above, the transform processing in Embodiment 1 is processing of determining transform coefficients which are coefficients in a square matrix, based on the statistical properties of a set including a transform target signal which is to be a target for the transform processing, and transforming the transform target signal using the determined transform coefficients. It is to be noted that the transform target signal in the first transform unit 200 is the transform target input signal $x^n$, and the transform target signal in the second transform unit 220 is the first partial signal $y_{1L}{}^m$. Since the set $S_C$ including the first partial signal $y_{1L}{}^m$ is a set smaller than the set $S_A$ including the transform target input signal $x^n$, the amount of computation and the amount of data can be reduced.

While the dividing unit 210 and the synthesizing unit 230 are not shown in FIG. 6, the first transformed output signal $y_1{}^n$ that is output from the first transform unit 200 is divided into the first partial signal $y_{1L}{}^m$ and the second partial signal $y_{1H}{}^{n-m}$ as shown in FIGS. 4 and 5. The second transformed output signal $y_2{}^m$ that is output from the second transform unit 220 are synthesized with the second partial signal $y_{1H}{}^{n-m}$ and output, as the transformed output signal $y^n$, to the quantization unit 120. FIG. 6 shows the processing units and data particularly related to the second transform $T_2$.

Next, a coding method which the coding apparatus 100 according to Embodiment 1 performs is described.

FIG. 7 is a flowchart showing an example of the operation of the coding apparatus 100 according to Embodiment 1.

First, the current signal of audio data, image data, or the like is input to the coding apparatus 100. To the transform unit 110, the received current signal is input as transform target input signal. The transform unit 110 generates the transformed output signal $y^n$ by transforming, using the predetermined transform coefficients, the transform target input signal $x^n$ from the spatial-temporal domain into the frequency domain (S110).

Next, the quantization unit 120 quantizes the transformed output signal generated as above and thereby generates the quantized coefficients (S120). At the end, the coding unit 130 compression codes the quantized coefficients generated by the quantization unit 120 and the transform coefficients used in the transform by the transform unit 110 and thereby generates the coded signal (S130). Specifically, first, the transform coefficient coding unit 131 codes the transform coefficients, thereby generating the coded transform coefficients. The entropy coding unit 132 then entropy codes the coded transform coefficients and the quantized coefficients, thereby generating the coded signal.

In the above-described manner, the coding apparatus 100 according to Embodiment 1 is capable of reducing the amount of information by coding the received current signal.

Subsequently, the transform processing (S110) which the coding apparatus 100 according to Embodiment 1 performs and especially the coding of the transform coefficients in the coding process (S130) are described in detail. First, the transform processing (S110) is described.

FIG. 8 is a flowchart showing an example of the operation of the transform unit 110 according to Embodiment 1.

First, the received transform target input signal $x^n$ is accumulated in the first memory 201. The first transform coefficient deriving unit 202 determines the first transform matrix $A_1{}^n$ based on the plurality of transform target input signals $x^n$ accumulated in the first memory 201 (S111).

Next, the first transform unit 200 performs, using the determined first transform matrix $A_1{}^n$, the first transform $T_1$ on the transform target input signal $x^n$, thereby generating the first transformed output signal $y_1{}^n$ (S112). The first

transformed output signal $y_1^n$ generated as above is accumulated in the second memory 211.

Next, the division and synthesis information generation unit 212 generates the division and synthesis information based on the plurality of first transformed output signals $y_1^n$ accumulated in the second memory 211 (S113). The dividing unit 210 then divides, using the generated division and synthesis information, the first transformed output signal $y_1^n$ into the first partial signal $y_{1L}^m$ and the second partial signal $y_{1H}^{n-m}$ (S114). The first partial signal $y_{1L}^m$ is accumulated in the third memory 221.

Next, the second transform coefficient deriving unit 222 determines the second transform matrix $A_2^m$ based on the plurality of first partial signals $y_{1L}^m$ accumulated in the third memory 221 (S115). The second transform unit 220 then performs, using the determined second transform matrix $A_2^m$, the second transform on the first partial signal $y_{1L}^m$, thereby generating the second transformed output signal $y_2^m$ (S116).

At the end, the synthesizing unit 230 synthesizes the second transformed output signal $y_2^m$ and the second partial signal $y_{1H}^{n-m}$, thereby generating the transformed output signal $y^n$ (S117).

In the case where the first transform is not a method of adaptively deriving transform coefficients, such as the KLT, but uses fixed transform coefficients, or in the case where the elements which are a target for the second transform are fixed, the processing of determining the first transform coefficients (S111) and the processing of generating the division and synthesis information (S113) may be omitted, respectively.

Subsequently, the coding of the transform coefficients according to Embodiment 1 is described.

As described above, in the coding apparatus 100 according to Embodiment 1, the coding unit 130 codes not only the quantized coefficients but also the transform coefficients used in the transform in the transform unit 110. At this time, the transform coefficients are a square matrix composed of a plurality of elements, and the coding unit 130 codes the transform coefficients according to a coding scheme which is different between diagonal elements and non-diagonal elements in the square matrix. Specifically, the transform coefficient coding unit 131 included in the coding unit 130 judges whether each of the current elements to be coded is a diagonal element or a non-diagonal element, calculates a difference between the current element and its suitable predetermined value, and codes the calculated difference, thereby coding the current element.

FIG. 9 is a flowchart showing an example of the operation of the transform coefficient coding unit 131 according to Embodiment 1.

The transform coefficient coding unit 131 codes the transform coefficients received from the transform unit 110, for each of the elements included in the received transform coefficients. First, the transform coefficient coding unit 131 judges whether the current element is a diagonal element or a non-diagonal element (S131).

When the current element is a diagonal element ("Diagonal element" in S131), the transform coefficient coding unit 131 codes the current element using a difference between a predetermined reference and the current element (S132). Specific processing will be described below.

When the current element is a non-diagonal element ("Non-diagonal element" in S131), the transform coefficient coding unit 131 codes the current element using relationship with its symmetrical element (S133). The symmetrical element is an element at a position symmetrical to the non-diagonal element about the diagonal element. Specific processing will be described below.

Thus, the coding apparatus 100 according to Embodiment 1 codes the transform coefficients using a coding scheme that is different depending on whether the current element is a diagonal element or a non-diagonal element. The following describes, in more detail, the coding of the transform coefficients in the coding apparatus 100 according to Embodiment 1.

In the following, it is assumed as an example that the first partial signal $y_{1L}^m$ having 4 elements are input to the second transform unit 220, and the second transform unit 220 transforms the first partial signal $y_{1L}^m$ using the second transform matrix $A_2^m$ which is a 4x4 matrix, and outputs the first partial transformed output signal $y_2^m$, as shown in FIG. 10A.

As shown in FIG. 10B, each element included in the second transform matrix $A_2^m$ is represented by $a(i, j)$ (or $a_{ij}$) where i = 1, 2, 3, or 4 and j = 1, 2, 3, or 4. In this case, as shown in FIG. 10B, the element ($a_{ii}$) where i=j is a diagonal element, and the element where i≠j is a non-diagonal element. Furthermore, the non-diagonal elements are classified into top-triangle elements that are elements where i<j and bottom-triangle elements that are elements where i>j.

First, the case where the current element is a diagonal element is described.

FIG. 11A is a flowchart showing an example of the operation of the transform coefficient coding unit 131 in Embodiment 1 where the current element is a diagonal element.

First, when the current element is a diagonal element, the transform coefficient coding unit 131 calculates a difference between the current element and a predetermined value (S200). The predetermined value is the largest possible value (for example, 1) of the elements in a square matrix which are the transform coefficients, for example.

Next, the transform coefficient coding unit 131 codes the calculated difference, thereby generating the coded transform coefficients (S210). Specifically, the calculated difference is a value which is described in the header of the coded signal (the coded bit stream) generated by the entropy coding unit 132 (which value is hereinafter referred to as a header description), and the entropy coding unit 132 entropy codes the header description.

In the above-described manner, the transform coefficient coding unit 131 and the entropy coding unit 132 code the diagonal elements. It is to be noted that the processing shown in FIG. 11A is an example of the coding process (S132) using a difference from a predetermined reference shown in FIG. 9.

Here, the header description h(i, i) is represented by Expression 5.

[Math. 5]

$$\text{(Expression 5)} \quad h(i, i) = a(i, i) - c$$

For example, c=1. Alternatively, c may be another value close to 1. The reason why the predetermined value 1 is set at 1 or at another value close to 1 is as follows.

If the first transform $T_1$ is a transform which can achieve complete de-correlation, the second transform $T_2$ is unable to de-correlate the first transformed output signal any more, with the result that all the diagonal elements become 1 (that is, 255 in the case of 8-bit accurate coefficients) and all the non-diagonal elements become 0.

However, as described above, the first transform coefficient deriving unit 202 derives the first transform matrix $A_1^n$ optimized on average to the plurality of transform target input signals $x^n$ included in the set $S_A$, which means that the matrix is not optimized to each transform target input signal $x^n$. Thus, the first transform unit 200 is unable to achieve complete de-correlation, with the result that the first transformed output signal $y_1^n$ and the first partial signal $I_{1L}^m$ that is a part of the first transformed output signal $y_1^n$ are not completely de-correlated. Consequently, in the second transform matrix $A_2^m$ derived by the second transform coefficient deriving unit 222, the diagonal elements do not necessarily become 1 and the non-diagonal elements do not necessarily become 0.

However, since the first partial signal $y_{1L}^m$ is de-correlated to some degrees by the first transform, the diagonal elements and the non-diagonal elements in the second transform matrix $A_2^m$ become values close to 1 and values close to 0, respectively.

Accordingly, the difference between the diagonal element a(i, i) and 1 becomes a value close to 0, which allows a reduction in the amount of information to be coded and thereby allows a further increase in the coding efficiency.

The predetermined value may be the diagonal element a(i-1, i-1) or a(i+1, i+1) adjacent to the diagonal element a(i, i) that is the current element to be coded. Specifically, the transform coefficient coding unit 131 may calculate a difference between the diagonal elements adjacent to each other in the diagonal direction and code the calculated difference.

The diagonal elements in a higher-frequency band are more susceptible to influences of special correlation and tend to be farther from 1. This means that the lower right diagonal elements tend to be farther from 1. Thus, calculating a difference between adjacent diagonal elements allows a reduction in the amount of information. For example, the transform coefficient coding unit 131 calculates, as indicated by Expression 6, a difference between the diagonal element a(i, i) and the diagonal element a(i-1, i-1) located diagonally left above the diagonal element a(i, i) and codes the calculated difference.

[Math. 6]

$$\text{(Expression 6)} \quad h(i, i) = a(i, i) - a(i - 1, i - 1)$$

In this expression, a(0,0) = 1.

The predetermined value may be a prediction value p(i, i) of the diagonal element a(i, i) that is the current element to be coded. Specifically, the transform coefficient coding unit 131 may calculate the prediction value p(i, i) of the diagonal element a(i, i) to calculate a difference between the diagonal element a(i, i) and the prediction value p(i, i).

FIG. 11B is a flowchart showing another example of the operation of the transform coefficient coding unit 131 in Embodiment 1 where the current element is a diagonal element.

First, when the current element is a diagonal element, the transform coefficient coding unit 131 calculates a prediction value of the current element (S201). Details are as follows.

As described above, the diagonal elements in a higher-frequency band tend to be farther from 1. Thus, the transform coefficient coding unit 131 calculates the prediction value p(i, i) using the linear function or the arithmetic series as indicated by Expression 7 or Expression 8, for example.

[Math. 7]

$$p(i,i) = a(i,i) * i(i,i) + c(i,i)$$

(Expression 7)

[Math. 8]

$$p(i,i) = p(i-1,i-1) + d$$

(Expression 8)

In Expression 7, i(i, i) represents a given coefficient determined for each diagonal element a(i, i), and c(i, i) represents a given offset value determined for each diagonal element a(i, i). Here, i(i, i) and c(i, i) may be predetermined fixed values. In Expression 8, d represents a predetermined fixed value and is, for example, a negative value.

The transform coefficient coding unit 131 then calculates, as indicated by Expression 9, a difference between the calculated prediction value p(i, i) and the diagonal element a(i, i) that is a current element to be coded (S202).

[Math. 9]

$$h(i,i) = a(i,i) - p(i,i)$$

(Expression 9)

At the end, the entropy coding unit 132 entropy codes the calculated difference (S210).

In the above-described manner, the transform coefficient coding unit 131 and the entropy coding unit 132 compression code the diagonal elements. It is to be noted that the processing shown in FIG. 11B is an example of the coding process (S132) using a difference from a predetermined reference shown in FIG. 9.

It is to be noted that, in Embodiment 1, the transform coefficient coding unit 131 does not code signs of the diagonal elements. Specifically, the transform coefficient coding unit 131 does not describe the signs of the diagonal elements in a header and thus does not transmit the signs to a decoding apparatus. More specifically, the signs of the diagonal elements are defined as being plus. This allows a further reduction in the amount of information.

With this, in deriving the second transform coefficients, the second transform coefficient deriving unit 222 is capable of setting a diagonal element having a negative value to have a positive value by multiplying, by -1, all the elements in the line including the diagonal element.

As above, the coding apparatus 100 according to Embodiment 1 is **characterized in that**, when the current element is a diagonal element in coding the transform coefficients derived by the KLT, a difference between the diagonal element and a predetermined value is calculated, and the calculated difference is coded. At this time, the predetermined value may be a predetermined fixed value (for example, 1) or a prediction value generated by predicting the diagonal element. Furthermore, owing to such deriving that the diagonal elements are always positive, the transform coefficient coding unit 131 does not transmit the signs of the diagonal elements. The above structure allows a reduction in the amount of information and allows an increase in the coding efficiency.

It is also possible that, when the current element is a diagonal element, the transform coefficient coding unit 131 performs both the processing in FIG. 11A and the processing in FIG. 11B and uses a result of higher coding efficiency. Alternatively, only predetermined one of the processing may be performed.

Subsequently, the case where the current element is a non-diagonal element is described.

When the current element is a non-diagonal element, the transform coefficient coding unit 131 codes an element obtained by removing redundancy between the current element and its symmetrical element that is an element at a position symmetrical to the current element about a diagonal element. Assuming that the current element is indicated by a(i, j), its symmetrical element is indicated by a(j, i). FIG. 12 shows an example of the current elements which are non-diagonal elements, and symmetrical elements thereof.

The transform coefficient coding unit 131 uses characteristic relationship between the current element and its symmetrical element to remove redundancy between the current element and the symmetrical element. The transform coefficients derived by the KLT have, as the characteristic relationship, relationship that the current element and its symmetrical element have substantially the same absolute value, for example.

Thus, the transform coefficient coding unit 131 calculates an average value of the absolute value of the current element and the absolute value of the symmetrical element (which average value will be hereinafter referred to as an absolute average value) and codes a difference between the calculated average value and the absolute value of the current element, for example.

FIG. 13 is a flowchart showing an example of the operation of the transform coefficient coding unit 131 in Embodiment 1 in the case where the current element is a non-diagonal element.

First, the transform coefficient coding unit 131 calculates an absolute average value ha_tpair(i, j) of the current element and the symmetrical element according to Expression 10 (S300).

[Math. 10]

$$\text{ha\_tpair}(i, j) = \left(\left|a(i, j)\right| + \left|a(j, i)\right|\right)/2$$

(Expression 10)

For the absolute average value ha_tpair(i, j), one value is determined for each pair of the current element and its symmetrical element (which pair is referred to as a diagonal pair). Specifically, because of ha_tpair(i, j) = ha_tpair(j, i), the absolute average value ha_tpair(i, j) can be calculated using only one of the top-triangle element and the bottom-triangle element as the current element.

The transform coefficient coding unit 131 then calculates a difference ha(i, j) between the absolute value of the current element and the absolute average value according to Expression 11 or 12 (S310). Here, Expression 11 is an equation where the current element is a top-triangle element (i<j), and Expression 12 is an equation where the current element is a bottom-triangle element (i>j).

[Math. 11]

$$\text{ha}(i, j) = \left|a(i, j)\right| - \text{ha\_tpair}(i, j)$$

(Expression 11)

[Math. 12]

$$\text{ha}(i, j) = \left|a(i, j)\right| - \text{ha\_tpair}(j, i)$$

(Expression 12)

The entropy coding unit 132 then compresses information by entropy coding the header description (difference ha(i, j)) (S320).

Furthermore, the transform coefficient coding unit 131 codes the sign (information indicating positivity and negativity) of the current element a(i, j) or the header description ha(i, j) (S330). It is to be noted that the transform coefficients derived by the KLT have characteristic relationship also in the signs (the plus and minus signs) of the non-diagonal elements. Thus, the use of this characteristic relationship allows the signs to be coded with higher coding efficiency.

In the above-described manner, the coding apparatus 100 according to Embodiment 1 is characterized by, in coding the transform coefficients derived by the KLT, coding the component obtained by removing redundancy between the current element and its symmetrical element when the current element is a non-diagonal element. For example, the use of the relationship that the current element and its symmetrical element often have substantially the same absolute value allows a reduction in the amount of information and allows an increase in the coding efficiency.

FIG. 14A shows an example of the transform coefficients a(i, j). FIG. 14B shows an example of the absolute average values ha_tpair(i, j) calculated from the transform coefficients shown in FIG. 14A. FIG. 14C shows an example of the header descriptions ha(i, j) calculated from the transform coefficients shown in FIG. 14A.

In the example shown in FIG. 14B, the absolute average value is assumed to be a natural number by raising the number to the closest whole number, but the number may be truncated or rounded off to the closest whole number, or the absolute average value may be not an integer.

When the current element is a non-diagonal element, the absolute average value is calculated and a difference between the calculated absolute average value and the non-diagonal element is coded, but the present invention is not limited to this example. For example, (i) a sum of the current element and its symmetrical element and (ii) one of the top-triangle element and the bottom-triangle element may be coded. In this case, the sum of the current element and its symmetrical element becomes a value close to 0, with the result that the amount of information to be transmitted can be reduced.

The following describes coding of signs of non-diagonal elements for higher compression.

The transform coefficients derived by the KLT have, as the characteristic relationship, the relationship that the current element and its symmetrical element often have reverse signs. Furthermore, the transform coefficients derived by the KLT have also the relationship that the top-triangle elements often have plus signs while the bottom-triangle elements often have minus signs. Specifically, the top-triangle elements and the bottom-triangle elements have the relationship as shown in FIG. 15. FIG. 15 shows the relationship of signs between the top-triangle elements and the bottom-triangle elements in Embodiment 1.

It is to be noted that the above-described relationship of signs is not only valid for a(i, j) that is a value of the non-diagonal element itself, but also often valid for the header description ha(i, j) calculated according to Expression 11 or 12 stated above.

Accordingly, the transform coefficient coding unit 131 codes the signs of the non-diagonal elements according to syntax shown in FIG. 16. FIG. 16 schematically illustrates an example of syntax in transmitting the signs of the non-diagonal elements in Embodiment 1.

First, the transform coefficient coding unit 131 codes information indicating whether the sign to be coded is a sign of a(i, j) that is a value of the non-diagonal element itself or a sign of the header description ha(i, j). Furthermore, the transform coefficient coding unit 131 codes the sign of the non-diagonal element according to one of modes 1 to 4 shown in FIG. 16.

For example, in mode 1, the transform coefficient coding unit 131 transmits the signs of all the non-diagonal elements without additional processing. Specifically, the transform coefficient coding unit 131 assigns, for each position of the non-diagonal element, bits to coding information indicating whether the non-diagonal element is positive or negative.

In mode 2, the transform coefficient coding unit 131 codes, for each position of the non-diagonal element (only the top-triangle element), sign reverse information indicating whether or not the sign of the symmetrical element is reverse of the sign of the current element. The sign reverse information is information indicating whether or not the current element and the symmetrical element have different signs.

Furthermore, the transform coefficient coding unit 131 codes sign information indicating positivity and negativity of the top-triangle elements. This means that it is sufficient that the transform coefficient coding unit 131 assigns, for each position of the non-diagonal element, bits to the sign reverse information and the sign information. In the case where the current element is a bottom-triangle element, it is sufficient that the sign reverse information and the sign information are coded for each position of the bottom-triangle element.

In mode 3, the transform coefficient coding unit 131 codes all-sign reverse information indicating that the current element and the symmetrical element have reverse signs at all the positions of the non-diagonal elements, and may further code, for each position of the top-triangle element, the sign information indicating positivity and negativity of the top-triangle element. This means that it is sufficient that that the transform coefficient coding unit 131 assigns bits to the all-sign reverse information and the sign information.

Since the top-triangle element and the bottom-triangle element often have reverse signs as mentioned above, the amount of information can be reduced by assigning bits to the all-sign reverse information indicating that the signs at all the positions are reverse.

In mode 4, the transform coefficient coding unit 131 may code top-triangle element sign information indicating that all the signs of the top-triangle elements are plus or range information indicating that the top-triangle elements in a top-left partial matrix of nxn have plus signs. At this time, assuming that the bottom-triangle elements have minus signs, for example, the transform coefficient coding unit 131 does not transmit the sign information for each position of the non-diagonal element.

The transform coefficient coding unit 131 may code bottom-triangle element sign information indicating that all the signs of the bottom-triangle elements are minus.

As above, the transform coefficient coding unit 131 codes the sign of the non-diagonal element according to one of a plurality of modes including modes 1 to 4.

It is to be noted that the transform coefficient coding unit 131 may select a mode according to received transform coefficients. For example, when the top-triangle element and the bottom-triangle element have reverse signs in the received transform coefficients, the transform coefficient coding unit 131 selects mode 3, which allows further compression of the information. Alternatively, when all the signs of the top-triangle elements of the received transform coefficients are plus, the transform coefficient coding unit 131 selects mode 4, which allows further compression of the information.

As above, the coding apparatus 100 according to Embodiment 1 calculates a difference between the predetermined value and each element included in the transform coefficients for use in the transform processing and codes the calculated difference, thereby compression coding the transform coefficients. At this time, a difference between values which are different between the diagonal element and the non-diagonal element is calculated. This is because the transform coefficients are coefficients determined based on the statistical properties of the transform target signal and as described above, the diagonal element and the non-diagonal element have different properties.

Using these properties, the coding apparatus 100 according to Embodiment 1 is capable of compression coding the transform coefficients and transmitting them to a decoding apparatus or the like. Consequently, the increase in the amount of data can be suppressed and the coding efficiency can be increased.

While Embodiment 1 describes a structure in which the transform unit 110 outputs, to the transform coefficient coding unit 131, the transform coefficients used in the transform, and the transform coefficient coding unit 131 codes the transform coefficients, it is also possible that the transform coefficients are quantized as in a coding apparatus 300a shown in FIG. 17A.

The coding apparatus 300a is different from the coding apparatus 100 shown in FIG. 3 in that a coding unit 330a is provided instead of the coding unit 130. The coding unit 330a includes a transform coefficient coding unit 331a and an entropy coding unit 132. The following mainly describes differences from the structure shown in FIG. 3, by omitting descriptions of the same structure.

The transform coefficient coding unit 331a includes a transform coefficient difference coding unit 333 and a transform coefficient quantization unit 335, and codes and quantizes the transform coefficients used in the transform unit 110.

The transform coefficient difference coding unit 333 corresponds to the above-described transform coefficient coding unit 131 and when the current element is a diagonal element, the transform coefficient difference coding unit 333 calculates a difference from a predetermined reference and codes the calculated difference. When the current element is a non-diagonal element, the transform coefficient difference coding unit 333 codes the non-diagonal element using redundancy between the non-diagonal element and its symmetrical element. The coded transform coefficients resulting from the coding are output to the transform coefficient quantization unit 335.

The transform coefficient quantization unit 335 quantizes the received coded transform coefficients. At this time, in consideration of energy, the transform coefficient quantization unit 335 weights each of the elements included in the transform coefficients, according to the position of the element. For example, the weighting is performed so that a component having large energy, that is, a low-frequency component, has a small quantization step.

For example, the transform coefficient quantization unit 335 quantizes the coded transform coefficients by dividing the elements ha(i, j) included in the coded transform coefficients, by a transform coefficient quantization step TWL(i, j) (TransWeightLevel), as indicated by Expression 13.

[Math. 13]

$$\mathrm{ha'}(i, j) = \mathrm{ha}(i, j)/\mathrm{TWL}(i, j)$$

(Expression 13)

The transform coefficients quantized as above (hereinafter referred to as quantized transform coefficients) are output to the entropy coding unit 132 and entropy coded as described above.

The transform coefficient quantization step $TWL(i, j)$ is, for example, stored in an internal memory or the like by the transform coefficient quantization unit 335. FIG. 18A shows an example of a transform coefficient quantization step table. The transform coefficient quantization step table is a table which indicates the transform coefficient quantization step $TWL(i, j)$ for each index.

Furthermore, the transform coefficient quantization unit 335 holds an index table in TWL array, which is referred to for each element $ha(i, j)$. FIG. 18B shows an example of the index table in TWL array. Here, the transform coefficient quantization step $TWL(i, j)$ is defined for each row of the elements. Specifically, the elements located in the same row have the same index and therefore have the same transform coefficient quantization step $TWL(i, j)$. Here, $TWL(i, j) = TWL(i)$ is satisfied, and the transform coefficient quantization step is determined based on the row of the element to be quantized.

The transform coefficient quantization unit 335 refers to the index table for each position of the element $ha(i, j)$ to obtain the index at the position. The transform coefficient quantization unit 335 then refers to the transform coefficient quantization step table to obtain the transform coefficient quantization step $TWL(i, j)$ corresponding to the obtained index.

For example, in the example shown in FIG. 18A and FIG. 18B, the index is 1 and the $TWL(1,j)$ is also 1 for the element $ha(1,j)$ in the first row. For the element $ha(3,j)$ in the third column, the index is 3 and $TWL(3,j)$ is 2.

In the case where the elements included in the input signal are arranged in order from a low-frequency band to a high-frequency band or in order from low energy to high energy, an element in a upper row, that is, an element in a lower region, is more important in the transform coefficients. Accordingly, more bits should be assigned to an element in an upper row, which means that it is preferable to use $TWL(i, j)$ having a small value.

It is to be noted that the entropy coding unit 132 codes the quantized transform coefficients and also the quantization step table shown in FIG. 18A and the index table shown in FIG. 18B. However, the entropy coding unit 132 is not required to code them when the coding apparatuses 300a and 300b and a decoding apparatus use fixed values as the index table and the quantization step table.

Alternatively, the index table in TWL array shown in FIG. 18C may be used. The index table shown in FIG. 18C shows that an element having a smaller row number i and a smaller column number j, that is, an element at the upper left, has a smaller index. Since an element in a lower-frequency band is more important as mentioned above, it is preferable to assign more bits to an element having not only a small row number i but also a small column number j. Thus, in the index table shown in FIG. 18C, the indices are arranged so that $TWL(i, j)$ for an element having a small row number i and a small column number j has a small value.

While the above describes a structure in which the header description $ha(i, j)$ is quantized and then entropy coded, the transform coefficient $a(i, j)$ itself, which is yet to be coded by the transform coefficient difference coding unit 333, may be quantized. Furthermore, the absolute average value $ha\_tpair(i, j)$ may be coded. In this case, for example, the transform coefficient difference coding unit 333 may code quantized transform coefficient $a'(i, j)$ in the above-described manner.

As in the coding apparatus 300b shown in FIG. 17B, an entropy coding unit dedicated to entropy coding of the transform coefficients may be provided.

The coding apparatus 300b is different from the coding apparatus 300a shown in FIG. 17A in that a coding unit 330b is provided instead of the coding unit 330a and furthermore, a multiplexing unit 340 is newly provided. The coding unit 330b includes a transform coefficient coding unit 331b and an entropy coding unit 132. The transform coefficient coding unit 331b includes a transform coefficient difference coding unit 333, the transform coefficient quantization unit 335, and a transform coefficient entropy coding unit 337. The following mainly describes differences from the structure of the coding apparatus 300a shown in FIG. 17A, by omitting descriptions of the same structure.

The transform coefficient entropy coding unit 337 entropy codes the coded transform coefficients quantized by the transform coefficient quantization unit 335.

The multiplexing unit 340 generates the coded signal by multiplexing the quantized coefficients entropy coded by the entropy coding unit 132 and the transform coefficients entropy coded by the transform coefficient entropy coding unit 337. For example, the multiplexing unit 340 describes, as header information of coded image or audio data, the entropy coded transform coefficients into the coded signal.

As above, the coding apparatus according to Embodiment 1 may include separate entropy coding units for quantized coefficients and for transform coefficients as in the case of the coding apparatus 300b shown in FIG. 17B.

The coding method according to an implementation of the present invention may be applied to prediction coding. FIG. 19 is a block diagram showing an example of a structure of a coding apparatus 400 according to Variation of Embodiment 1. To the coding apparatus 400, the current signal of audio data, video data, or the like is input.

The coding apparatus 400 shown in FIG. 19 includes a transform unit 410, the quantization unit 120, the coding unit 130, an inverse quantization unit 440, an inverse transform unit 450, an adder 460, a memory 470, a prediction unit 480, and a subtractor 490. Processing units which perform the same operation as those in the coding apparatus 100 shown in FIG. 3 are denoted with the same reference numerals and are not described below.

To the transform unit 410, a prediction error signal that is a difference between a current signal to be coded and a prediction signal is input as a transform target input signal. The transform unit 410 performs, on the prediction error signal, the same processing as the above transform unit 110. In other words, the transform unit 410 is different from the transform unit 110 only in that not the current signal to be coded but the prediction error signal is input, and is the same in detailed structure as the transform unit 110 shown in FIG. 4, for example.

The quantization unit 120 and the coding unit 130 operate as described above and therefore are not described here.

The inverse quantization unit 440 generates a decoded transformed output signal by inverse quantizing the quantized coefficients provided from the quantization unit 120. The decoded transformed output signal generated as above is output to the inverse transform unit 450. It is to be noted that although the decoded transformed output signal is a signal generated by reconstructing the transformed output signal generated by the transform unit 410, the decoded transformed output signal is not completely the same as the transformed output signal because of lossy processing performed thereon by the quantization unit 120. Specifically, the decoded transformed output signal includes a quantization error.

The inverse transform unit 450 performs inverse transform processing on the decoded transformed output signal to generate a decoded transformed input signal. The inverse transform processing is processing opposite to the transform processing which the transform unit 410 performs.

For example, assume that the transform unit 410 performs a transform T on the transform target input signal $x^n$ using a transform matrix A that is an N x N square matrix. At this time, the transformed output signal $y^n$ which the transform unit 410 outputs is represented by Expression 1. More specifically, the transform unit 410 generates the transformed output signal $y^n$ according to Expressions 2 and 3.

At this time, the inverse transform $T^{-1}$ which the inverse transform unit 450 performs is transform processing which uses, as the transform coefficients, an inverse matrix $A^{-1}$ that is opposite to the transform matrix A. The inverse transform $T^{-1}$ that is performed on the decoded transformed output signal $\hat{y}^n$ input to the inverse transform unit 450 is represented by Expression 14.

[Math. 14]

$$T^{-1}[\hat{y}''] = A^{-1}\hat{y}''$$

(Expression 14)

Accordingly, the decoded transformed input signal $x^{\wedge n}$ which the inverse transform unit 450 outputs is represented by Expression 15.

[Math. 15]

$$\hat{x}'' = T^{-1}[\hat{y}'']$$

(Expression 15)

The adder 460 generates a decoded signal by adding the decoded transformed input signal and the prediction signal. The decoded signal generated as above is stored in the memory 470 and is referred to in generating the prediction signal for the following input signal to be coded.

The memory 470 is an example of a storage unit, such as a memory in which the decoded signal is stored.

The prediction unit 480 generates the prediction signal by predicting the current signal with reference to the decoded signal (the already coded signal) which has been coded and decoded before and is stored in the memory 470. The prediction signal generated as above is output to the subtractor 490 and the adder 460. It is to be noted that control information used to generate the prediction signal, such as a prediction mode (such as intra prediction or inter prediction), is output to the coding unit 130 and coded by the coding unit 130.

The subtractor 490 generates a prediction error signal by calculating a difference between a current signal to be coded and a prediction signal generated by the prediction unit 480; that is, calculating a prediction error. The prediction error signal generated as above is input to the transform unit 410 as a transform target input signal.

Subsequently, operation of the above coding apparatus 400 is described with reference to FIG. 20.

FIG. 20 is a flowchart showing an example of operation of the coding apparatus 400 according to Variation of Embodiment 1.

First, the current signal of audio data, video data, or the like is input to the coding apparatus 400. The prediction unit 480 generates the prediction signal with reference to the coded signal stored in the memory 470 (S400). The prediction signal generated as above is output to the subtractor 490. The subtactor 490 then generates the prediction error signal by calculating the prediction error that is the difference between the current signal and the prediction signal (S405).

Next, the transform unit 410 performs transform processing on the prediction error signal (S110). For example, according to the flowchart shown in FIG. 8, the prediction error signal is transformed to generate the transformed output signal. Next, the quantization unit 120 generates the quantized coefficients by quantizing the transformed output signal (S120).

Next, the coding unit 130 generates the coded signal by compression coding the quantized coefficients and the transform coefficients used in the transform processing (S130). Furthermore, the inverse quantization unit 440 generates the decoded transformed output signal by inverse quantizing the quantized coefficients (S440). It is to be noted that the compression coding which the coding unit 130 performs and the inverse quantization which the inverse quantization unit 440 performs may be performed in any order or may be performed in parallel.

Next, the inverse transform unit 450 generates the decoded transformed input signal by performing the inverse transform processing on the decoded transformed output signal (S450). The inverse transform processing is processing opposite to the transform processing which the transform unit 410 performs. At the end, the adder 460 generates the decoded signal by adding the decoded transformed input signal and the prediction signal and stores the decoded signal onto the memory 470 (S460).

As above, the coding apparatus 400 may perform the above transforming process on, as the transform target signal, the prediction error signal that is the difference between the current signal and the prediction signal generated by predicting the current signal. This allows a reduction in the amount of information to be coded, with the result that the coding efficiency can be further increased.

In Embodiment 1, the transform target signal is a signal based on the input signal and is, for example, the input signal, i.e., the current signal itself, or a signal generated by performing some processing on the input signal. For example, the transform target signal is a signal, such as the prediction error signal and the first partial signal, on which the transform processing is performed.

The first transform unit 200 may perform an ordinary DCT as the first transform $T_1$. Even in this case, the correlation of the first transformed output signal $y_1^n$ can be reduced. Thus, the elements included in the second transform matrix $A_2^m$ have the above-described properties (for example, that the diagonal elements are close to 1) and the like.

It may be possible that the second transform unit 220 adaptively determines the transform coefficients based on the statistical properties of the input signal and performs, using the determined transform coefficients, not the KLT but other transform that reduces the correlation, as the second transform $T_2$.

Although the coding apparatus 100 according to Embodiment 1 synthesizes the second partial signal and the second transformed output signal before quantizing them, it may quantize and compression code the second partial signal and the second transformed output signal without synthesizing them.

Furthermore, even in the case where only one-stage transform is performed, the above coding method according to Embodiment 1 can apply. For example, in the coding method according to the present invention, it may be possible that a difference between a default transform coefficient Dij (for example, a transform coefficient to be used in the DCT) and a coefficient Wij actually used in the transform is calculated and the calculated difference is coded. This enables more efficient coding of the transform coefficients. This is because transform coefficients close to those obtained in the DCT are determined when, as the one-stage transform, the KLT is performed on the transform target input signal in the spatial-temporal domain.

While the above Embodiment 1 describes an example of compression coding the transform coefficients which are used in a transform (specifically, the second transform) to be performed at the time of coding, the coding apparatus may compression code the inverse transform coefficients which are used in an inverse transform of the transform processing. Specifically, the coding apparatus 100 according to Embodiment 1 may compression code the second inverse transform coefficients which are used in the inverse transform of the second transform. The second transform coefficients and the second inverse transform coefficients have the relationship of transpose, for example.

(Embodiment 2)

A decoding apparatus according to Embodiment 2 is a decoding apparatus which generates a decoded signal by decoding a coded signal, and the coded signal includes coded quantized coefficients resulting from compression coding and a difference between a predetermined value and each element included in transform coefficients used in transform processing performed in generating the coded signal. The decoding apparatus according to Embodiment 2 includes: a decoding unit which decodes the coded signal to generate decoded quantized coefficients and inverse transform coefficients; an inverse quantization unit which inverse quantizes the decoded quantized coefficients to generate a decoded transformed output signal; and an inverse transform unit which performs, using the inverse transform coefficients, inverse transform processing that is processing opposite to the transform processing performed on the coding side, to generate the decoded signal from the decoded transformed output signal. The decoding unit is characterized by decoding the coded signal to obtain differences and adding the obtained difference and predetermined values to generate the inverse transform coefficients. First, an example of a structure of the decoding apparatus according to Embodiment 2 is described below with reference to FIG. 21.

FIG. 21 is a block diagram showing an example of a structure of a decoding apparatus 500 according to Embodiment 2. To the decoding apparatus 500, the coded signal is input that is generated by coding various data, such as audio data, still image data, and video data. As shown in FIG. 21, the decoding apparatus 500 includes a decoding unit 510, an inverse quantization unit 520, and an inverse transform unit 530, and decodes the received coded signal to generate the decoded signal.

It is to be noted that the coded signal which is input to the decoding apparatus 500 is a signal generated by transforming and quantizing the input signal indicating various data input to the coding apparatus. More specifically, the coded signal includes the coded quantized coefficients that have been compression coded and the difference between the predetermined value and each element included in the transform coefficients used in the transform processing performed in generating the coded signal. For example, the coded signal is the signal generated by the coding apparatus 100 according to Embodiment 1.

The decoding unit 510 includes an entropy decoding unit 511 and a transform coefficient decoding unit 512 and decodes the coded signal to generate decoded quantized coefficients and inverse transform coefficients.

In this embodiment, it may also be possible that the decoding unit 510 does not generate the inverse transform coefficients and instead, the inverse transform unit 530 generates the inverse transform coefficients.

Furthermore, it may also be possible that the coding apparatus generates the inverse transform coefficients and based on Embodiment 1 described above, the coding apparatus codes the generated inverse transform coefficients and transmits them to the decoding apparatus 500. In a general orthogonal transform, an inverse transform matrix and a transform matrix have relationship of transpose. When the transform coefficient coding unit 131 compression codes the transform coefficients and transmits them to the decoding apparatus 500, the transform coefficients are transposed in the transform coefficient decoding unit 512, resulting in the inverse transform coefficients. When the transform coefficient coding unit 131 compression codes the inverse transform coefficients and transmits them to the decoding apparatus 500 based on Embodiment 1 described above, the transposing in the transform coefficient decoding unit 512 is not necessary.

There is a case where the inverse transform coefficients and the transform coefficients are not set to match each other in order to reduce the amount of computation for the inverse transform in the decoding apparatus 500, and in this case, the transform coefficient coding unit 131 compression codes the inverse transform coefficients and transmits them to the decoding apparatus 500 based on Embodiment 1 described above. Also in the case of using a transform called biorthgonal transform that is not exactly orthogonal and using an inverse transform thereof, the inverse transform coefficients are transmitted to the decoding apparatus 500.

The entropy decoding unit 511 generates decoded quantized coefficients and decoded transform coefficients by entropy decoding the coded signal. The decoded quantized coefficients are output to the inverse quantization unit 520, and the decoded transform coefficients are output to the transform coefficient decoding unit 512. The decoded transform coefficients are coded transform coefficients which have been reconstructed, and correspond to differences between predetermined values and the elements included the transform coefficients used in the transform processing performed in generating the coded signal. Furthermore, the decoded transform coefficients include also information necessary for reconstructing the transform coefficients, such as sign information of the non-diagonal elements.

The transform coefficient decoding unit 512 decodes the decoded transform coefficients to reconstruct the transform coefficients and generates the inverse transform coefficients. Specific processing of generating the inverse transform coefficients will be described below.

The transform coefficients are coefficients adaptively determined on the coding apparatus side according to the transform target signal. Specifically, the transform coefficients are coefficients determined based on the statistical properties of a set including the transform target signal that is a signal which is to be a target for the transform processing, as described in Embodiment 1, and, for example, are coefficients determined by the KLT.

The inverse quantization unit 520 generates a decoded transformed output signal by inverse quantizing the decoded quantized coefficients provided from the entropy decoding unit 511. Specifically, the inverse quantization unit 520 performs processing opposite to the processing in the quantization unit 120 described in Embodiment 1. The decoded transformed output signal generated as above is output to the inverse transform unit 530.

The inverse transform unit 530 generates the decoded signal by inverse transforming the decoded transformed output signal using the inverse transform coefficients provided from the transform coefficient decoding unit 512. Specifically, the inverse quantization unit 530 performs processing opposite to the processing in the transform unit 110 described in Embodiment 1.

As indicated by the above structure, the decoding unit 510 obtains the decoded quantized coefficients and the transform coefficients by entropy decoding the coded signal. The inverse transform unit 530 then inverse transforms the decoded transformed output signal using the transform coefficients obtained by the decoding unit 510.

With this, the decoding apparatus 500 according to Embodiment 2 generates the inverse transform coefficients using the transform coefficients included in the coded signal and performs the inverse transform using the generated inverse transform coefficients or performs the inverse transform using the inverse transform coefficients included in the coded signal, and therefore is capable of decoding the coded signal generated through the transform using the transform coefficients adaptively determined as in the case of the coding apparatus 100 according to Embodiment 1, for example.

Subsequently, an example of a structure of an inverse transform unit 530 according to Embodiment 2 is described in more detail.

FIG. 22A is a block diagram showing an example of a structure of the decoding apparatus 530 included in the decoding apparatus 500 according to Embodiment 2. As shown in FIG. 22A, the inverse transform unit 530 includes a dividing unit 600, a second inverse transform unit 610, a synthesizing unit 620, and a first inverse transform unit 630, and performs, on the decoded transformed output signal $y^{\wedge n}$ inverse transform processing at two stages.

The dividing unit 600 divides the decoded transformed output signal $y^{\wedge n}$ into a second decoded transformed output signal $y^{\wedge}2^m$ and a second decoded partial signal $y^{\wedge}1H^{n-m}$ based on division and synthesis information. The second decoded transformed output signal $y^{\wedge}_2^m$ corresponds to the second transformed output signal $y_2^m$ generated by the second transform unit 220 according to Embodiment 1, and the second decoded partial signal $y^{\wedge}1H^{n-m}$ corresponds to the second partial signal $y_{1H}^{n-m}$ provided from the dividing unit 210.

The division and synthesis information is information indicating how to divide the decoded transformed output signal $y^{\wedge n}$, and specifically is information indicating how the coding apparatus has divided the transform target signal in the transform processing. The division and synthesis information may be included in the coded signal or may be stored in an internal memory or the like included in the decoding apparatus 500. Especially, when the elements that are a target for the second transform are fixed, storing the division and synthesis information onto the memory allows a reduction in the coding amount of the coded signal.

The second inverse transform unit 610 inverse transforms the second decoded transformed output signal $y^{\wedge}_2^m$ to generate a first decoded partial signal $y^{\wedge}_{1L}^m$. Specifically, the second inverse transform unit 610 performs, on the second decoded transformed output signal $y^{\wedge}2^m$, inverse transform processing (a second inverse transform $T_2^{-1}$) that is processing opposite to the transform processing (the second transform $T_2$) which the second transform unit 220 according to Embodiment 1 performs.

More specifically, the second inverse transform unit 610 performs the second inverse transform $T_2^{-1}$ on the second decoded transformed output signal using a second inverse transform matrix $A^{-1}_2$ generated by the entropy decoding unit 511 and the transform coefficient decoding unit 512. Alternatively, it may also be possible that the second inverse transform unit 610 calculates an inverse matrix of the second transform matrix $A_2$ and inverse transforms, using the calculated inverse matrix, i.e., the second inverse transform matrix $A^{-1}_2$, the second decoded transformed output signal $y^{\wedge}_2^m$ according to Expression 15.

The first decoded partial signal $y^{\wedge}_{1L}^m$ corresponds to the first partial signal $y_{1L}^m$ provided from the dividing unit 210 according to Embodiment 1. Here, the second inverse transform matrix $A^{-1}_2$ is, as described in Embodiment 1, coefficients determined based on the statistical properties of the set including the first partial signal $y_{1L}^m$ that is a signal which is to be a target for the transform processing and, for example, is coefficients determined by the KLT.

The synthesizing unit 620 generates a first decoded transformed output signal $y^{\wedge}_1^n$ by synthesizing, based on the division and synthesis information, the second decoded partial signal $y^{\wedge}_{1H}^{n-m}$ provided from the dividing unit 600 and the first decoded partial signal $y^{\wedge}_{1L}^m$ provided from the second inverse transform unit 610. The first decoded transformed output signal $y^{\wedge}_1^n$ corresponds to the first transformed output signal $y_1^n$ provided from the first transform unit 200 according to Embodiment 1.

The first inverse transform unit 630 generates a decoded signal $x^{\wedge n}$ by inverse transforming the first decoded transformed output signal $y^{\wedge}_1^n$. Specifically, the first inverse transform unit 630 performs, on the first decoded transformed output signal $y^{\wedge}_1^n$, inverse transform processing (a first inverse transform $T_1^{-1}$) that is processing opposite to the transform processing (the first transform $T_1$) which the first transform unit 200 according to Embodiment 1 performs.

More specifically, the first inverse transform unit 630 performs the first inverse transform $T_1^{-1}$ on the first

decoded transformed output signal $y^\wedge{}_1{}^n$ using a first inverse transform matrix $A^{-1}{}_1$ generated by the entropy decoding unit 511 and the transform coefficient decoding unit 512. Alternatively, it may also be possible that the first inverse transform unit 630 calculates an inverse matrix of the first transform matrix $A_1$, i.e., the first inverse transform matrix $A^{-1}{}_1$, and inverse transforms, using the calculated first inverse transform matrix $A^{-1}{}_1$, the first decoded transformed output signal $y^\wedge{}_1{}^n$ according to Expression 15.

Here, the first inverse transform matrix $A^{-1}{}_1$ is, as described in Embodiment 1, coefficients determined based on the statistical properties of the set including a transform target input signal $y_1{}^n$ that is a signal which is to be a target for the transform processing and, for example, is coefficients determined by the KLT. It is to be noted that the first inverse transform unit 630 may perform an inverse DCT, and in this case, the first inverse transform matrix $A^{-1}{}_1$ may be stored in an internal memory or the like included in the first inverse transform unit 630.

It is to be noted that the inverse transform unit 530 according to Embodiment 2 of the present invention is not required to include the dividing unit 600 and the synthesizing unit 620. Specifically, instead of explicitly dividing the decoded transformed output signal $y^\wedge{}^n$, it is sufficient that the inverse transform unit 530 determines elements which are to be a target for the second inverse transform $T_2{}^{-1}$, from among the elements included in the decoded transformed output signal $y^\wedge{}^n$, and performs the second inverse transform $T_2{}^{-1}$ only on the determined elements.

For example, the second inverse transform unit 610 receives the decoded transformed output signal $y^\wedge{}^n$ and performs, on the received decoded transformed output signal $y^\wedge{}^n$, the second transform $T_2{}^{-1}$ using the second inverse transform coefficients. At this time, the second inverse transform unit 610 sets 0 for the diagonal elements and 1 for the non-diagonal elements, in the second transform matrix which is multiplied by an element which is not to be a target for the second inverse transform $T_2{}^{-1}$ (that is, an element included in the second decoded partial signal) among the elements included in the decoded transformed output signal $y^\wedge{}^n$. This allows the second inverse transform unit 610 to perform the second inverse transform $T_2{}^{-1}$ only on the element which is to be a target for the second inverse transform $T_2{}^{-1}$ among the elements included in the decoded transformed output signal $y^\wedge{}^n$. FIG. 22B shows a specific example of a matrix operation.

A result obtained by multiplying three points $(X_1, X_2, X_3)$ of four vectors $X_n$ by a 3x3 matrix $A^3{}_{ij}$ as in (a) of FIG. 22B matches three points in a result obtained by multiplying, by four points X, an expanded matrix $A^4{}_j$ resulting from expansion of $A^3{}_{ij}$ to a 4x4 matrix with the diagonal elements set at 1 and the non-diagonal elements set at 0 as in (b) of FIG. 22B.

At this time, it may be possible that the second inverse transform unit 610 obtains selection range information for determining an element which is to be a target for the second inverse transform $T_2{}^{-1}$, and based on the obtained selection range information, the second inverse transform unit 610 determines an element which is to be a target for the second inverse transform $T_2{}^{-1}$. The selection range information is, for example, obtained from a coding apparatus or an internal memory.

Subsequently, a flow of data in the inverse transform unit 530 is described by giving an example of the decoded transformed output signal $y^\wedge{}^n$ as shown in FIG. 23. FIG. 23 conceptually shows an example of a data flow in the inverse transform unit 530 according to Embodiment 2.

As shown in FIG. 23, the decoded transformed output signal $y^\wedge{}^n$ composed of 16 elements (i.e., whose number of input elements is 16) is input to the inverse transform unit 530.

First, the dividing unit 600 divides the decoded transformed output signal $y^\wedge{}^n$ into a second decoded transformed output signal $y^\wedge{}_2{}^m$ including a low-frequency band and the second decoded partial signal $y^\wedge{}_{1H}{}^{n-m}$ including a high-frequency band. Specifically, using the division and synthesis information, the dividing unit 600 divides the decoded transformed output signal $y^\wedge{}^n$ so that correlation energy of the second decoded transformed output signal $y^\wedge{}_2{}^m$ is larger than correlation energy of the second decoded partial signal $y^\wedge{}_{1H}{}^{n-m}$

Furthermore, the dividing unit 600 rearranges the second decoded transformed output signal $y^\wedge{}_2{}^m$ from two dimensions to one dimension and outputs the rearranged second decoded transformed output signal $y^\wedge{}_2{}^m$ to the second inverse transform unit 610. At this time, the dividing unit 600 preferably rearranges the second decoded transformed output signal $y^\wedge{}_2{}^m$ so that the respective elements become arranged from a low-frequency band to a high-frequency band. For example, in the example shown in FIG. 23, the second decoded transformed output signal $y^\wedge{}_2{}^m$ is composed of 6 elements (whose number of input elements is 6), and the second decoded partial signal $y^\wedge{}_{1H}{}^{n-m}$ is composed of 10 elements (whose number of input elements is 10).

Next, the second inverse transform unit 610 generates the first decoded partial signal $y^\wedge{}_{1L}{}^m$ by performing the second inverse transform $T_2{}^{-1}$ on the second decoded transformed output signal $y^\wedge{}_2{}^m$ using the second inverse transform matrix $A^{-1}{}_2$ generated by the entropy decoding unit 511 and the transform coefficient decoding unit 512. Specifically, the second inverse transform unit 610 calculates the inverse matrix (the second inverse transform matrix) of the second transform matrix $A_2$ used in the transform processing performed by the coding apparatus and inverse transforms the second decoded transformed output signal $y^\wedge{}_{1L}{}^m$ using the calculated second inverse transform matrix $A^{-1}{}_2$.

Next, the synthesizing unit 620 rearranges the first decoded partial signal $y^\wedge{}_{1L}{}^m$ so that they are in a dimension (which is two dimensions in this case) in which they had been before being rearranged so as to be in one dimension by the dividing unit 600. The synthesizing unit 620 then generates the first decoded transformed output signal $y^{\wedge}_1{}^n$ by synthesizing the first decoded partial signal $y^{\wedge}_{1L}{}^m$ and the second decoded partial signal $y^{\wedge}_{1H}{}^{n-m}$.

At the end, the first inverse transform unit 630 generates a decoded signal $x^{\wedge n}$ by inverse transforming the first decoded transformed output signal $y^{\wedge}_1{}^n$. Specifically, the first inverse transform unit 630 calculates the inverse matrix (the first inverse transform matrix) of the first transform matrix $A_1$ used in the transform processing performed by the coding apparatus and inverse transforms the first decoded transformed output signal $y^{\wedge}_1{}^n$ using the calculated first inverse transform matrix $A^{-1}_1$.

In the above-described manner, the inverse transform unit 530 transforms the received decoded transformed output signal at two stages in the decoding apparatus 500 according to Embodiment 2. With this, the coded signal generated through the two-stage transform processing can be decoded.

Subsequently, a decoding method which the decoding apparatus 500 according to Embodiment 2 performs is described.

FIG. 24 is a flowchart showing an example of the operation of the decoding apparatus 500 according to Embodiment 2.

First, a coded signal generated by coding audio data, video data, or the like is input to the decoding apparatus 500. The entropy decoding unit 511 generates the decoded quantized coefficients and the transform coefficients by decoding the received coded signal (S510). Specifically, first, the entropy decoding unit 511 generates the decoded quantized coefficients and the decoded transform coefficients by decoding the coded signal. The transform coefficient decoding unit 512 then decodes the decoded transform coefficients to reconstruct the transform coefficients and furthermore, generates the inverse transform coefficients. Alternatively, in the case where the inverse transform coefficients have been coded, the transform coefficient decoding unit 512 decodes the decoded transform coefficients to generate the inverse transform coefficients.

Next, the inverse quantization unit 520 generates the decoded transformed output signal by inverse quantizing the decoded quantized coefficients obtained as above (S520).

At the end, the inverse transform unit 530 generates the decoded signal by inverse transforming the decoded transformed output signal from the frequency domain into the spatial-temporal domain using the inverse transform coefficients generated by the transform coefficient decoding unit 512 (S530).

In the above-described manner, the decoding apparatus 500 according to Embodiment 2 generates the decoded signal by inverse transforming the transform coefficients included in the coded signal. With this, even in the case where the coding apparatus adaptively determines the transform coefficients and the determined transform coefficients are included, the decoding apparatus 500 according to Embodiment 2 is capable of decoding the coded signal.

Subsequently, the inverse transform processing (S530) which the decoding apparatus 500 according to Embodiment 2 performs and especially the decoding of the transform coefficients in the decoding process (S510) are described in detail. First, the inverse transform processing (S530) is described.

FIG. 25 is a flowchart showing an example of the operation of the inverse transform unit 530 according to Embodiment 2.

First, the dividing unit 600 obtains the division and synthesis information (S531). For example, in the case where the division and synthesis information is included in the coded signal, the dividing unit 600 obtains the division and synthesis information from the decoding unit 510, and in the case where the signal is divided at a fixed position or the like case, the dividing unit 600 obtains the division and synthesis information from an internal memory or the like.

Next, the dividing unit 600 divides the decoded transformed output signal $y^{\wedge n}$ into the second decoded transformed output signal $y^{\wedge}_2{}^m$ and the second decoded partial signal $y^{\wedge}_{1H}{}^{n-m}$ based on the division and synthesis information obtained as above (S532). The second decoded transformed output signal $y^{\wedge}_2{}^m$ is output to the second inverse transform unit 610, and the second decoded partial signal $y^{\wedge}_{1H}{}^{n-m}$ is output to the synthesizing unit 620.

Next, the second inverse transform unit 610 obtains the second inverse transform matrix $A^{-1}_2$ provided from the transform coefficient decoding unit 512 (S532). Furthermore, the second inverse transform unit 610 generates the first decoded partial signal $y^{\wedge}_{1L}{}^m$ by performing the inverse transform (the second inverse transform $T_2{}^{-1}$) on the second decoded transformed output signal $y^{\wedge}_2{}^m$ using the second inverse transform matrix $A^{-1}_2$ obtained as above (S534). The first decoded partial signal $y^{\wedge}_{1L}{}^m$ generated as above is output to the synthesizing unit 620.

Next, the synthesizing unit 620 generates the first decoded transformed output signal $y^{\wedge}_1{}^n$ by synthesizing the first decoded partial signal $y^{\wedge}_{1L}{}^m$ and the second decoded partial signal $y^{\wedge}_{1H}{}^{n-m}$ (S535). The first decoded transformed output signal $y^{\wedge}_1{}^n$ generated as above is output to the first inverse transform unit 630.

Next, the first inverse transform unit 630 obtains the first inverse transform matrix $A^{-1}_1$ (S536). For ex\ample, in the case where the first transform matrix $A_1$ or the first inverse transform matrix $A^{-1}_1$ is included in the coded signal, the first inverse transform unit 630 obtains the first inverse transform matrix $A^{-1}_1$ from the transform coefficient decoding unit 512, and in the case where the first inverse transform is an inverse DCT or the like and the first inverse transform matrix $A^{-1}_1$ is predetermined coefficients, the first inverse transform unit 630 obtains the first inverse transform matrix $A^{-1}_1$ from an internal memory or the like.

At the end, the first inverse transform unit 630 generates the decoded signal $x^{\wedge n}$ by performing the inverse transform (the first inverse transform $T_1^{-1}$) on the first decoded transformed output signal $y^{\wedge}_1{}^n$ using the first inverse transform matrix $A^{-1}_1$ obtained as above (S537).

As above, the inverse transform unit 530 according to Embodiment 2 is capable of generating the decoded signal from the decoded transformed output signal by performing the inverse transform processing that is processing opposite to the transform processing performed on the coded signal.

Subsequently, the decoding of the transform coefficients according to Embodiment 2 is described.

As described above, the coded signal includes the coded quantized coefficients that have been compression coded and the difference between the predetermined value and each element included in the transform coefficients used in the transform processing performed in generating the coded signal. In the decoding apparatus 500 according to Embodiment 2, the decoding unit 510 generates the decoded quantized coefficients and the transform coefficients by generating the coded signal. The transform coefficients are coefficients used in the transform processing performed in generating the coded signal and are coefficients adaptively determined by the coding apparatus based on the statistical properties of the set including the input signal.

The transform coefficients have properties different between the diagonal elements and the non-diagonal elements and are coded by the coding apparatus using such properties, as described in Embodiment 1. Thus, the decoding apparatus 500 according to Embodiment 2 obtains the transform coefficients (the inverse transform coefficients) according to a decoding scheme that is different between the diagonal elements and the non-diagonal elements in the transform coefficients.

FIG. 26 is a flowchart showing an example of the operation of the transform coefficient decoding unit 512 according to Embodiment 2.

The decoding unit 510 decodes the transform coefficients included in the coded signal and compression coded, for each of the elements included in the transform coefficients. Specifically, the entropy decoding unit 511 generates the decoded transform coefficients by entropy decoding the coded signal. Next, the transform coefficient decoding unit 512 judges whether a current element to be decoded, which is included in the decoded transform coefficients, is a diagonal element or a non-diagonal element (S511).

When the current element is a diagonal element ("Diagonal element" in S511), the transform coefficient decoding unit 512 decodes the current element using a difference between a predetermined reference and the current element (S512). Specific processing will be described below.

When the current element is a non-diagonal element ("Non-diagonal element" in S511), the transform coefficient decoding unit 512 decodes the current element using relationship with its symmetrical element (S513). Specific processing will be described below.

Thus, the decoding apparatus 500 according to Embodiment 2 decodes the transform coefficients using a decoding scheme that is different depending on whether the current element is a diagonal element or a non-diagonal element. The following describes, in more detail, the decoding of the transform coefficients in the decoding apparatus 500 according to Embodiment 2.

First, the case where the current element is a diagonal element is described.

FIG. 27A is a flowchart showing an example of the operation of the transform coefficient decoding unit 512 in Embodiment 2 where the current element is a diagonal element.

First, the entropy decoding unit 511 entropy decodes the coded signal to obtain the decoded transform coefficients that are specifically a difference between each diagonal element and the predetermined value, and outputs it to the transform coefficient decoding unit 512 (S600). For example, in the coded signal generated according to the flowchart shown in FIG. 11A, a difference between the diagonal element a(i, i) and a predetermined c is described in a header. Thus, the entropy decoding unit 511 entropy decodes the coded signal to obtain the header description h(i, i) indicated by Expression 5.

Next, the transform coefficient decoding unit 512 adds the obtained header description h(i, i) and the predetermined value c to obtain the diagonal element a(i, i) (S610). At this time, it may be possible that the predetermined value c is also described in the header of the coded signal, and as a result of entropy coding of the coded signal by the entropy decoding unit 511, the transform coefficient decoding unit 512 obtains the predetermined value c. Alternatively, it may also be possible that when the predetermined value c is a predetermined fixed value (for example, c=1) which is, for example, the largest possible value of the elements in the transform coefficients, the transform coefficient decoding unit 512 holds the predetermined value c in advance in an internal memory or the like.

In the above-described manner, the transform coefficient decoding unit 512 is capable of decoding the transform coefficients which have been coded using the properties that the diagonal elements in the transform coefficients often have values close to the predetermined value which is the largest possible value or the like.

The predetermined value may also be the diagonal element a(i-1, i-1) or a(i+1, i+1) adjacent to the diagonal element a(i, i). For example, the coded signal includes the header description h(i, i) indicated by Expression 6.

At this time, the entropy decoding unit 511 entropy decodes the coded signal to obtain the header description h(i, i) indicated by Expression 6 and outputs the obtained header description h(i, i) to the transform coefficient decoding unit 512. The transform coefficient decoding unit 512 then adds the obtained header description and the already decoded diagonal element a(i-1, i-1) to generate the diagonal element a(i, i) that is a current element to be decoded.

With this, the transform coefficient decoding unit 512 is capable of decoding the transform coefficients which have been coded using a tendency that the lower right diagonal elements in the transform coefficients are farther from 1.

The predetermined value may also be the prediction value p(i, i) of the diagonal element a(i, i) that is the current element to be decoded.

FIG. 27B is a flowchart showing an example of the operation of the transform coefficient decoding unit 512 in Embodiment 2 where the current element is a diagonal element.

First, the entropy decoding unit 511 entropy decodes the coded signal to obtain a difference between each diagonal element and the prediction value, and outputs it to the transform coefficient decoding unit 512 (S600). For example, in the coded signal generated according to the flowchart shown in FIG. 11B, a difference between the diagonal element a(i, i) and the prediction value p(i, i) is described in a header. Thus, the entropy decoding unit 511 entropy decodes the coded signal to obtain the header description h(i, j) indicated by Expression 9.

Next, the transform coefficient decoding unit 512 generates the prediction value p(i, i) (S611). For example, the transform coefficient decoding unit 512 generates the prediction value p(i, i) according to Expressions 7 and 8. It is to be noted that information to be used in generating the prediction value, for example, i(i, i) and c(i, i) in Expressions 7 and 8, is described in a header of the coded signal. Alternatively, values held in an internal memory or the like of the transform coefficient decoding unit 512 may be used.

The transform coefficient decoding unit 512 then adds the generated prediction value p(i, i) and the obtained difference, i.e., the header description h(i, i), to generate the diagonal element a(i, i) (S612).

In the above-described manner, the entropy decoding unit 511 entropy decodes the coded signal, and the transform coefficient decoding unit 512 decodes the obtained decoded transform coefficients, to generate the diagonal elements. It is to be noted that the processing shown in FIGS. 27A and 27B is an example of the decoding process (S512) using a difference from a predetermined reference shown in FIG. 26. It is to be noted that which one of the decoding schemes of FIGS. 27A and 27B is to be used for decoding or whether another decoding scheme is to be used for decoding is described in a header of the coded signal, for example.

Subsequently, the case where the current element is a non-diagonal element is described.

When the current element is a non-diagonal element, the transform coefficient decoding unit 512 decodes a component obtained by removing redundancy between the non-diagonal element and its symmetrical element that is an element at a position symmetrical to the non-diagonal element about a diagonal element. Assuming that the current element is indicated by a(i, j), its symmetrical element is indicated by a(j, i) (cf. FIG. 12).

For example, the coded signal includes the average value of the absolute value of the non-diagonal element and the absolute value of the symmetrical element (which average value is the absolute average value) and the difference between the average value and the absolute value of the non-diagonal element. The operation of the decoding apparatus 500 which has received the coded signal including the absolute average value and the difference is described with reference to FIG. 28.

FIG. 28 is a flowchart showing an example of the operation of the transform coefficient decoding unit 512 in Embodiment 2 where the current element is a non-diagonal element.

First, the entropy decoding unit 511 entropy decodes the coded signal to obtain the average value of the absolute value of the non-diagonal element and the absolute value of the symmetrical element, the difference between the average value and the absolute value of the non-diagonal element, and the sign of the non-diagonal element, and outputs them to the transform coefficient decoding unit 512 (S700).

For example, in the coded signal generated according to the flowchart shown in FIG. 13, the average value ha_tpair(i, j) of the absolute value and the difference ha(i, j) between the average value and the absolute value of the non-diagonal element are described in a header. Thus, the entropy decoding unit 511 entropy decodes the coded signal to obtain ha_tpair(i, j) and ha(i, j) indicated by Expressions 10 to 12.

Furthermore, the coded signal includes information indicating the signs of the non-diagonal elements coded in any of modes 1 to 4 shown in FIG. 16 and other modes. Details of the information indicating the signs will be described below.

Next, the transform coefficient decoding unit 512 adds the obtained difference ha(i, j) and the obtained average value ha_tpair(i, j) (cf. Expressions 10 to 12), to generate the absolute value of the non-diagonal element a(i, j) (S710). Furthermore, the transform coefficient decoding unit 512 generates the non-diagonal element a(i, j) by determining the sign of the non-diagonal element a(i, j) based on the information indicating the signs (S720).

The following describes the operation of the transform coefficient decoding unit 512 in the case where the information indicating the signs of the transform coefficients coded according to modes 1 to 4 shown in FIG. 16.

As an example, the following describes the case where the sign information in mode 1 has been obtained.

Since the sign information indicates the sign of each of the non-diagonal elements without any change, the transform coefficient decoding unit 512 determines the sign of each of the non-diagonal elements according to the obtained sign information.

Next, the case where the sign reverse information and the sign information in mode 2 have been obtained is described. The sign reverse information is information indicating whether or not the current element and the symmetrical element have different signs. The sign information indicating positivity and negativity of the top-triangle element or the bottom-triangle element. Here, the sign information is assumed to indicate the sign of the current element for each of the top-triangle elements.

For example, when the sign information indicates that the current element a(i, j) included in the top-triangle elements has a plus sign, the transform coefficient decoding unit 512 determines the sign of the symmetrical element a(j, i) based on the sign reverse information of the current element a(i, j). For example, when the sign reverse information indicates that the sign of the current element and the sign of the symmetrical element are reverse, the sign of the symmetrical element a(j, i) is minus. On the other hand, when the sign reverse information indicates that the sign of the current element and the sign of the symmetrical element are not reverse, the sign of the symmetrical element a(j, i) is plus. When the sign information indicates that the current element a(i, j) included in the top-triangle elements has a minus sign, the sign of the symmetrical element a(j, i) is opposite to the above.

Next, the case where the all-sign reverse information and the sign information in mode 3 have been obtained is described. The all-sign reverse information is information indicating that the non-diagonal elements included in the transform coefficients have reverse signs at all the positions. Thus, when the sign information indicates that the current element a(i, j) has a plus sign, the transform coefficient decoding unit 512 determines that the symmetrical element a(j, i) has a minus sign. When the sign information indicates that the current element a(i, j) has a minus sign, the sign of the symmetrical element a(j, i) is plus.

Next, the case where the top-triangle element sign information or the range information in mode 4 has been obtained is described. The top-triangle element sign information is information indicating that the top-triangle elements included in the transform coefficients have plus signs at all the positions. The range information is information indicating that the top-triangle elements in a top-left partial matrix of nxn have plus signs.

For example, when the top-triangle element sign information has been obtained, the transform coefficient decoding unit 512 may determine that the top-triangle element has a plus sign and also determine that all the bottom-triangle elements have minus signs. Furthermore, when the range information has been obtained, the transform coefficient decoding unit 512 determines that, out of the coefficients included in the transform coefficients, the top-triangle elements in the top-left partial matrix of n x n have plus signs at all the positions. At this time, the transform coefficient decoding unit 512 may determine that the bottom-triangle elements in the top-left partial matrix of nxn have minus signs at all the positions.

It may instead be possible to obtain the bottom-triangle element sign information indicating that the bottom-triangle elements included in the transform coefficients have minus signs at all the positions.

In the above-described manner, the transform coefficient decoding unit 512 determines the sign of the non-diagonal element a(i, j). Furthermore, since the absolute value of the non-diagonal element a(i, j) is calculated by adding the obtained absolute average value ha_tpair(i, j) and ha(i, j) as described above, the transform coefficient decoding unit 512 is capable of generating the non-diagonal element a(i, j).

As above, the decoding apparatus 500 according to Embodiment 2 obtains the transform coefficients from the coded signal and performs the inverse transform using the obtained transform coefficients, thereby generating the decoded signal. At this time, the transform coefficients have properties different between the diagonal elements and the non-diagonal elements, and the coded signal includes the differences calculated using these properties, as described in Embodiment 1.

It is to be noted that the coded signal may include the inverse transform coefficients. Specifically, it may be possible that the coding apparatus generates the inverse transform coefficients based on the transform coefficients used in the transform and codes the generated inverse transform coefficients based on the above embodiment. In other words, the decoding apparatus 500 according to Embodiment 2 may obtain (reconstruct) the inverse transform coefficients from the coding apparatus.

The decoding apparatus 500 according to Embodiment 2 is capable of decoding the coded signal using the properties of the transform coefficients, by performing the processing opposite to the processing which the coding apparatus performs.

It is to be noted that the transform coefficients included in the coded signal may have been quantized. Specifically, the coded signal may include the transform coefficients quantized as above (hereinafter referred to as quantized transform coefficients) and the information indicating the quantization step used in quantizing the transform coefficients. At this time, in the decoding apparatus according to Embodiment 2, as shown in FIG. 29A, the quantized transform coefficients decoded by the decoding unit 510 are output to a transform coefficient inverse quantization unit 714 included in a transform coefficient decoding unit 712a. FIG. 29A shows an example of a structure of a decoding apparatus 700a according to Variation of Embodiment 2.

The decoding apparatus 700a is different from the decoding apparatus 500 shown in FIG. 21 in that a decoding unit 710a is provided instead of the decoding unit 510. The decoding unit 710a includes the entropy decoding unit 511 and the transform coefficient decoding unit 712a. The following mainly describes differences from the structure shown in FIG. 21, by omitting descriptions of the same structure.

The transform coefficient decoding unit 712a includes the transform coefficient inverse quantization unit 714 and a transform coefficient difference decoding unit 716, and quantizes and decodes the quantized transform coefficients generated by the entropy decoding unit 511, to reconstruct the transform coefficients and thereby generate the inverse transform coefficients.

The entropy decoding unit 511 entropy decodes the coded signal to obtain the quantization step and the quantized transform coefficients. The quantization step is, for each of the elements in the transform coefficients, weighted according to the position of the element in consideration of energy, for example, as described in Embodiment 1. For example, the weighting is performed so that a component having large energy, that is, a low-frequency component, has a small quantization step.

The entropy decoding unit 511 entropy decodes the coded signal, for example, to obtain the quantized transform coefficients and the quantization step table and index table shown in FIGS. 18A to 18C, and outputs them to the transform coefficient inverse quantization unit 714.

Using the quantization step table and the index table, the transform coefficient inverse quantization unit 714 generates, for each of the elements in the transform coefficients, the quantization step $TWL(i, j)$ according to the position of the element, in the like manner as in Embodiment 1. The transform coefficient inverse quantization unit 714 then generates the difference $ha(i, j)$ which is a header description, using the generated quantization step and the quantized element $ha'(i, j)$ (cf. Expression 13).

The transform coefficient difference decoding unit 716 corresponds to the above-described transform coefficient decoding unit 512, and when the current element is a diagonal element, the difference generated by the inverse quantization and the predetermined reference are added to reconstruct the diagonal element. When the current element is a non-diagonal element, the transform coefficient difference decoding unit 716 decodes the non-diagonal element using redundancy between the non-diagonal element and its symmetrical element. The inverse transform coefficients resulting from the decoding are output to the inverse transform unit 530.

As above, the decoding apparatus 700a that is another example of Embodiment 2 is capable of generating the inverse transform coefficients by reconstructing, based on the quantized transform coefficients, the transform coefficients used in the coding, and therefore is capable of decoding the coded signal including the quantized transform coefficients.

As in the decoding apparatus 700b shown in FIG. 29B, an entropy decoding unit dedicated to entropy decoding of the coded transform coefficients may be provided.

The decoding apparatus 700b is different from the decoding apparatus 700a shown in FIG. 29A in that a decoding unit 710b is provided instead of the decoding unit 710a and furthermore, an inverse multiplexing unit 705 is newly provided. The decoding unit 710b includes the entropy decoding unit 511 and a transform coefficient decoding unit 712b. The transform coefficient decoding unit 712b includes the transform coefficient inverse quantization unit 714, the transform coefficient difference decoding unit 716, and a transform coefficient entropy decoding unit 718. The following mainly describes differences from the structure of the decoding apparatus 700a shown in FIG. 29A, by omitting descriptions of the same structure.

The inverse multiplexing unit 705 separates the received coded signal into the coded quantized coefficients and the coded transform coefficients. The coded quantized coefficients are output to the entropy decoding unit 511, and the coded quantized coefficients are output to the transform coefficient entropy decoding unit 718.

The transform coefficient entropy decoding unit 718 entropy decodes the coded transform coefficients received from the inverse multiplexing unit 705, to obtain the quantized transform coefficients. The quantized transform coefficients are output to the transform coefficient inverse quantization unit 714.

As above, the decoding apparatus according to Embodiment 2 may include separate entropy coding units for quantized coefficients and for transform coefficients as in the case of the decoding apparatus 700b shown in FIG. 29B.

The present invention may be applied to prediction decoding in which a coded signal resulting from prediction coding is decoded.

FIG. 30 shows an example of a structure of a decoding apparatus 800 according to Variation of Embodiment 2. To the decoding apparatus 800, a coded signal resulting from prediction coding is input. The coded signal resulting from the prediction coding is, for example, the coded signal provided from the coding apparatus 400 shown in FIG. 19, and is a signal generated by transforming and quantizing the prediction error signal.

The decoding apparatus 800 shown in FIG. 30 includes the decoding unit 510, the inverse quantization unit 520, the inverse transform unit 530, an adder 840, a memory 850, and a prediction unit 860. Processing units which perform the same operation as those in the decoding apparatus 500 shown in FIG. 21 are denoted with the same reference numerals and are not described below.

The decoding unit 510 obtains the decoded quantized coefficients and the transform coefficients by entropy decoding the received coded signal. The decoding unit 510 obtains control information used for prediction in generating the coded signal, such as a prediction mode (including intra prediction or inter prediction), and outputs it to the prediction unit 860.

The inverse quantization unit 520 and the inverse transform unit 530 operate as described above and therefore are not described here.

The adder 840 generates a decoded signal by adding the decoded transformed input signal provided from the inverse quantization transform unit 530 and the prediction signal generated by the prediction unit 860.

The memory 850 is an example of a storage unit, such as a memory in which the decoded signal is stored.

The prediction unit 860 generates a prediction signal with reference to the previously decoded signal stored in the memory 850. The generated prediction signal is output to the adder 840. For example, the prediction unit 860 generates the prediction signal based on the control information received from the decoding unit 510.

Subsequently, operation of the above decoding apparatus 800 is described with reference to FIG. 31.

FIG. 31 is a flowchart showing an example of the operation of the decoding apparatus 800 according to Variation of Embodiment 2.

First, a coded signal resulting from prediction coding of an input signal of audio data, video data, or the like is input to the decoding apparatus 800. Specifically, the coded signal is a signal generated by performing the transform, the quantization, and the compression coding on a prediction error signal that is a difference between the input signal and the prediction signal.

The prediction unit 860 generates the prediction signal based on the already decoded signal stored in the memory 850 (S800).

Next, the decoding unit 510 obtains the decoded quantized coefficients and the inverse transform coefficients by decoding the coded signal (S510). The inverse quantization unit 520 then generates the decoded transformed output signal by inverse quantizing the decoded quantized coefficients (S520). Furthermore, the inverse transform unit 530 generates the decoded transformed input signal by inverse transforming the decoded transformed output signal using the inverse transform coefficients received from the decoding unit 510 (S530). The decoded transformed input signal is a decoded prediction error signal generated by reconstructing the prediction error signal.

Next, the adder 840 generates the decoded signal by adding the prediction signal and the decoded transformed input signal (S840). The adder 840 stores, as a reference signal, the generated decoded signal onto the memory 850 and provides, as an output signal, the decoded signal to outside (S850).

In the case where the control information contained in the coded signal is necessary in generating the prediction signal, the prediction signal is generated (S800) after the entropy decoding process (S510). Furthermore, the generating of the prediction signal (S800) may be in parallel with the inverse quantization (S520) and the inverse transform (S530).

In the above-described manner, the decoding apparatus 800 is capable of decoding the coded signal generated by coding the prediction error signal.

The coded signal to be decoded may be a signal generated by quantizing and entropy coding the second partial signal and the second transformed output signal separately without synthesizing these signals. In other words, when the entropy decoding and the inverse quantization result in the second decoded partial signal and the second decoded transformed output signal, the decoding apparatus 500 is not required to include the dividing unit 600.

Furthermore, even in the case where only one-stage inverse transform is performed, the above decoding method according to Embodiment 2 can apply. For example, it may be possible that a difference between a default transform coefficient Dij (for example, a transform coefficient to be used in the DCT) and a coefficient Wij actually used in the transform is calculated, and the coded signal thus contains the calculated difference. At this time, the decoding apparatus 500 obtains the difference by entropy decoding the coded signal. For example, the decoding apparatus 500 stores the default transform coefficient Dij in an internal memory or the like, so as to add the obtained difference and the default transform coefficient Dij, and is thus capable of generating the coefficient Wij used in the transform.

(Embodiment 3)

The processing described in each of Embodiments can be simply implemented in an independent computer system, by recording, in a recording medium, a program for implementing the configurations of the video coding method and the video decoding method described in Embodiments. The recording media may be any recording media as long as the program can be recorded, such as a magnetic disk, an optical disk, a magnetic optical disk, an IC card, and a semiconductor memory.

Hereinafter, the applications to the video coding method and the video decoding method described in Embodiments and systems using thereof will be described.

FIG. 32 illustrates an overall configuration of a content providing system ex100 for implementing content distribution services. The area for providing communication services is divided into cells of desired size, and base stations ex107 to ex110 which are fixed wireless stations are placed in each of the cells.

The content providing system ex100 is connected to devices, such as a computer ex111, a personal digital assistant (PDA) ex112, a camera ex113, a cellular phone ex114 and a game machine ex115, via the Internet ex101, an Internet service provider ex102, a telephone network ex104, as well as the base stations ex107 to ex110, respectively.

However, the configuration of the content providing system ex100 is not limited to the configuration shown in FIG. 32, and a combination in which any of the elements are connected is acceptable. In addition, each device may be directly connected to the telephone network ex104, rather than via the base stations ex107 to ex110 which are the fixed wireless stations. Furthermore, the devices may be interconnected to each other via a short distance wireless communication and others.

The camera ex113, such as a digital video camera, is capable of capturing video. A camera ex116, such as a digital video camera, is capable of capturing both still images and video. Furthermore, the cellular phone vex114 may be the one that meets any of the standards such as Global System for Mobile Communications (GSM), Code Division Multiple Access (CDMA), Wideband-Code Division Multiple Access (W-CDMA), Long Term Evolution (LTE), and High Speed Packet Access (HSPA). Alternatively, the cellular phone ex114 may be a Personal Handyphone System (PHS).

In the content providing system ex100, a streaming server ex103 is connected to the camera ex113 and others via the telephone network ex104 and the base station ex109, which enables distribution of images of a live show and others. In such a distribution, a content (for example, video of a music live show) captured by the user using the camera ex113 is coded as described above in Embodiments, and the coded content is transmitted to the streaming server ex103. On the other hand, the streaming server ex103 carries out stream distribution of the transmitted content data to the clients upon their requests. The clients include the computer ex111, the PDA ex112, the camera ex113, the cellular phone ex114, and the game machine ex115 that are capable of decoding the above-mentioned coded data. Each of the devices that have received the distributed data decodes and reproduces the coded data.

The captured data may be coded by the camera ex113 or the streaming server ex103 that transmits the data, or the coding processes may be shared between the camera ex113 and the streaming server ex103. Similarly, the distributed data may be decoded by the clients or the streaming server ex103, or the decoding processes may be shared between the clients and the streaming server ex103. Furthermore, the data of the still images and video captured by not only the camera ex113 but also the camera ex116 may be transmitted to the streaming server ex103 through the computer ex111. The coding processes may be performed by the camera ex116, the computer ex111, or the streaming server ex103, or shared among them.

Furthermore, the coding and decoding processes may be performed by an LSI ex500 generally included in each of the computer ex111 and the devices. The LSI ex500 may be configured of a single chip or a plurality of chips. Software for coding and decoding video may be synthesized into some type of a recording medium (such as a CD-ROM, a flexible disk, and a hard disk) that is readable by the computer ex111 and others, and the coding and decoding processes may be performed using the software. Furthermore, when the cellular phone ex114 is equipped with a camera, the image data obtained by the camera may be transmitted. The video data is data coded by the LSI ex500 included in the cellular phone ex114.

Furthermore, the streaming server ex103 may be composed of servers and computers, and may decentralize data and process the decentralized data, record, or distribute data.

As described above, the clients may receive and reproduce the coded data in the content providing system ex100. In other words, the clients can receive and decode information transmitted by the user, and reproduce the decoded data in real time in the content providing system ex100, so that the user who does not have any particular right and equipment can implement personal broadcasting.

Each of the devices included in this content providing system may perform coding and decoding using the image coding method and the image decoding method described in Embodiments.

The cellular phone ex114 will be described as an example of such a device.

FIG. 33 illustrates the cellular phone ex114 that uses the image coding method and the image decoding method described in Embodiments. The cellular phone ex114 includes: an antenna ex601 for transmitting and receiving radio waves through the base station ex110; a camera unit ex603 such as a CCD camera capable of capturing moving and still images; a display unit ex602 such as a liquid crystal display for displaying the data such as decoded video captured by the camera unit ex603 or received by the antenna ex601; a main body unit including a set of operation keys ex604; an audio output unit ex608 such as a speaker for output of audio; an audio input unit ex605 such as a microphone for input of audio; a recording medium ex607 for recording coded or decoded data including data of captured moving or still images, data of received e-mails, and data of moving or still images; and a slot unit ex606 for enabling the cellular phone ex114 to attach the recording medium ex607. The recording medium ex607 is a medium that stores a flash memory device within a plastic case, for example, an SD Card. The flash memory device is one type of Electrically Erasable and Programmable Read-Only Memory (EEPROM) which is a non-volatile memory that is electrically rewritable and erasable.

Next, the cellular phone ex114 will be described with reference to FIG. 34. In the cellular phone ex114, a main control unit ex711 designed to control overall each unit of the main body including the display unit ex602 as well as the operation key ex604 is connected mutually, via a synchronous bus ex713, to a power supply circuit unit ex710, an operation input control unit ex704, an image coding unit ex712, a camera interface unit ex703, a liquid crystal display (LCD) control unit ex702, an image decoding unit ex 709, a multiplexing/demultiplexing unit ex708, a recording/reproducing unit ex707, a modem circuit unit ex706, and an audio processing unit ex705.

When a call-end key or a power key is turned ON by a user's operation, the power supply circuit unit ex710 supplies the respective units with power from a battery pack so as to activate the cell phone ex114 that is digital and is equipped with the camera.

In the cellular phone ex114, the audio processing unit ex705 converts the audio signals collected by the audio input unit ex605 in voice conversation mode into digital audio data under the control of the main control unit ex711 including a CPU, ROM, and RAM. Then, the modem circuit unit ex706 performs spread spectrum processing on the digital audio data, and the transmitting and receiving circuit unit ex701 performs digital-to-analog conversion and frequency conversion on the data, so as to transmit the resulting data via the antenna ex601. In addition, in the cellular phone ex114, the transmitting and receiving circuit unit ex701 amplifies the data received by the antenna ex601 in voice conversation mode and performs frequency conversion and the analog-to-digital conversion on the data. Then, the modem circuit unit ex706 performs inverse spread spectrum processing on the data, and the audio processing unit ex705 converts it into analog audio data, so as to output it via the audio output unit ex608.

Furthermore, when an e-mail in data communication mode is transmitted, text data of the e-mail inputted by operating the operation keys ex604 of the main body is sent out to the main control unit ex711 via the operation input control unit ex704. The main control unit ex711 causes the modem circuit unit ex706 to perform spread spectrum processing on the text data, and the transmitting and receiving circuit unit ex701 performs the digital-to-analog conversion and the frequency conversion on the resulting data to transmit the data to the base station ex110 via the antenna ex601.

When image data is transmitted in data communication mode, the image data captured by the camera unit ex603 is supplied to the image coding unit ex712 via the camera interface unit ex703. Furthermore, when the image data is not transmitted, the image data captured by the camera unit ex603 can be displayed directly on the display unit ex602 via the camera interface unit ex703 and the LCD control unit ex702.

The image coding unit ex712 including the image coding apparatus as described for the present invention compresses and codes the image data supplied from the camera unit ex603 using the coding method employed by the image coding apparatus as shown in Embodiments so as to transform the data into coded image data, and sends the data out to the multiplexing/demultiplexing unit ex708. Furthermore, the cellular phone ex114 simultaneously sends out, as digital audio data, the audio collected by the audio input unit ex605 during the capturing with the camera unit ex603 to the multiplexing/demultiplexing unit ex708 via the audio processing unit ex705.

The multiplexing/demultiplexing unit ex708 multiplexes the coded image data supplied from the image coding unit ex712 and the audio data supplied from the audio processing unit ex705, using a predetermined method. Then, the modem circuit unit ex706 performs spread spectrum processing on the multiplexed data obtained by the multiplexing/demultiplexing unit ex708. After the digital-to-analog conversion and frequency conversion on the data, the transmitting and receiving circuit unit ex701 transmits the resulting data via the antenna ex601.

When receiving data of a video file which is linked to a Web page and others in data communication mode, the modem circuit unit ex706 performs inverse spread spectrum processing on the data received from the base station ex102 via the antenna ex601, and sends out the multiplexed data obtained as a result of the inverse spread spectrum processing to the multiplexing/demultiplexing unit ex708.

In order to decode the multiplexed data received via the antenna ex601, the multiplexing/demultiplexing unit ex708 demultiplexes the multiplexed data into a bit stream of image data and that of audio data, and supplies the coded image data to the image decoding unit ex709 and the audio data to the audio processing unit ex705, respectively via the synchronous bus ex713.

Next, the image decoding unit ex709 including the image decoding apparatus described according to the present invention decodes the bit stream of the image data using a decoding method corresponding to the coding method as described in Embodiments so as to generate reproduced video data, and supplies this data to the display unit ex602 via the LCD control unit ex702. Thus, the video data included in the video file linked to the Web page, for instance, is displayed. Simultaneously, the audio processing unit ex705 converts the audio data into analog audio data, and supplies the data to the audio output unit ex608. Thus, the audio data included in the video file linked to the Web page, for instance, is reproduced.

The present invention is not limited to the above-mentioned system because terrestrial or satellite digital broadcasting has been in the news lately, and at least one of the image coding apparatus and the image decoding apparatus described in Embodiments can be incorporated into a digital broadcasting system as shown in FIG. 35. More specifically, a broadcast station ex201 communicates or transmits, via radio waves to a broadcast satellite ex202, audio data, video data, or a bit stream obtained by multiplexing the audio data and the video data. Upon receipt of the bit stream, the broadcast satellite ex202 transmits radio waves for broadcasting. Then, a home-use antenna ex204 with a satellite broadcast reception function receives the radio waves, and a device, such as a television (receiver) ex300 and a set top box (STB) ex217 decodes a coded bit stream and reproduces the decoded bit stream. Furthermore, a reader/recorder ex218 that reads and decodes such a bit stream obtained by multiplexing image data and audio data that are recorded on storage media ex215 and 216, such as a CD and a DVD may include an image decoding apparatus described in Embodiments. In this case, the reproduced video signals are displayed on the monitor ex219. It is also possible to implement the image decoding apparatus in the set top box ex217 connected to a cable ex203 for a cable television or an antenna ex204 for satellite and/or terrestrial broadcasting, so as to reproduce the video signals on the monitor ex219 of the television ex300. The image decoding apparatus may be included not in the set top box but in the television ex300. Also, a car ex210 having an antenna ex205 can receive signals from the satellite ex202 or the base station ex201 for reproducing video on a display device such as a car navigation system ex211 set in the car ex210.

Furthermore, the video decoding apparatus or the video coding apparatus as shown in Embodiments can be implemented in the reader/recorder ex218 (i) for reading and decoding the video data, the audio data, or the coded bit stream obtained by multiplexing the video data and the audio data, or (ii) for coding the video data, the audio data, or the coded bit stream obtained by multiplexing the video data and the audio data and recording the resulting data as the multiplexed data on the recording medium ex215. Here, the video data and the audio data are recorded on the recording medium ex215, such as a BD and a DVD. In this case, the reproduced video signals are displayed on the monitor ex219, and the reproduced video signals can be reproduced by another device or system, using the recording medium ex215 on which the coded bit stream is recorded. Furthermore, it is also possible to implement the video decoding apparatus in the set top box ex217 connected to the cable ex203 for a cable television or the antenna ex204 for satellite and/or terrestrial broadcasting, so as to display the video signals on the monitor ex219 of the television ex300. The image decoding apparatus may be included not in the set top box but in the television ex300.

FIG. 36 illustrates the television (receiver) ex300 that uses the video decoding method and the video coding method described in Embodiments. The television ex300 includes: a tuner ex301 that obtains or provides a bit stream of video information through the antenna ex204 or the cable ex203, etc. that receives a broadcast; a modulation/demodulation unit ex302 that demodulates the received coded data or modulates data into coded data to be supplied outside; and a multiplexing/demultiplexing unit ex303 that demultiplexes the modulated data into video data and audio data, or multiplexes the coded video data and audio data into data. Furthermore, the television ex300 further includes: a signal processing unit ex306 including an audio signal processing unit ex304 and a video signal processing unit ex305 that decode audio data and video data and code audio data and video data, respectively; a speaker ex307 that provides the decoded audio signal; and an output unit ex309 including a display unit ex308 that displays the decoded video signal, such as a display. Furthermore, the television ex300 includes an interface unit ex317 including an operation input unit ex312 that receives an input of a user operation. Furthermore, the television ex300 includes a control unit ex310 that controls overall each constituent element of the television ex300, and a power supply circuit unit ex311 that supplies power to each of the elements. Other than the operation input unit ex312, the interface unit ex317 may include: a bridge ex313 that is connected to an external device, such as the reader/recorder ex218; a slot unit ex314 for enabling attachment of the recording medium ex216, such as an SD card; a driver ex315 to be connected to an external recording medium, such as a hard disk; and a modem ex316 to be connected to a telephone network. Here, the recording medium ex216 can electrically record information using a non-volatile/volatile semiconductor memory element for storage. The constituent elements of the television ex300 are connected to one another through a synchronous bus.

First, a configuration in which the television ex300 decodes data obtained from outside through the antenna ex204 and others and reproduces the decoded data will be described. In the television ex300, upon receipt of a user operation from a remote controller ex220 and others, the multiplexing/demuitiplexing unit ex303 demultiplexes the video data and audio data demodulated by the modulation/demodulation unit ex302, under control of the control unit ex310 including a CPU. Furthermore, the audio signal processing unit ex304 decodes the demultiplexed audio data, and the video signal processing unit ex305 decodes the demultiplexed video data, using the decoding method described in Embodiments, in the television ex300. The output unit ex309 provides the decoded video signal and audio signal outside, respectively. When the output unit ex309 provides the video signal and the audio signal, the signals may be temporarily stored in buffers ex318 and ex319, and others so that the signals are reproduced in synchronization with each other. Furthermore, the television ex300 may read a coded bit stream not through a broadcast and others but from the recording media ex215 and ex216, such as a magnetic disk, an optical disc, and a SD card. Next, a configuration in which the television ex300 codes an audio signal and a video signal, and transmits the data outside or writes the data on a recording medium will be described. In the television ex300, upon receipt of a user operation from the remote controller ex220 and others, the audio signal processing unit ex304 codes an audio signal, and the video signal processing unit ex305 codes a video signal, under control of the control unit ex310 using the coding method as described in Embodiments. The multiplexing/demultiplexing unit ex303 multiplexes the coded video signal and audio signal, and provides the resulting signal outside. When the multiplexing/demultiplexing unit ex303 multiplexes the video signal and the audio signal, the signals may be temporarily stored in buffers ex320 and ex321, and others so that the signals are reproduced in synchronization with each other. Here, the buffers ex318 to ex321 may be plural as illustrated, or at least one buffer may be shared in the television ex300. Furthermore, data may be stored in a buffer other than the buffers ex318 to ex321 so that the system overflow and underflow may be avoided between the modulation/demodulation unit ex302 and the multiplexing/demultiplexing unit ex303, for example.

Furthermore, the television ex300 may include a configuration for receiving an AV input from a microphone or a camera other than the configuration for obtaining audio and video data from a broadcast or a recording medium, and may code the obtained data. Although the television ex300 can code, multiplex, and provide outside data in the description, it may not be capable of coding, multiplexing, and providing outside data but capable of only one of receiving, decoding, and providing outside data.

Furthermore, when the reader/recorder ex218 reads or writes a coded bit stream from or in a recording medium, any of the television ex300 and the reader/recorder ex218 may decode or code the coded bit stream, and the television ex300 and the reader/recorder ex218 may share the decoding or coding.

As an example, FIG. 37 illustrates a configuration of an information reproducing/recording unit ex400 when data is read or written from or in an optical disc. The information reproducing/recording unit ex400 includes constituent elements ex401 to ex407 to be described hereinafter. The optical head ex401 irradiates a laser spot on a recording surface of the recording medium ex215 that is an optical disk to write information, and detects reflected light from the recording surface of the recording medium ex215 to read the information. The modulation recording unit ex402 electrically drives a semiconductor laser included in the optical head ex401, and modulates the laser light according to recorded data. The reproduction demodulating unit ex403 amplifies a reproduction signal obtained by electrically detecting the reflected light from the recording surface using a photo detector included in the optical head ex401, and demodulates the reproduction signal by separating a signal component recorded on the recording medium ex215 to reproduce the necessary information. The buffer ex404 temporarily holds the information to be recorded on the recording medium ex215 and the information reproduced from the recording medium ex215. A disc motor ex405 rotates the recording medium ex215. A servo control unit ex406 moves the optical head ex401 to a predetermined information track while controlling the rotation drive of the disc motor ex405 so as to follow the laser spot. The system control unit ex407 controls overall the information reproducing/recording unit ex400. The reading and writing processes can be implemented by the system control unit ex407 using various information held in the buffer ex404 and generating and adding new information as necessary, and by the modulation recording unit ex402, the reproduction demodulating unit ex403, and the servo control unit ex406 that record and reproduce information through the optical head ex401 while being operated in a coordinated manner. The system control unit ex407 includes, for example, a microprocessor, and executes processing by causing a computer to execute a program for read and write.

Although the optical head ex401 irradiates a laser spot in the description, it may perform high-density recording using near field light.

FIG. 38 schematically illustrates the recording medium ex215 that is the optical disk. On the recording surface of the recording medium ex215, guide grooves are spirally formed, and an information track ex230 records, in advance, address information indicating an absolute position on the disk according to change in a shape of the guide grooves. The address information includes information for determining positions of recording blocks ex231 that are a unit for recording data. An apparatus that records and reproduces data reproduces the information track ex230 and reads the address information so as to determine the positions of the recording blocks. Furthermore, the recording medium ex215 includes a data recording area ex233, an inner circumference area ex232, and an outer circumference area ex234. The data recording area ex233 is an area for use in recording the user data. The inner circumference area ex232 and the outer circumference area ex234 that are inside and outside of the data recording area ex233, respectively are for specific use except for recording the user data. The information reproducing/recording unit 400 reads and writes coded audio data, coded video data, or coded data obtained by multiplexing the coded audio data and the coded video data, from and in the data recording area ex233 of the recording medium ex215.

Although an optical disc having a layer, such as a DVD and a BD is described as an example in the description, the optical disk is not limited to such, and may be an optical disk having a multilayer structure and capable of being recorded on a part other than the surface. Furthermore, the optical disc may have a structure for multidimensional recording/reproduction, such as recording information using light of colors with different wavelengths in the same portion of the optical disc and recording information having different layers from various angles.

Furthermore, the car ex210 having the antenna ex205 can receive data from the satellite ex202 and others, and reproduce video on the display device such as the car navigation system ex211 set in the car ex210, in a digital broadcasting system ex200. Here, a configuration of the car navigation system ex211 will be a configuration, for example, including a GPS receiving unit from the configuration illustrated in FIG. 36. The same will be true for the configuration of the computer ex111, the cellular phone ex114, and others. Furthermore, similarly to the television ex300, a terminal such as the cellular phone ex114 may have 3 types of implementation configurations including not only (i) a transmitting and receiving terminal including both a coding apparatus and a decoding apparatus, but also (ii) a transmitting terminal including only a coding apparatus and (iii) a receiving terminal including only a decoding apparatus.

As such, the video coding method or the video decoding method in Embodiments can be used in any of the devices and systems described. Thus, the advantages described in Embodiments can be obtained.

Furthermore, the present invention is not limited to Embodiments, and various modifications or revisions are possible without departing from the scope of the present invention.

(Embodiment 4)

Each of the video coding method and apparatus and the video decoding method and apparatus in Embodiments is typically achieved in the form of an integrated circuit or a LSI circuit. As an example, FIG. 39 illustrates a configuration of an LSI ex500 that is made into one chip. The LSI ex500 includes elements ex501 to ex509 to be described below, and the elements are connected to each other through a bus ex510. The power supply circuit unit ex505 is activated by supplying each of the elements with power when power is on.

For example, when coding is performed, the LSI ex500 receives an AV signal from a microphone ex117, a camera ex113, and others through an AV IO ex509 under control of a control unit ex501 including a CPU ex502, a memory controller ex503, and a stream controller ex504. The received AV signal is temporarily stored in a memory ex511 outside the LSI ex500, such as an SDRAM. Under control of the control unit ex501, the stored data is subdivided into data portions according to the processing amount and speed as necessary. Then, the data portions are transmitted to a signal processing unit ex507. The signal processing unit ex507 codes an audio signal and/or a video signal. Here, the coding of the video signal is the coding described in Embodiments. Furthermore, the signal processing unit ex507 sometimes multiplexes the coded audio data and the coded video data, and a stream I/O ex506 provides the multiplexed data outside. The provided bit stream is transmitted to a base station ex107, or written into the recording medium ex215. When data sets are multiplexed, the data sets should be temporarily stored in the buffer ex508 so that the data sets are synchronized with each other.

For example, when coded data is decoded, the LSI ex500 temporarily stores, in the memory ex511, the coded data obtained from the base station ex107 through the stream I/O ex506 or read from the recording medium ex215 under control of the control unit ex501. Under control of the control unit ex501, the stored data is subdivided into data portions according to the processing amount and speed as necessary. Then, the data portions are transmitted to the signal processing unit ex507. The signal processing unit ex507 decodes audio data and/or video data. Here, the decoding of the video signal is the decoding described in Embodiments. Furthermore, a decoded audio signal and a decoded video signal may be temporarily stored in the buffer ex508 and others so that the signals can be reproduced in synchronization with each other. Each of the output units, such as the cellular phone vex114, the game machine vex115, and the television ex300 provides the decoded output signal through, for example, the memory 511 as necessary.

Although the memory ex511 is an element outside the LSI ex500 in the description, it may be included in the LSI ex500. The buffer ex508 is not limited to one buffer, but may be composed of buffers. Furthermore, the LSI ex500 may be made into one chip or a plurality of chips.

The name used here is LSI, but it may also be called IC, system LSI, super LSI, or ultra LSI depending on the degree of synthesis.

Moreover, ways to achieve the synthesis are not limited to the LSI, and a special circuit or a general purpose processor and so forth can also achieve the synthesis. Field Programmable Gate Array (FPGA) that can be programmed after manufacturing LSI or a reconfigurable processor that allows re-configuration of the connection or configuration of an LSI can be used for the same purpose.

In the future, with advancement in semiconductor technology, a brand-new technology may replace LSI. The functional blocks can be synthesized using such a technology. One such possibility is that the present invention is applied to biotechnology.

Although the coding method, the coding apparatus, the decoding method, and the decoding apparatus are described based on Embodiments according to the present invention, the present invention is not limited to these Embodiments. Without departing from the scope of the present invention, the present invention includes an embodiment with some modifications on Embodiments that are conceived by a person skilled in the art, and an embodiment obtained through combinations of the constituent elements of different Embodiments.

[Industrial Applicability]

The present invention produces effects of suppressing an increase in the amount of computation in the coding process and an increase in the amount of data of the transform coefficients and is applicable to a coding apparatus which codes audio, still images, and video and to a decoding apparatus which decodes data coded by the coding apparatus. For example, the present invention is applicable to various audio-visual devices such as audio devices, cellular phones, digital cameras, BD recorders, and digital televisions.

[Reference Signs List]

100, 300a, 300b, 400, 900 Coding apparatus
110, 410, 910 Transform unit
120 Quantization unit
130, 330a, 330b Coding unit
131, 331a, 331b Transform coefficient coding unit
132, 930 Entropy coding unit
200 First transform unit
201 First memory
202 First transform coefficient deriving unit
210, 600 Dividing unit
211 Second memory
212 Division and synthesis information generation unit
220 Second transform unit
221 Third memory
222 Second transform coefficient deriving unit
230, 620 Synthesizing unit
333 Transform coefficient difference coding unit
335 Transform coefficient quantization unit
337 Transform coefficient entropy coding unit
340 Multiplexing unit
440, 520 Inverse quantization unit
450, 530 Inverse transform unit
460, 840 Adder
470, 850 Memory
480, 860 Prediction unit
490 Subtractor
500, 700a, 700b, 800 Decoding apparatus
510, 710a, 710b Decoding unit
511 Entropy decoding unit
512, 712a, 712b Transform coefficient decoding unit
610 Second inverse transform unit
630 First inverse transform unit
705 Inverse multiplexing unit
714 Transform coefficient inverse quantization unit
716 Transform coefficient difference decoding unit
718 Transform coefficient entropy decoding unit
ex100 Content providing system
ex101 Internet
ex102 Internet service provider
ex103 Streaming server
ex104 Telephone network
ex106, ex107, ex108, ex109, ex110 Base station
ex111 Computer
ex112 PDA
ex113, ex116 Camera
vex114 Cellular phone equipped with camera (cellular phone)
ex115 Game machine
ex117 Microphone
ex200 Digital broadcasting system
ex201 Broadcast station
ex202 Broadcast satellite (Satellite)
ex203 Cable
ex204, ex205, ex601 Antenna
ex210 Car

ex211 Car navigation system
ex212 Reproduction apparatus
ex213, ex219 Monitor
ex214, ex215, ex216, ex607 Recoding medium
ex217 Set top box (STB)
ex218 Reader/recorder
ex220 Remote controller
ex230 Information track
ex231 Recoding blocks
ex232 Inner circumference area
ex233 Data recording area
ex234 Outer circumference area
ex300 Television
ex301 Tuner
ex302 Modulation/demodulation unit
ex303 Multiplexing/demultiplexing unit
ex304 Audio signal processing unit
ex305 Video signal processing unit
ex306, ex507 Signal processing unit
ex307 Speaker
ex308, ex602 Display unit
ex309 Output unit
ex310, ex501 Control unit
ex311, ex505, ex710 Power supply circuit unit
ex312 Operation input unit
ex313 Bridge
ex314, ex606 Slot unit
ex315 Driver
ex316 Modem
ex317 Interface unit
ex318, ex319, ex320, ex321, ex404, ex508 Buffer
ex400 Information reproducing/recording unit
ex401 Optical head
ex402 Modulation recording unit
ex403 Reproduction demodulating unit
ex405 Disk motor
ex406 Servo control unit
ex407 System control unit
ex500 LSI
ex502 CPU
ex503 Memory controller
ex504 Stream controller
ex506 Stream I/O
ex509 AV I/O
ex510 Bus
ex511 Memory
ex603 Camera unit
ex604 Operation keys
ex605 Audio input unit
ex608 Audio output unit
ex701 Transmitting and receiving circuit unit
ex702 LCD control unit
ex703 Camera interface unit (camera I/F unit)
ex704 Operation input control unit
ex705 Audio processing unit
ex706 Modem circuit unit
ex707 Recording/reproducing unit
ex708 Multiplexing/demultiplexing unit

ex709 Image decoding unit
ex711 Main control unit
ex712 Image coding unit
ex713 Synchronous bus

**Claims**

1. A coding method comprising:

   transforming an input signal to generate a transformed output signal;
   quantizing the transformed output signal to generate a quantized coefficient; and
   entropy coding the quantized coefficient to generate a coded signal,
   wherein said transforming includes:
   generating a first transformed output signal by performing a first transform on the input signal using a first transform coefficient; and
   (i) generating a second transformed output signal by performing a second transform on a first partial signal using a second transform coefficient, and (ii) outputting the transformed output signal including the generated second transformed output signal and a second partial signal, the first partial signal being a part of the first transformed output signal, and the second partial signal being a part of the first transformed output signal other than the first partial signal, and
   in said entropy coding, the second transform coefficient or a second inverse transform coefficient is compression coded by (i) calculating a difference between a predetermined value and an element included in the second transform coefficient or the second inverse transform coefficient and (ii) compression coding the calculated difference, the second inverse transform coefficient being used in an inverse transform of the second transform.

2. The coding method according to Claim 1,
   wherein the second transform coefficient or the second inverse transform coefficient is a coefficient in a square matrix, and
   in said entropy coding, a difference between a diagonal element and a largest possible value of the diagonal element is calculated, the diagonal element being included in the second transform coefficient or the second inverse transform coefficient.

3. The coding method according to Claim 1,
   wherein the second transform coefficient or the second inverse transform coefficient is a coefficient in a square matrix, and
   in said entropy coding, a difference between adjacent diagonal elements is calculated, the adjacent diagonal elements being included in the second transform coefficient or the second inverse transform coefficient.

4. The coding method according to Claim 1,
   wherein the second transform coefficient or the second inverse transform coefficient is a coefficient in a square matrix, and
   in said entropy coding, a prediction value is calculated based on a position of a diagonal element in the square matrix, and a difference between the calculated prediction value and the diagonal element is calculated, the diagonal element being included in the second transform coefficient or the second inverse transform coefficient.

5. The coding method according to any one of Claims 1 to 4,
   wherein the second transform coefficient or the second inverse transform coefficient is a coefficient in a square matrix,
   said coding method further comprises
   determining the second transform coefficient or the second inverse transform coefficient based on a statistical property of the input signal, and
   in said determining, the second transform coefficient or the second inverse transform coefficient is determined so that a diagonal element included in the second transform coefficient or the second inverse transform coefficient has a plus sign.

6. The coding method according to any one of Claims 1 to 5,
   wherein the second transform coefficient or the second inverse transform coefficient is a coefficient in a square matrix, and

in said entropy coding, a component obtained by removing redundancy between a non-diagonal element and a symmetrical element is compression coded, the non-diagonal element being included in the second transform coefficient or the second inverse transform coefficient, and the symmetrical element being an element at a position symmetrical to the non-diagonal element about a diagonal element.

**7.** The coding method according to Claim 6,
wherein, in said entropy coding, an average value of an absolute value of the non-diagonal element and an absolute value of the symmetrical element is calculated, and a difference between the calculated average value and the absolute value of the non-diagonal element is compression coded.

**8.** The coding method according to one of Claims 6 and 7,
wherein, in said entropy coding, information indicating whether the non-diagonal element and the symmetrical element have the same or different signs is further compression coded.

**9.** The coding method according to one of Claims 6 and 7,
wherein, in said entropy coding, information indicating that the non-diagonal element and the symmetrical element at any position have reverse signs is compression coded.

**10.** The coding method according to one of Claims 8 and 9,
wherein, in said entropy coding, information indicating positivity and negativity of one of a top-triangle element and a bottom-triangle element is further compression coded, each of the top-triangle element and the bottom-triangle element being the non-diagonal element.

**11.** The coding method according to one of Claims 6 and 7,
wherein, in said entropy coding, information indicating that a top-triangle element at any position has a plus sign is further compression coded, the top-triangle element being the non-diagonal element.

**12.** The coding method according to any one of Claims 1 to 11,
wherein, in said quantizing, the second transform coefficient or the second inverse transform coefficient is quantized using a quantization step weighted according to a position of an element included in the second transform coefficient or the second inverse transform coefficient, and
in said entropy coding, the quantized second transform coefficient or the quantized second inverse transform coefficient is compression coded.

**13.** The coding method according to any one of Claims 1 to 12, further comprising:

predicting the input signal to generate a prediction signal; and
generating a prediction error signal that is a difference between the prediction signal and the input signal,
wherein, in said transforming, the prediction error signal is transformed.

**14.** The coding method according to any one of Claims 1 to 13,
wherein the second transform is the Karhunen Loeve transform (KLT).

**15.** A decoding method of decoding a coded signal to generate a decoded signal, the coded signal being generated by transforming and quantizing an input signal and including: a coded quantized coefficient resulting from compression coding; and a difference between a predetermined value and an element included in a transform coefficient or a second inverse transform coefficient, the transform coefficient being used in transform processing performed in generating the coded signal, and the second inverse transform coefficient being used in a second inverse transform, said decoding method comprising:

entropy decoding the coded signal to generate a decoded quantized coefficient;
inverse quantizing the decoded quantized coefficient to generate a decoded transformed output signal; and
inverse transforming the decoded transformed output signal to generate the decoded signal,

wherein said inverse transforming includes:

generating a first decoded partial signal by performing the second inverse transform on a second decoded transformed output signal using the second inverse transform coefficient, the second decoded transformed output signal being a part of the decoded transformed output signal; and

generating the decoded signal by performing, using a first inverse transform coefficient, a first inverse transform on a first decoded transformed output signal including the first decoded partial signal and a second decoded partial signal that is a part of the decoded transformed output signal other than the second decoded transformed output signal, and

in said entropy decoding, the coded signal is decoded to obtain the difference, and the obtained difference and the predetermined value are added, to generate the second inverse transform coefficient.

16. The decoding method according to Claim 15,

wherein the transform coefficient or the second inverse transform coefficient is a coefficient in a square matrix,

the coded signal includes a difference between a diagonal element and a largest possible value of the diagonal element, the diagonal element being included in the transform coefficient or the second inverse transform coefficient, and

in said entropy decoding, the coded signal is decoded to obtain the difference, and the obtained difference and the largest possible value are added to generate the diagonal element, to generate the second inverse transform coefficient.

17. The decoding method according to Claim 15,

wherein the transform coefficient or the second inverse transform coefficient is a coefficient in a square matrix,

the coded signal includes a difference between a first diagonal element and a second diagonal element adjacent to the first diagonal element, the first and second diagonal elements being included in the transform coefficient or the second inverse transform coefficient, and

in said entropy decoding, the coded signal is decoded to obtain the difference, and the obtained difference and the second diagonal element are added to generate the first diagonal element, to generate the second inverse transform coefficient.

18. The decoding method according to Claim 15,

wherein the transform coefficient or the second inverse transform coefficient is a coefficient in a square matrix,

the coded signal includes a difference between a diagonal element included in the transform coefficient or the second inverse transform coefficient and a prediction value calculated based on a position of the diagonal element in the square matrix, and

in said entropy decoding, the coded signal is decoded to obtain the difference and generate the prediction value, and the generated prediction value and the obtained difference are added to generate the diagonal element, to generate the second inverse transform coefficient.

19. The decoding method according to any one of Claims 15 to 18,

wherein the transform coefficient or the second inverse transform coefficient is a coefficient in a square matrix, and

in said entropy decoding, a component obtained by removing redundancy between a non-diagonal element and a symmetrical element is decoded to generate the non-diagonal element, to generate the second inverse transform coefficient, the non-diagonal element being included in the transform coefficient or the second inverse transform coefficient, and the symmetrical element being an element at a position symmetrical to the non-diagonal element about a diagonal element.

20. The decoding method according to Claim 19,

wherein the coded signal includes an average value of an absolute value of the non-diagonal element and an absolute value of the symmetrical element, and a difference between the average value and the absolute value of the non-diagonal element, and

in said entropy decoding, the coded signal is decoded to obtain the average value and the difference, and the obtained average value and the obtained difference are added, to generate the non-diagonal element.

21. The decoding method according to one of Claims 19 and 20,

wherein the coded signal includes sign reverse information indicating whether the non-diagonal element and the symmetrical element have the same or different signs, and

in said entropy decoding, the coded signal is decoded to obtain the sign reverse information, and according to the obtained sign reverse information, signs of the non-diagonal element and the symmetrical element are determined.

22. The decoding method according to one of Claims 19 and 20,

wherein the coded signal includes all-sign reverse information indicating that the non-diagonal element and the symmetrical element at any position have reverse signs, and
in said entropy decoding, the coded signal is decoded to obtain the all-sign reverse information, and according to the obtained all-sign reverse information, signs of the non-diagonal element and the symmetrical element are determined.

23. The decoding method according to one of Claims 21 and 22,
wherein the coded signal further includes sign information indicating positivity and negativity of one of a top-triangle element and a bottom-triangle element, each of the top-triangle element and the bottom-triangle element being the non-diagonal element, and
in said entropy decoding, the sign information is further obtained, and according to the obtained sign information, a sign of the non-diagonal element is determined.

24. The decoding method according to one of Claims 19 and 20,
wherein the coded signal further includes top-triangle element sign information indicating that a top-triangle element at any position has a plus sign, the top-triangle element being the non-diagonal element, and
in said entropy decoding, the top-triangle element sign information is further obtained, and according to the obtained top-triangle element sign information, it is determined that the top-triangle element has the plus sign.

25. The decoding method according to any one of Claims 15 to 24,
wherein the coded signal includes: a quantization step weighted according to a position of an element included in the transform coefficient or the second inverse transform coefficient; and a quantized transform coefficient or a quantized second inverse transform coefficient, each of the quantized transform coefficient and the quantized second inverse transform coefficient resulting from quantization using the quantization step,
in said entropy decoding, the coded signal is decoded to obtain the quantization step and the quantized transform coefficient or the quantized second inverse transform coefficient, and
in said inverse quantizing, the quantized transform coefficient or the quantized second inverse transform coefficient is further inverse quantized using the quantization step.

26. The decoding method according to any one of Claims 15 to 25,
wherein the coded signal is a signal generated by transforming and quantizing a prediction error signal,
said decoding method further comprises
generating a prediction signal, and
in said inverse transforming, the inverse transform is performed to generate a decoded prediction error signal from the decoded transformed output signal, and the prediction signal and the decoded prediction error signal are added, to generate the decoded signal.

27. The decoding method according to any one of Claims 15 to 26,
wherein the second inverse transform is the KLT.

28. A coding apparatus comprising:

a transform unit configured to transform an input signal to generate a transformed output signal;
a quantization unit configured to quantize the transformed output signal to generate a quantized coefficient; and
an entropy coding unit configured to entropy code the quantized coefficient to generate a coded signal,
wherein said transform unit includes:
a first transform unit configured to generate a first transformed output signal by performing a first transform on the input signal using a first transform coefficient; and
a second transform unit configured to (i) generate a second transformed output signal by performing a second transform on a first partial signal using a second transform coefficient, and (ii) output the transformed output signal including the generated second transformed output signal and a second partial signal, the first partial signal being a part of the first transformed output signal, and the second partial signal being a part of the first transformed output signal other than the first partial signal, and
said entropy coding unit is configured to compression code the second transform coefficient or a second inverse transform coefficient by (i) calculating a difference between a predetermined value and an element included in the second transform coefficient or the second inverse transform coefficient and (ii) compression coding the calculated difference, the second inverse transform coefficient being used in an inverse transform of the second transform.

29. A decoding apparatus which decodes a coded signal to generate a decoded signal, the coded signal being generated by transforming and quantizing an input signal and including: a coded quantized coefficient resulting from compression coding; and a difference between a predetermined value and an element included in a transform coefficient or a second inverse transform coefficient, the transform coefficient being used in transform processing performed in generating the coded signal, and the second inverse transform coefficient being used in a second inverse transform, said decoding apparatus comprising:

an entropy decoding unit configured to entropy decode the coded signal to generate a decoded quantized coefficient;

an inverse quantization unit configured to inverse quantize the decoded quantized coefficient to generate a decoded transformed output signal; and

an inverse transform unit configured to inverse transform the decoded transformed output signal to generate the decoded signal,

wherein said inverse transform unit includes:

a second inverse transform unit configured to generate a first decoded partial signal by performing the second inverse transform on a second decoded transformed output signal using the second inverse transform coefficient, the second decoded transformed output signal being a part of the decoded transformed output signal; and

a first inverse transform unit configured to generate the decoded signal by performing, using a first inverse transform coefficient, a first inverse transform on a first decoded transformed output signal including the first decoded partial signal and a second decoded partial signal that is a part of the decoded transformed output signal other than the second decoded transformed output signal, and

said entropy decoding unit is configured to decode the coded signal to obtain the difference, and add the obtained difference and the predetermined value, to generate the second inverse transform coefficient.

30. An integrated circuit comprising:

a transform unit configured to transform an input signal to generate a transformed output signal;

a quantization unit configured to quantize the transformed output signal to generate a quantized coefficient; and

an entropy coding unit configured to entropy code the quantized coefficient to generate a coded signal,

wherein said transform unit includes:

a first transform unit configured to generate a first transformed output signal by performing a first transform on the input signal using a first transform coefficient; and

a second transform unit configured to (i) generate a second transformed output signal by performing a second transform on a first partial signal using a second transform coefficient, and (ii) output the transformed output signal including the generated second transformed output signal and a second partial signal, the first partial signal being a part of the first transformed output signal, and the second partial signal being a part of the first transformed output signal other than the first partial signal, and

said entropy coding unit is configured to compression code the second transform coefficient or a second inverse transform coefficient by (i) calculating a difference between a predetermined value and an element included in the second transform coefficient or the second inverse transform coefficient and (ii) compression coding the calculated difference, the second inverse transform coefficient being used in an inverse transform of the second transform.

31. An integrated circuit which decodes a coded signal to generate a decoded signal, the coded signal beinggenerated by transforming and quantizing an input signal and including: a coded quantized coefficient resulting from compression coding; and a difference between a predetermined value and an element included in a transform coefficient or a second inverse transform coefficient, the transform coefficient being used in transform processing performed in generating the coded signal, and the second inverse transform coefficient being used in a second inverse transform, said integrated circuit comprising:

an entropy decoding unit configured to entropy decode the coded signal to generate a decoded quantized coefficient;

an inverse quantization unit configured to inverse quantize the decoded quantized coefficient to generate a decoded transformed output signal; and

an inverse transform unit configured to inverse transform the decoded transformed output signal to generate the decoded signal,

wherein said inverse transform unit includes:

a second inverse transform unit configured to generate a first decoded partial signal by performing the second inverse transform on a second decoded transformed output signal using the second inverse transform coefficient, the second decoded transformed output signal being a part of the decoded transformed output signal; and a first inverse transform unit configured to generate the decoded signal by performing, using a first inverse transform coefficient, a first inverse transform on a first decoded transformed output signal including the first decoded partial signal and a second decoded partial signal that is a part of the decoded transformed output signal other than the second decoded transformed output signal, and

said entropy decoding unit is configured to decode the coded signal to obtain the difference, and add the obtained difference and the predetermined value, to generate the second inverse transform coefficient.

32. A program for causing a computer to execute a coding method which includes:

transforming an input signal to generate a transformed output signal;
quantizing the transformed output signal to generate a quantized coefficient; and
entropy coding the quantized coefficient to generate a coded signal,
wherein said transforming includes:
generating a first transformed output signal by performing a first transform on the input signal using a first transform coefficient; and
(i) generating a second transformed output signal by performing a second transform on a first partial signal using a second transform coefficient, and (ii) outputting the transformed output signal including the generated second transformed output signal and a second partial signal, the first partial signal being a part of the first transformed output signal, and the second partial signal being a part of the first transformed output signal other than the first partial signal, and
in said entropy coding, the second transform coefficient or a second inverse transform coefficient is compression coded by (i) calculating a difference between a predetermined value and an element included in the second transform coefficient or the second inverse transform coefficient and (ii) compression coding the calculated difference, the second inverse transform coefficient being used in an inverse transform of the second transform.

33. A program for causing a computer to execute a decoding method of decoding a coded signal to generate a decoded signal, the coded signal being generated by transforming and quantizing an input signal and including: a coded quantized coefficient resulting from compression coding; and a difference between a predetermined value and an element included in a transform coefficient or a second inverse transform coefficient, the transform coefficient being used in transform processing performed in generating the coded signal, and the second inverse transform coefficient being used in a second inverse transform, and the decoding method comprising:

entropy decoding the coded signal to generate a decoded quantized coefficient;
inverse quantizing the decoded quantized coefficient to generate a decoded transformed output signal; and
inverse transforming the decoded transformed output signal to generate the decoded signal,
wherein said inverse transforming includes:
generating a first decoded partial signal by performing the second inverse transform on a second decoded transformed output signal using the second inverse transform coefficient, the second decoded transformed output signal being a part of the decoded transformed output signal; and
generating the decoded signal by performing, using a first inverse transform coefficient, a first inverse transform on a first decoded transformed output signal including the first decoded partial signal and a second decoded partial signal that is a part of the decoded transformed output signal other than the second decoded transformed output signal, and
in said entropy decoding, the coded signal is decoded to obtain the difference, and the obtained difference and the predetermined value are added, to generate the second inverse transform coefficient.

FIG. 1

900

Transform target input signal

910 Transform unit

Transformed output signal

120 Quantization unit

Quantized coefficients

930 Entropy coding unit

Coded signal

FIG. 2

| The number of dimensions of input signal | DCT | KLT | Ratio |
|---|---|---|---|
| 4 | 8 | 16 | 2.0 |
| 8 | 24 | 64 | 2.6 |
| 16 | 64 | 256 | 4.0 |
| M | $M*\log_2(M)$ | $M*M$ | — |

FIG. 3

# FIG. 4

110

Transform target input signal $x^n$

200 First transform unit

First transformed output signal $y_1^n$

210 Dividing unit

First partial signal $y_{1L}^m$

Second partial signal $y_{1H}^{n-m}$

220 Second transform unit

Second transformed output signal $y_2^m$

230 Synthesizing unit

Transformed output signal $y^n$ → To quantization unit 120

201 First memory

202 First transform coefficient deriving unit

211 Second memory

212 Division and synthesis information generation unit

221 Third memory

222 Second transform coefficient deriving unit

Second transform coefficients $A_2^m$

Division and synthesis information

First transform coefficients $A_1^n$

To transform coefficient coding unit 131

FIG. 5

FIG. 6

Transform target input signal $x^n$

Set $S_A$

$x^n$ $x^n$ $x^n$ $x^n$ $x^n$ $x^n$ $x^n$ $x^n$ $x^n$ $x^n$ $x^n$ $x^n$

First memory

201

202 — First transform coefficient deriving unit

First transform coefficients $A_1^n$

200 — First transform unit

First partial signal $y_{1L}^m$

Set $S_C$

$y_{1L}^m$ $y_{1L}^m$ $y_{1L}^m$

Third memory

221

222 — Second transform coefficient deriving unit

Second transform coefficients $A_2^m$

220 — Second transform unit

Second transformed output signal $y_2^m$

EP 2 464 018 A1

FIG. 7

# FIG. 8

S110

```
          ┌──────────┐
          │  Start   │
          └──────────┘
               │
               ▼
  ┌──────────────────────────┐ ── S111
  │ Determine first          │
  │ transform coefficients   │
  └──────────────────────────┘
               │
               ▼
  ┌──────────────────────────┐ ── S112
  │     First transform      │
  └──────────────────────────┘
               │
               ▼
  ┌──────────────────────────┐ ── S113
  │ Generate                 │
  │ division and synthesis   │
  │ information              │
  └──────────────────────────┘
               │
               ▼
  ┌──────────────────────────┐ ── S114
  │        Division          │
  └──────────────────────────┘
               │
               ▼
  ┌──────────────────────────┐ ── S115
  │ Determine second         │
  │ transform coefficients   │
  └──────────────────────────┘
               │
               ▼
  ┌──────────────────────────┐ ── S116
  │    Second transform      │
  └──────────────────────────┘
               │
               ▼
  ┌──────────────────────────┐ ── S117
  │       Synthesis          │
  └──────────────────────────┘
               │
               ▼
          ┌──────────┐
          │   End    │
          └──────────┘
```

## FIG. 9

<u>S130</u>

Start

S131

Diagonal element or non-diagonal element?

"Diagonal element"

"Non-diagonal element"

S132

Coding using difference from predetermined reference

S133

Coding using relationship with symmetrical element

End

## FIG. 10A

Second transform coefficients

First partial signal 220

Second transformed output signal

| $y_{1L}(0)$ | | $y_2(0)$ |
| $y_{1L}(1)$ | Second transform unit | $y_2(1)$ |
| $y_{1L}(2)$ | | $y_2(2)$ |
| $y_{1L}(3)$ | | $y_2(3)$ |

## FIG. 10B

Second transform coefficients

| $a_{11}$ | $a_{12}$ | $a_{13}$ | $a_{14}$ |
| $a_{21}$ | $a_{22}$ | $a_{23}$ | $a_{24}$ |
| $a_{31}$ | $a_{32}$ | $a_{33}$ | $a_{34}$ |
| $a_{41}$ | $a_{42}$ | $a_{43}$ | $a_{44}$ |

Top-triangle elements

Bottom-triangle elements

Diagonal elements

## FIG. 11A

S132

```
    Start

Calculate difference from        S200
predetermined value

    Code difference             S210

    End
```

# FIG. 11B

S132

# FIG. 12

Elements to be coded

Symmetrical elements

# FIG. 13

S133

Start

Calculate absolute average value — S300

Calculate difference — S310

Code difference — S320

Code signs — S330

End

# FIG. 14A

| 242 | 48 | 64 | 10 |
| -58 | 243 | 28 | 10 |
| -57 | -46 | 241 | 2 |
| -3 | -25 | -28 | 224 |

## FIG. 14B

| | 53 | 61 | 7 |
|---|---|---|---|
| | | 37 | 18 |
| | | | 10 |
| | | | |

## FIG. 14C

| | -5 | 3 | 3 |
|---|---|---|---|
| 5 | | -9 | -8 |
| -4 | 9 | | -8 |
| -4 | 7 | 8 | |

## FIG. 15

| | Top-triangle elements | Bottom-triangle elements |
|---|---|---|
| Largest in number | + | - |
| Large in number | - | + |
| Small in number | + | + |
| Small in number | - | - |

## FIG. 16

EP 2 464 018 A1

Sign of a(i,j) is
to be coded.

**OR**

Sign of ha(i,j)
is to be coded.

X

<mode 1>
Whole layer
Position layer (all non-diagonal elements)
- bits indicating plus/minus of non-diagonal elements
  = transmit signs without additional processing

<mode 2>
Whole layer
Position layer (only top-triangle elements)
- bits indicating whether signs of symmetrical elements
  are reverse (sign reverse information)
- bits indicating signs of top-triangle elements
  (sign information)

<mode 3>
Whole layer
- bits indicating that symmetrical elements at all positions
  have reverse signs (all-sign reverse information)
Position layer (only top-triangle elements)
- bits indicating plus/minus of top-triangle elements
  (sign information)

<mode 4>
Whole layer
- bits indicating that top-triangle elements are plus
  (top-triangle element sign information) or bits indicating
  that top-triangle elements in top-left partial matrix of
  n x n are plus (range information)
Position layer (only top-triangle elements)
- transmit no sign information indicating plus/minus

EP 2 464 018 A1

FIG. 17A

FIG. 17B

300b

Transform target input signal

110 Transform unit

Transformed output signal

120 Quantization unit

Quantized coefficients

Transform coefficients

132 Entropy coding unit

Coded signal

340 Multiplexing unit

331b

337 Transform coefficient entropy coding unit

335 Transform coefficient quantization unit

333 Transform coefficient difference coding unit

Transform coefficient coding unit

330b Coding unit

## FIG. 18A

| index | 1 | 2 | 3 | 4 |
|-------|---|---|---|---|
| TWL   | 1 | 2 | 2 | 4 |

## FIG. 18B

| 1 | 1 | 1 | 1 |
|---|---|---|---|
| 2 | 2 | 2 | 2 |
| 3 | 3 | 3 | 3 |
| 4 | 4 | 4 | 4 |

## FIG. 18C

| 1 | 1 | 1 | 1 |
|---|---|---|---|
| 1 | 2 | 2 | 2 |
| 1 | 2 | 3 | 3 |
| 1 | 2 | 3 | 4 |

## FIG. 19

EP 2 464 018 A1

# FIG. 20

```
        ┌──────────┐
        │  Start   │
        └──────────┘
              │
              ▼
┌─────────────────────────────┐  S400
│ Generate prediction signal  │
└─────────────────────────────┘
              │
              ▼
┌─────────────────────────────┐  S405
│     Generate prediction     │
│        error signal         │
└─────────────────────────────┘
              │
              ▼
┌─────────────────────────────┐  S110
│         Transform           │
└─────────────────────────────┘
              │
              ▼
┌─────────────────────────────┐  S120
│        Quantization         │
└─────────────────────────────┘
              │
              ▼
┌─────────────────────────────┐  S130
│       Entropy coding        │
└─────────────────────────────┘
              │
              ▼
┌─────────────────────────────┐  S440
│    Inverse quantization     │
└─────────────────────────────┘
              │
              ▼
┌─────────────────────────────┐  S450
│      Inverse transform      │
└─────────────────────────────┘
              │
              ▼
┌─────────────────────────────┐  S460
│     Storage onto memory     │
└─────────────────────────────┘
              │
              ▼
        ┌──────────┐
        │   End    │
        └──────────┘
```

FIG. 21

EP 2 464 018 A1

## FIG. 22A

530

First decoded transformed output signal $\hat{y}_1^n$

Decoded transformed output signal $\hat{y}^n$

600

Second decoded partial signal $\hat{y}_{1H}^{n-m}$

620

Decoded signal $\hat{x}^n$

Dividing unit

Synthesizing unit

First inverse transform unit

Second decoded transformed output signal $\hat{y}_2^m$

Second inverse transform unit

First decoded partial signal $\hat{y}_{1L}^m$

610

630

Second inverse transform coefficients $A_2^{-1}$

Division and synthesis information

First inverse transform coefficients $A_1^{-1}$

EP 2 464 018 A1

## FIG. 22B

(a)

(b)

Same operation results

FIG. 23

FIG. 24

```
        ┌─────────────┐
        │    Start    │
        └──────┬──────┘
               │
               ▼
    ┌─────────────────────┐
    │  Entropy decoding   │──── S510
    └──────────┬──────────┘
               │
               ▼
    ┌─────────────────────┐
    │ Inverse quantization│──── S520
    └──────────┬──────────┘
               │
               ▼
    ┌─────────────────────┐
    │  Inverse transform  │──── S530
    └──────────┬──────────┘
               │
               ▼
        ┌─────────────┐
        │     End     │
        └─────────────┘
```

# FIG. 25

S530

```
         ┌─────────────┐
         │    Start     │
         └──────┬───────┘
                ↓
┌──────────────────────────┐
│   Receive division and    │──── S531
│   synthesis information   │
└──────────────┬───────────┘
               ↓
┌──────────────────────────┐
│         Division          │──── S532
└──────────────┬───────────┘
               ↓
┌──────────────────────────┐
│   Receive second inverse  │──── S533
│    transform coefficients │
└──────────────┬───────────┘
               ↓
┌──────────────────────────┐
│      Second inverse       │──── S534
│        transform          │
└──────────────┬───────────┘
               ↓
┌──────────────────────────┐
│        Synthesis          │──── S535
└──────────────┬───────────┘
               ↓
┌──────────────────────────┐
│   Receive first inverse   │──── S536
│    transform coefficients │
└──────────────┬───────────┘
               ↓
┌──────────────────────────┐
│      First inverse        │──── S537
│        transform          │
└──────────────┬───────────┘
               ↓
         ┌─────────────┐
         │     End      │
         └─────────────┘
```

## FIG. 26

S510

Start

S511

Diagonal
element or
non-diagonal element?

"Diagonal
element"

"Non-diagonal
element"

S512

Decoding using
difference from
predetermined
reference

S513

Decoding using
relationship with
symmetrical
element

End

## FIG. 27A

S512

Start

Receive difference — S600

Add received difference
and predetermined value — S610

End

FIG. 27B

S512

```
          ┌──────────┐
          │  Start   │
          └──────────┘
                │
                ▼
   ┌─────────────────────┐
   │  Receive difference │──── S600
   └─────────────────────┘
                │
      ┌ ─ ─ ─ ─ ▼ ─ ─ ─ ─ ─ ┐
        ┌───────────────────────┐
S610  │ │ Generate prediction value │── S611
        └───────────────────────┘
      │           │             │
                  ▼
        ┌───────────────────────┐
      │ │  Add received difference  │── S612
        │  and prediction value │
        └───────────────────────┘
      │           │             │
      └ ─ ─ ─ ─ ─ ▼ ─ ─ ─ ─ ─ ┘
          ┌──────────┐
          │   End    │
          └──────────┘
```

# FIG. 28

S513

```
              ┌──────────────┐
              │    Start     │
              └──────┬───────┘
                     │
                     ▼
     ┌─────────────────────────────┐    S700
     │ Receive difference, absolute │
     │ average value, and sign      │
     └─────────────┬───────────────┘
                   │
                   ▼
     ┌─────────────────────────────┐    S710
     │ Add difference and absolute  │
     │ average value                │
     └─────────────┬───────────────┘
                   │
                   ▼
     ┌─────────────────────────────┐    S720
     │       Determine sign         │
     └─────────────┬───────────────┘
                   │
                   ▼
              ┌──────────────┐
              │     End      │
              └──────────────┘
```

# FIG. 29A

*700a*

**Coded signal** → **Entropy decoding unit** *511*

Decoded quantized coefficients → **Inverse quantization unit** *520* → Decoded transformed output signal → **Inverse transform unit** *530* → **Decoded signal**

Quantized transform coefficients → **Transform coefficient inverse quantization unit** *714* → **Transform coefficient difference decoding unit** *716*

Inverse transform coefficients

Transform coefficient decoding unit *712a*

Decoding unit *710a*

EP 2 464 018 A1

## FIG. 29B

EP 2 464 018 A1

FIG. 30

FIG. 31

Start

Generate prediction signal — S800

Entropy decoding — S510

Inverse quantization — S520

Inverse transform — S530

Addition — S840

Storage onto memory — S850

End

FIG. 32

EP 2 464 018 A1

# FIG. 33

ex601

ex608

ex602

ex603

ex604

ex606

ex605

ex607

SD

ex114

FIG. 34

## FIG. 35

Broadcast satellite ex202

ex214

Monitor ex213

Reproduction apparatus ex212

Cellular phone ex114

Antenna ex205

Car ex210

Antenna ex204

Car navigation system ex211

Broadcast station ex201

Cable ex203

ex215

Monitor ex219

STB ex217

Television ex300

Reader/recorder ex218

ex216

ex200

EP 2 464 018 A1

## FIG. 36

FIG. 37

FIG. 38

Optical disk
ex215

Recording blocks
ex231

Information track
ex230

Inner
circumference area         ex232

Data recording
area                        ex233

Outer
circumference area          ex234

## FIG. 39

## INTERNATIONAL SEARCH REPORT

| | International application No. |
|---|---|
| | PCT/JP2010/004966 |

**A. CLASSIFICATION OF SUBJECT MATTER**
*H03M7/30*(2006.01)i, *H04N7/30*(2006.01)i, *H04N7/32*(2006.01)i

According to International Patent Classification (IPC) or to both national classification and IPC

**B. FIELDS SEARCHED**

Minimum documentation searched (classification system followed by classification symbols)
H03M7/30, H04N7/30, H04N7/32

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 9-200762 A   (Daewoo Electronics Co., Ltd.), 31 July 1997 (31.07.1997), entire text; all drawings & US 5724096 A           & GB 2308771 A & KR 10-0255746 B1 | 1-33 |
| A | WO 2006/006564 A1  (Sony Corp.), 19 January 2006 (19.01.2006), entire text; all drawings & JP 2006-54846 A         & JP 2010-119153 A & JP 2010-136454 A        & JP 2010-141926 A & EP 1662801 A1           & CN 1860796 A | 1-33 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 October, 2010 (21.10.10) | 02 November, 2010 (02.11.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2010/004966

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2004-46499 A (Matsushita Electric Industrial Co., Ltd.), 12 February 2004 (12.02.2004), entire text; all drawings & US 2005/0080784 A1 & CN 1472964 A | 1-33 |
| A | JP 3-85080 A (NEC Corp.), 10 April 1991 (10.04.1991), entire text; all drawings (Family: none) | 1-33 |

Form PCT/ISA/210 (continuation of second sheet) (July 2009)